# EUROPÄISCHE PATENTSCHRIFT

(11) **EP 3 772 111 B1**
(45) Veröffentlichungstag und Bekanntmachung des Hinweises auf die Patenterteilung: **05.07.2023**
(21) Anmeldenummer: 20174662.5
(22) Anmeldetag: 14.05.2020
(51) Int. Cl.: H01L 29/74, H01L 29/08, H01L 23/62, H01L 29/06, H01L 29/417, H01L 29/423

(54) **KURZSCHLUSS-HALBLEITERBAUELEMENT UND VERFAHREN ZU DESSEN BETRIEB**
SHORT CIRCUIT SEMICONDUCTOR ELEMENT AND METHOD FOR OPERATING THE SAME
COMPOSANT SEMI-CONDUCTEUR À COURT CIRCUIT ET SON PROCÉDÉ DE FONCTIONNEMENT

(30) Priorität: 01.08.2019 DE 102019120876; 13.09.2019 DE 102019124695
(43) Veröffentlichungstag der Anmeldung: 03.02.2021
(73) Patentinhaber: Infineon Technologies Bipolar GmbH & Co. KG, 59581 Warstein (DE)
(72) Erfinder: SCHENK, Mario, 91074 Herzogenaurach (DE); BARTHELMESS, Reiner, 59494 Soest (DE); WEIDNER, Peter, 59494 Soest (DE); PIKORZ, Dirk, 59581 Warstein (DE); DROLDNER, Markus, 59229 Ahlen (DE); STELTE, Michael, 33178 Borchen-Etteln (DE); NÜBEL, Harald, 59581 Warstein (DE); KELLNER-WERDEHAUSEN, Uwe, 91359 Leutenbach (DE); DRILLING, Christof, 59955 Winterberg (DE); PRZYBILLA, Jens, 59581 Warstein (DE)
(74) Vertreter: Westphal, Mussgnug & Partner, Patentanwälte mbB

(56) Entgegenhaltungen:
- EP-A1- 3 721 472
- JP-A- S57 118 671
- US-A- 3 660 687
- US-A- 5 969 922
- US-B1- 9 741 839

## Beschreibung

Die vorliegende Erfindung betrifft ein Kurzschluss-Halbleiterbauelement nach dem Oberbegriff des Anspruchs 1 sowie ein Verfahren zum Betreiben eines solchen Kurzschluss-Halbleiterbauelements nach dem Oberbegriff des Anspruchs 24.

Nach bestimmten Fehler- oder Störfällen können beispielsweise in Stromrichteranlagen sämtliche Komponenten und insbesondere die Leistungshalbleiter durch zu hohe Kurzschluss- oder Überlastströme, die bis zu mehrere 100 kA betragen können, zerstört werden. Um die Zerstörung der Komponenten in den Anlagen und insbesondere der Halbleiterkomponenten sicher zu vermeiden, ist der Einsatz vielfältiger Schutzeinrichtungen bekannt. Beim Auftreten des Fehlerfalles kann zum Beispiel durch einen Sicherheitsschalter in Form einer Kurzschlusseinrichtung eine definierte, dauerhaft niederohmige Verbindung (Kurzschluss) erzeugt werden. Die Schutzeinrichtung ist dabei einmalig auslösbar und bleibt nach erfolgter Auslösung durch ein elektrisches oder optisches Auslösesignal dauerhaft kurzgeschlossen.

In modernen Anwendungen zur Energieübertragung und in elektrischen Hochleistungsantrieben gibt es heutzutage ferner die Anforderung, in Fehlerfällen einzelne, in Reihe geschaltete Submodule kurzzuschließen, um den Betrieb der Anlagen weiterhin zu gewährleisten. Das Kurzschließen dieser Submodule dient auch zum Schutz der Anwendung vor Zerstörung und ist damit erheblich für den Schutz dieser Anwendung gedacht.

Eine alternative Anwendung sind beispielsweise Kurzschließer und Schnellerder in Hoch- und Mittelspannungsanlagen. Heute werden solche als mechanische Schalter, angetrieben über Federkraft, realisiert. Sie dienen z. B. dazu, eine Überlastung/Zerstörung einer Anlage durch einen Lichtbogenfehler zu verhindern, indem ein schneller direkter Kurzschluss bzw. eine schnelle Erdung herbeigeführt werden. U. a. können damit auch Hochspannungs-Hochleistungssicherungen (HH-Sicherungen) bei einer Überlastung einer Anlage, bei der die Sicherungen noch nicht sicher schalten würden (z. B. durch einen weiter entfernten Lichtbogenfehler), zum Schmelzen gebracht und der Kurzschluss sicher abgeschaltet werden.

Üblicherweise werden zum Kurzschließen mechanische Schalter eingesetzt, die eine Schaltzeit (von geöffnet nach geschlossen) von etwa 1 ms bis 10 ms aufweisen. Da das Kurzschließen der Submodule nur im Fehlerfall geschieht, ist eher mit einem seltenen Gebrauch der Schalter (z. B: eine Schalthandlung in 10 Jahren) zu rechnen. Infolgedessen haben mechanische Schalter das Problem einer sicheren Schalthandlung nach langem Nichtgebrauch. Aufgrund der beweglichen Teile in einem mechanischen Schalter und ggf. bei Verwendung von Fett und Öl kann eine sichere Schalthandlung nach einer entsprechend langen (Stand-)Zeit nicht mehr garantiert werden.

Beispielsweise offenbart die DE 103 23 220 B4 eine Kurzschlussschaltung für einen fehlerhaften Teilumrichter, in der ein elektronisches Halbleiterbauelement im Fehlerfall entweder einen Kurzschlussstrom übernimmt oder in Abhängigkeit von einem solchen Kurzschlussstrom angesteuert wird und anschließend dauerhaft durchlegiert. Als elektronisches Halbleiterbauelement wird ein aktiver Halbleiterschalter vorgeschlagen, der insbesondere als herkömmlicher Thyristor ausgebildet sein kann. Im Fehlerfall wird dieser gezündet, wonach der durch den Thyristor fließende Kurschlussstrom eine lokale Überhitzung des Halbleitermaterials bewirkt, die den Kurzschluss-Thyristor zerstört. Dieser bildet danach einen dauerhaften Kurzschluss. Die Kontaktierung des Kurzschluss-Thyristors ist derart kurzschlussfest ausgelegt, dass sich bei ihm kein Lichtbogen aufgrund des hohen Kurzschlussstroms ausbilden kann. Hierzu wird unter anderem eine Druckkontaktierung vorgeschlagen.

Auch die DE 103 33 798 A1 beschreibt ein Verfahren zum Kurzschließen eines fehlerhaften Teilumrichters, bei dem im Fehlerfall stromführende IGBT-Leistungshalbleiterschalter (Insulated Gate Bipoloar Transistor) kurzzeitig so eingeschaltet werden, dass diese dauerhaft durchlegieren. Um ein sicheres Durchlegieren der Halbleiterschalter zu gewährleisten, wird u. a. das Anheben der Gate-Emitter-Spannung der IGBT-Leistungshalbleiterschalter vorgeschlagen. IGBTs weisen allgemein einen MOS-gesteuertes Bereich auf, wobei über eine am IGBT-Gate anliegende kleine Spannung ein leitender Kanal zwischen IGBT-Source und IGBT-Drain bzw. IGBT-Emitter und IGBT-Kollektor erzeugt wird, der zum Einschalten des IGBT führt. Die IGBT-Anschlüsse "Gate" und "Emitter" sind jedoch stets durch einen Isolator (Oxidschicht) voneinander elektrisch isoliert, der erst eine "extreme" Anhebung der Gate-Emitter-Spannung ermöglicht. Wird eine höhere Spannung an die Gate-Elektrode, die den üblichen, betriebsgemäßen Wert weit übersteigt, angelegt, kommt es zu einem Durchschlag, der das Durchlegieren des IGBT einleiten soll.

Des Weiteren offenbart die EP 3 001 525 A1 einen Kurzschlussschalter mit einem zum Kurschließen einer zwischen zwei Leitern anliegenden Spannung ansteuerbaren Halbleiterschalter. Der Halbleiterschalter ist ein herkömmlicher Thyristor vom Press-Pack-Typ mit flächigen Kontaktelektroden auf einander gegenüberliegenden Kontaktseiten. Bei der Montage des Halbleiterbauteils werden dessen Kontaktelektroden über flächige Anschlusselektroden kontaktiert, die mit hoher Steifigkeit elastisch gegeneinander beaufschlagt werden. Auf diese Weise wird die flächige Kontaktierung des Halbleiterbauteils auch unter hoher thermischer Belastung durch hohe fließende Leistungsströme sichergestellt. Der Thyristor ist in einer mechanischen Press-Pack-Struktur angeordnet, die eine den Thyristor umhüllende Schutzhülle ausbildet. Der Thyristor ist so ausgelegt, dass er durch einen beim Kurzschließen durch ihn fließenden Kurzschlussstrom als ansteuerbarer Halbleiterschalter irreversibel zerstört wird, wobei die Leitfähigkeit zwischen seinen Kontaktelektroden erhalten bleibt. Der Kurschlussstrom soll wenigstens das 50-fache des Nennstroms betragen, zu dessen Schalten der Thyristor ausgelegt ist.

Nachteilig bei der Verwendung eines herkömmlichen Thyristors als Kurzschlussschalter ist, dass nicht sichergestellt ist, bei welchem Strom der Thyristor zerstört wird und einen definierten Kurzschluss bildet, da der Stoßstromwert eines herkömmlichen Thyristors nach oben weit streut.

Die Realisierung eines "Short-on-Fair"-Zustandes durch ein gezieltes Durchlegieren wie vorstehend beschrieben kann durch einen geeigneten Modulaufbau wie zum Beispiel der Druckkontaktierung sicher gewährleistet werden. Hierbei befindet sich das Halbleiterbauelement in einem geeigneten Gehäuse, zum Beispiel einer Keramikzelle oder Keramikkapsel, deren äußeren Stromkontakte, üblicherweise der Kathoden- und Anodenanschluss, aus dicken Kupferstempeln (oder anderen leitenden Metallen) bestehen. Durch einen geeigneten Druckverbund wird sichergestellt, dass die beiden Kontaktstempel mit einem ausreichend hohen Druck gegen die jeweiligen metallischen Kontaktelektroden des Halbleiterbauelements kontaktiert sind, um einen besonders niedrigen elektrischen und thermischen Übergang zwischen dem Halbleiterbauelement und den Kupferstempeln des Gehäuses herzustellen. Wenn sich der Ort der Durchlegierung innerhalb des gedrückten Kontaktbereiches befindet, bleibt der Bereich der Zerstörung des Halbleiterbauelements innerhalb der gedrückten Kontaktfläche, sowohl während des Fehlerfalles, in dem es zum Aufschmelzen bzw. Durchlegieren kommt, als auch beim dauerhaften Stromfluss nach dem Fehlerfall. Das Gehäuse nimmt äußerlich keinen oder kaum Schaden, der Energieumsatz während und nach dem Fehlerfall erfolgt im Inneren des Halbleiterbauteils und bleibt dort innerhalb des druckkontaktierten Bereiches begrenzt. Entscheidend ist, dass die elektrische Verbindung im Bauteil durch den Fehlerfall nicht getrennt wird, wie das zum Beispiel bei einem Lötbondbauteil auftreten kann, bei dem der Strom über Bonddrähte fließt. Hier kommt es bei hohen Strömen zu einer galvanischen Trennung der Anschlüsse im Bauteil infolge einer Aufschmelzung der Bonddrähte oder Lötverbindungen. Dies führt zwangsläufig wegen der sehr hohen Energie im Fehlerfall zur kompletten Zerstörung des gesamten Halbleiterbauteils, was auch eine hohe Gefährdung der Anlage in der Umgebung des Bauteiles darstellt. Die Bonddrähte liegen relativ offen innerhalb des das Halbleiterbauteil umgebenden Gehäuses, oft auch in einem Gel eingebettet, weswegen es zu einer explosionsartigen Zerstörung infolge eines Lichtbogens zwischen den unterbrochenen Bonddrähten kommt. Im Gegensatz hierzu wird bei einem druckkontaktierten Bauteil der Energieumsatz im Silizium bzw. der Schmelzbereich bzw. Lichtbogen innerhalb des von den anoden- und kathodenseitigen Kontaktscheiben kontaktierten Bereichs begrenzt, so dass selbst bei höchsten Stromdichten eine Explosion bzw. Zerstörung der unmittelbaren Umgebung des Bauteils weitestgehend vermieden wird.

Wird ein herkömmlicher Thyristor mit seinem Stoßstromgrenzwert belastet, verliert er kurzzeitig, das heißt reversibel, wegen der starken großflächigen Erwärmung in seiner Kathodenfläche, teilweise oder ganz seine Blockier- und Sperrfähigkeit, bis die Sperrschichttemperatur wieder auf den für Dauerbetrieb zulässigen Bereich gesunken ist. Die zulässige Stoßstromdichte im Strommaximum eines einzelnen 10 ms-Impulses, bei der es noch nicht zu einer irreversiblen Zerstörung kommt, liegt typischerweise zwischen 1,0 und 1,5 kA/cm². Wird dieser Grenzwert deutlich überschritten, führt die Erwärmung zu Aufschmelzungen (Durchlegierung) innerhalb der Kathodenfläche, der Thyristor wird zerstört und verliert irreversibel seine Sperrfähigkeit bzw. seine Steuerfunktion. Solange sich die Aufschmelzungen innerhalb des von den Kupferkontaktscheiben bzw. den Kupferstempeln der Kapsel kontaktierten und gedruckten Bereichs und gleichzeitig ausreichend weit weg vom Randbereich des Thyristors befinden, bleiben sowohl die Kapsel als auch die unmittelbare Umgebung weitestgehend intakt.

Ein wesentlicher Nachteil eines beispielsweise in der DE 10 2008 049 678 A1 oder DE 10 2009 045 216 A1 beschriebenen, herkömmlichen Thyristors als Kurzschlussschutzeinrichtung ist jedoch seine große Kathodenfläche, die auf einen möglichst geringen Leit- oder Durchlassverlust bzw. auf eine maximale Stoßstromfähigkeit ausgelegt wird. Ihr Durchmesser entspricht etwa demjenigen der Kontaktscheiben des Kupferstempels oder ist in der Regel noch ein wenig größer (bis zu ca. 0,5 bis 2 mm). Kommt es infolge eines hohen Kurzschlussstromes in der Kathodenfläche zur gewollten Durchlegierung, ist nicht sichergestellt, dass diese weit genug vom Randbereich des Thyristors entfernt auftritt. Als Randbereich kann der radial äußere Bereich des Bauelements verstanden werden, der nicht durch die die Kontaktelektroden (insbesondere die Kathoden- und Anodenanschlüsse) des Halbleiterbauelements gewöhnlich druckkontaktierenden Kontaktscheiben von z. B. Kupferstempeln bedeckt bzw. gedrückt ist. Der durchlegierte Bereich befindet sich irgendwo innerhalb der Kathodenfläche und kann sich auch in den Randbereich hinein ausdehnen. In diesem Fall kann es zu einer Zerstörung des Keramikgehäuses und zum Plasmaaustritt kommen. Ein Plasmaaustritt könnte ebenso in einem Zentrum des Halbleiterbauelements auftreten, wenn nämlich beispielsweise eine Gate-Elektrode oder eine Hilfsthyristorstruktur (Amplifying-Gate-Struktur) im Zentrum des Halbleiterbauelements angeordnet ist, die ebenfalls nicht von den Kontaktscheiben der das Halbleiterbauelements druckkontaktierenden Kupferstempels bedeckt bzw. gedrückt ist/sind.

Auch ist der Randbereich eines Thyristors im Vergleich zur restlichen Fläche, welche durch die Kupferkontaktscheiben direkt kontaktiert bzw. abgedeckt ist, sehr viel anfälliger gegenüber auftretenden Überspannungen. Ein solcher Ausfall führt in Verbindung mit dem dann fließenden Kurzschlussstrom wegen der sehr hohen Energiedichte, besonders bei einer hohen Sperrspannung, zur Zerstörung der Kapsel wie weiter oben bereits beschrieben wurde. Die Festigkeit gegenüber solchen Überspannungen ließe sich zwar durch verschiedene Maßnahmen erheblich verbessern, dies ist aber mit gravierenden Nachteilen verbunden. Zum Beispiel würde ein sehr viel dickerer Siliziumausgangswafer die Sperrfähigkeit deutlich erhöhen und damit ließe sich die Wahrscheinlichkeit für einen Randausfall verursacht durch eine Überspannung weitestgehend vermeiden. Dies ist aber wegen der dann zu hohen dynamischen Verluste und Durchlassverluste bei einer herkömmlichen Thyristorstruktur nicht sinnvoll möglich, da der Thyristor dann die an ihn gestellten Anforderungen, vor allem niedrigste Durchlassverluste und maximales Stoßstromverhalten sowie niedrigste dynamische Verluste nicht mehr erfüllen kann.

Fällt der Thyristor zum Beispiel bei anliegender Sperrspannung U_{R} aus, zum Beispiel hervorgerufen durch eine Überspannung oder einer Sperrinstabilität der Passivierung seiner Randkontur, so befindet sich der Ausfallort meistens im Randbereich des Thyristorbauteils und damit außerhalb des durch die Kupferkontaktscheiben direkt kontaktierten Bereichs. Es fließt ein sehr hoher Kurzschlussstrom in Sperrrichtung, wobei der ungestörte Bereich nicht am Stromfluss beteiligt ist, während es am Ausfallort zu einer Aufschmelzung kommt. Im Inneren der Gehäusekapsel bzw. am Ausfallort kommt es zu einem Lichtbogen, das geschmolzene Material verdampft und es entsteht heißes Plasma, das je nach Stärke zur Zerstörung der Kapsel führen kann. Durch diese explosionsartige Entladung kann in der Nähe der Aufschmelzung die Keramikkapsel reißen, aus der dann heißes Plasma entweicht. Ein solcher Randausfall kann auch bei anliegender Blockierspannung U_{D} auftreten.

Die Druckschrift JP S57 118671 A offenbart eine Halbleiterbauelement mit einem Abschnitt, der nicht mit einer Kathodenelektrode einer N-Emitterschicht verbunden ist, und um die Tiefe einer Nut tiefer ausgebildet als ein Abschnitt, der mit der Kathodenelektrode verbunden ist, wobei zwischen den beiden Abschnitten eine Stufe vorgesehen ist. Genauer gesagt ist in einem Hauptthyristorabschnitt eine Basisschicht vom P-Typ, die sich direkt unter dem Abschnitt befindet, der nicht mit der Kathodenelektrode verbunden ist, schmaler als ein Basisbereich vom P-Typ, der sich direkt unter dem Abschnitt befindet, der mit der Kathodenelektrode verbunden ist. Dementsprechend fließt ein Einschaltstrom durch den tieferen Abschnitt, selbst wenn der Strom lokal eingeschaltet wird, erzeugt eine FI-Funktion durch den seitlichen Widerstand des anderen Abschnitts, und erweitert den Einschaltstrom.

Die Druckschrift US 9 741 839 B1 offenbart ein Thyristorbauelement, das ein scheibenförmiges Bauelement umfasst, das ein Halbleitermaterial umfasst, das alternierende p-n-p-n-Schichten bildet. Die Vorrichtung umfasst einen GateBereich, der sich von einem externen Gate-Leitungskontaktpunkt zu einer Vielzahl von parallel geschalteten Thyristoreinheiten erstreckt. Jede Thyristoreinheit umfasst mindestens einen freigelegten pB-Schichtabschnitt, um mindestens einen von mehreren Punkten zu bilden, zu dem ein Gatestrom geleitet werden kann. Ferner kann eine Isolatorschicht über dem Gatebereich gebildet werden, um zumindest einen Teil der Gateelektrode von der pB-Schicht zu isolieren, so dass der Verschiebungsstrom zu kurzen Punkten und dann zu mehreren Punkten geleitet werden kann. Strom, der in jede Thyristoreinheit eindringt, kann an jeder Thyristoreinheit einen eingeschalteten Bereich erzeugen, der sich über die gesamte Thyristorvorrichtung ausbreitet.

Die Druckschrift US 3 660 687 A offenbart eine monolithisch integrierte Halbleiter-Triggersteuerschaltung zum Zünden von bidirektionalen Thyristoren mit geringer Hysterese mit einer nicht symmetrischen Spannungs-Strom-Kennlinie.

Die Druckschrift US 5 969 922 A offenbart einen einem vierschichtigen Halbleiterschutzbauelement zugeordneten Fehlerdetektor, der eine Mittelschicht aufweist, die einem niedrig dotierten Halbleitersubstrat eines ersten Leitfähigkeitstyps entspricht. Das Bauelement enthält in diesem Substrat zusätzlich zu mehreren Bereichen, die seine Schutzfunktion bereitstellen, mindestens einen zusätzlichen Bereich des zweiten Leitfähigkeitstyps, der mit einem Testanschluss verbunden ist.

Die Druckschrift EP 3 721 472 A1 offenbart ein Kurzschluss-Halbleiterbauelement das einen Halbleiterkörper aufweist, in dem eine rückseitige Basiszone von einem ersten Leitungstyp, eine Innenzone von einem zum ersten Leitungstyp komplementären zweiten Leitungstyp und eine vorderseitige Basiszone vom ersten Leitungstyp angeordnet sind. Die rückseitige Basiszone ist mit einer rückseitigen Elektrode mit einer rückseitigen Elektrodenweite elektrisch leitend verbunden und die vorderseitige Basiszone ist mit einer vorderseitigen Elektrode mit einer vorderseitigen Elektrodenweite elektrisch leitend verbunden, wobei in die vorderseitige Basiszone wenigstens eine vorderseitige Einschaltstruktur mit einer vorderseitigen Einschaltstrukturweite eingebettet und von der vorderseitigen Elektrode wenigstens teilweise überdeckt ist und/oder in die rückseitige Basiszone wenigstens eine rückseitige Einschaltstruktur mit einer rückseitigen Einschaltstrukturweite eingebettet und von der rückseitigen Elektrode wenigstens teilweise überdeckt ist. Die Einschaltstruktur ist ausgebildet, in Abhängigkeit von einem zugeführten Einschaltsignal einzuschalten und einmalig eine irreversible, niederohmige Verbindung zwischen den beiden Elektroden herzustellen. Das Verhältnis der vorderseitigen Einschaltstrukturweite zur vorderseitigen Elektrodenweite und das Verhältnis der rückseitigen Einschaltstrukturweite zur rückseitigen Elektrodenweite ist jeweils kleiner 1. Die Erfindung betrifft ebenso ein Verfahren zum Betreiben eines derartigen Kurzschluss-Halbleiterbauelements

Vor diesem Hintergrund liegt der vorliegenden Erfindung die Aufgabe zugrunde, ein Kurzschluss-Halbleiterbauelement bereitzustellen, mit dem in Abhängigkeit von einem Auslöse- bzw. Einschaltsignal eine an dem Halbleiterbauelement anliegende elektrische Spannung zuverlässig, sicher und dauerhaft (langzeitstabil) kurzgeschlossen werden kann, ohne dass hierbei Plasma explosionsartig aus dem Halbleiterbauelement austritt. Darüber hinaus sollen Sperrverluste in einer sperrenden Betriebsart des Halbleiterbauelements derart gering ausfallen, dass es ohne aktive Kühlung betrieben werden kann. Ferner soll ein Verfahren zum Betreiben eines Kurzschluss-Halbleiterbauelements bereitgestellt werden.

Diese Aufgabe wird durch ein Kurzschluss-Halbleiterbauelement mit den Merkmalen des Anspruchs 1 sowie durch ein Verfahren zum Betreiben eines Kurzschluss-Halbleiterbauelements mit den Merkmalen des Anspruchs 24 gelöst. Weitere, besonders vorteilhafte Ausgestaltungen der Erfindung offenbaren die Unteransprüche.

Es ist darauf hinzuweisen, dass die in der nachfolgenden Beschreibung einzeln aufgeführten Merkmale in beliebiger, technisch sinnvoller Weise miteinander kombiniert werden können und weitere Ausgestaltungen der Erfindung aufzeigen. Die Beschreibung charakterisiert und spezifiziert die Erfindung insbesondere im Zusammenhang mit den Figuren zusätzlich.

Erfindungsgemäß weist ein Kurzschluss-Halbleiterbauelement einen Halbleiterkörper auf, in dem in einer vertikalen Richtung ausgehend von einer Rückseite mit einem durch ihren geometrischen Schwerpunkt festgelegten rückseitigen Zentrum hin zu einer der Rückseite gegenüberliegenden Vorderseite mit einem durch ihren geometrischen Schwerpunkt festgelegten vorderseitigen Zentrum eine rückseitige Basiszone von einem ersten Leitungstyp, zum Beispiel vom p-Typ, eine Innenzone von einem zum ersten Leitungstyp komplementären zweiten Leitungstyp, zum Beispiel vom n-Typ, und eine vorderseitige Basiszone vom ersten Leitungstyp aufeinanderfolgend angeordnet sind. Ferner ist die rückseitige Basiszone mit einer auf der Rückseite aufgebrachten rückseitigen Elektrode (Metallisierung, zum Beispiel Aluminium) mit einer durch ihre laterale Erstreckung gegebenen lateralen rückseitigen Elektrodenweite elektrisch leitend verbunden. Die vorderseitige Basiszone ist mit einer auf der Vorderseite aufgebrachten vorderseitigen Elektrode (Metallisierung, zum Beispiel Aluminium) mit einer durch ihre laterale Erstreckung gegebenen lateralen vorderseitigen Elektrodenweite elektrisch leitend verbunden. Erfindungsgemäß ist weiterhin in die vorderseitige Basiszone wenigstens eine vorderseitige Einschaltstruktur eingebettet und von der vorderseitigen Elektrode wenigstens teilweise überdeckt und/oder in die rückseitige Basiszone wenigstens eine rückseitige Einschaltstruktur eingebettet und von der rückseitigen Elektrode wenigstens teilweise überdeckt. Gemäß der Erfindung ist die jeweilige Einschaltstruktur eine mit der auf diese jeweils einbettenden Basiszone aufgebrachten Elektrode elektrisch leitend kontaktierte Emitterstruktur vom zweiten Leitungstyp, zum Beispiel n-Typ, die mittels wenigstens einer auf diese elektrisch über den Halbleiterkörper einwirkenden Zündstruktur einschaltbar ist, die wiederum mittels eines ihr zugeführten elektrischen Einschaltsignals aktivierbar ist. Weiter ist die Zündstruktur derart ausgebildet und angeordnet, dass sie in ihrem aktivierten Zustand durch die Injektion eines elektrischen Stromstoßes mit einem vorbestimmten Energieeintrag, beispielsweise etwa 2 Ws, in den Halbleiterkörper zwischen die Zündstruktur und die vorderseitige und/oder rückseitige Einschaltstruktur eine Vorzerstörung herbeiführt, wobei der elektrische Stromstoß einen zwischen der jeweiligen Einschaltstruktur und diese einbettenden Basiszone gebildeten ersten Halbleiterübergang, zum Beispiel np-Übergang, und/oder einen zwischen dieser Basiszone und der Innenzone gebildeten zweiten Halbleiterübergang, zum Beispiel pn-Übergang, irreversibel zerstört, und wobei der Halbleiterkörper im Anschluss an die Vorzerstörung durch einen über die vorderseitige Elektrode und die rückseitige Elektrode fließenden Strom derart zerstört wird, dass sich eine Durchlegierung zwischen der vorderseitigen Elektrode und der rückseitigen Elektrode bildet.

Es sei angemerkt, dass hierin eine zwischen zwei Merkmalen stehende und diese miteinander verbindende Konjunktion "und/oder" hierin stets so auszulegen ist, dass in einer ersten Ausgestaltung des erfindungsgemäßen Gegenstands lediglich das erste Merkmal vorhanden sein kann, in einer zweiten Ausgestaltung lediglich das zweite Merkmal vorhanden sein kann und in einer dritten Ausgestaltung sowohl das erste als auch das zweite Merkmal vorhanden sein können.

Als laterale oder radiale Erstreckungsrichtung im Halbleiterkörper wird hierin eine zur vertikalen Erstreckungsrichtung des Halbleiterkörpers im Wesentlichen senkrechte Richtung verstanden. Im Falle eines beispielsweise als Zylinder (mit geringer Höhe) ausgebildeten Halbleiterkörpers entspricht demnach die vertikale Erstreckungsrichtung der Richtung der Zylinderhöhe und die laterale Richtung der radialen Richtung des Zylinders. Die Begriffe lateral und radial werden hierin gleichbedeutend verwendet.

Weiterhin ist anzumerken, dass sich das vorderseitige Zentrum und das rückseitige Zentrum des Kurzschluss-Halbleiterbauelements unterscheiden können, was jedoch nicht zwingend erforderlich ist und gewöhnlich auch nicht der Fall ist. Die beiden Zentren legen gewöhnlich eine Symmetrieachse des Halbleiterkörpers fest, von dem aus der Radius des Halbleiterkörpers bestimmt wird. Wenn im Folgenden von einem Zentrum bezüglich einer vorderseitigen Komponente des Kurzschluss-Halbleiterbauelements die Rede ist, so ist bei diesem Zentrum stets das vorderseitige Zentrum zu verstehen, sofern dies hierin nicht ausdrücklich anders bestimmt ist. Ebenso ist bei einer Beziehung zwischen einem Zentrum und einer rückseitigen Komponente des Halbleiterkörpers entsprechend das rückseitige Zentrum zu verstehen, sofern dies hierin nicht ausdrücklich anders bestimmt ist.

Es ist zu verstehen, dass eine mit der vorderseitigen Elektrode elektrisch leitend kontaktierte Emitterstruktur eine vorderseitige Einschaltstruktur ist, bei welcher die Emitterstruktur vom zweiten Leitungstyp in die vorderseitige Basiszone vom ersten Leitungstyp angrenzend an die Vorderseite des Halbleiterkörpers derart eingebettet ist, dass sie durch das Aufbringen der vorderseitigen Elektrode auf die Vorderseite des Halbleiterkörpers wenigstens bereichsweise elektrisch leitend kontaktiert ist. Sinngemäß verhält es sich mit einer mit der rückseitigen Elektrode elektrisch leitend kontaktierten Emitterstruktur, die dementsprechend eine rückseitige Einschaltstruktur ist, bei welcher die Emitterstruktur vom zweiten Leitungstyp in die rückseitige Basiszone vom ersten Leitungstyp angrenzend an die Rückseite des Halbleiterkörpers derart eingebettet ist, dass sie durch das Aufbringen der rückseitigen Elektrode auf die Rückseite des Halbleiterkörpers wenigstens bereichsweise elektrisch leitend kontaktiert ist. Die Kontaktierung der Emitterstruktur mit der jeweiligen vorderseitigen oder rückseitigen Elektrode erfolgt hierbei bevorzugt durch unmittelbaren Kontakt zwischen den jeweiligen Komponenten.

Die laterale Weite einer Gesamtstruktur, zum Beispiel einer Einschaltstruktur oder einer Elektrode, ergibt sich damit aus einem Abstand einer die Gesamtstruktur radial am weitesten nach innen begrenzenden Innenseite zu einer diese Gesamtstruktur radial am weitesten nach außen begrenzenden Außenseite. Dies ist unmittelbar einleuchtend für Strukturen des Halbleiterkörpers, die zu ihrem radialen Zentrum (r = 0), das heißt dem geometrischen Schwer- bzw. Mittelpunkt der Vorder- und/oder Rückseite des Halbleiterkörpers, beabstandet angeordnet sind. In dem Spezialfall, dass die Gesamtstruktur keinen Abstand zum radialen Zentrum aufweist, das heißt mit ihrer radialen Innenseite bis an das radiale Zentrum heranreicht, entspricht die laterale Weite der Gesamtstruktur dem Abstand einer die Gesamtstruktur radial nach außen begrenzenden Außenseite zum radialen Zentrum. Mit anderen Worten entspricht in diesem Fall die laterale Weite dem Radius (gemessen vom radialen Zentrum) der Gesamtstruktur oder auch ihrem halben Durchmesser.

Somit weist der Halbleiterkörper des erfindungsgemäßen Kurzschluss-Halbleiterbauelements (ohne Betrachtung der Einschaltstruktur) zwischen seiner vorderseitigen Elektrode bzw. vorderseitigen Metallisierung und seiner rückseitigen Elektrode bzw. rückseitigen Metallisierung eine pnp- bzw. npn-Struktur auf, die das Bauelement für eine zwischen der vorderseitigen Elektrode und der rückseitigen Elektrode anliegende elektrische Spannung in beiden Richtungen bzw. Polaritäten zuverlässig und langzeitstabil sperrt. Dieser Zustand wird hierin als normaler, nicht kurzgeschlossener Betriebszustand des erfindungsgemäßen Kurzschluss-Halbleiterbauelements bezeichnet.

Kommt es hingegen bei einem Störfall in einer durch das erfindungsgemäße Kurzschluss-Halbleiterbauelement zu schützenden elektrischen Anlage zu einer Überlastung durch einen zu hohen Strom, der bis zu mehrere 100 kA betragen kann, werden wenigstens der zwischen der Einschaltstruktur und der diese einbettenden Basiszone gebildete erste Halbleiterübergang (z. B. ein np-Übergang) und/oder der zwischen dieser Basiszone und der Innenzone gebildete zweite Halbleiterübergang (z. B. pn-Übergang) durch vorherige Aktivierung der Zündstruktur und dem anschließend von dieser Zündstruktur erzeugten Stromstoß irreversibel zerstört (hierin auch als Vorzerstörung bezeichnet). Hierdurch wird die Sperrwirkung der beiden Halbleiterübergänge zwischen der Einschaltstruktur, der Basiszone und der Innenzone aufgehoben.

Fließt nun unmittelbar nach dieser Vorzerstörung ein ausreichend hoher Haupt- oder Laststrom zwischen den äußeren Metallanschlüssen des Halbleiterbauelements, das heißt zwischen der vorderseitigen und rückseitigen Elektrode, erhöht dies den Grad dieser Zerstörung weiter und es kommt durch die hohe Stromdichte zu einer permanenten, irreversiblen, niederohmigen Aufschmelzung bzw. Durchlegierung (permanenter Kurzschluss) zwischen den beiden, den Halbleiterkörper kontaktierenden Elektroden. Der Grad bzw. die Größe dieser Durchlegierung hängen am Ende von der Stromdichte bzw. dem Hauptstrom zwischen den vorder- und rückseitigen Elektroden ab. Das erfindungsgemäße Kurzschluss-Halbleiterbauelement ist danach nicht mehr sperrfähig. Dieser Zustand wird hierin als kurzgeschlossener Betriebszustand oder Kurzschlusszustand des erfindungsgemäßen Kurzschluss-Halbleiterbauelements bezeichnet.

Das Aktivieren der Zündstruktur infolge des Zuführens des vorherbestimmbaren Einschaltsignals zum Halbleiterkörper bzw. zur Zündstruktur führt gezielt zum einmaligen Herstellen der dauerhaften, irreversiblen, elektrisch leitenden, niederohmigen Verbindung zwischen der vorderseitigen Elektrode und der rückseitigen Elektrode, das heißt zum permanentem Kurzschluss.

Der permanente Kurzschluss entsteht hierbei nach der Vorzerstörung wenigstens eines der beiden Halbleiterübergänge durch das gezielte Führen des Kurzschlussstromes auf einer lokal begrenzten Fläche im Bauelement, so dass es dort anschließend infolge der hohen Stromdichte zu einer Aufschmelzung im stromführenden Bereich kommt. Bei dieser Aufschmelzung, die auch als Durchlegieren bezeichnet wird, kommt es zu einem Verschmelzen der Materialien der äußeren Metallanschlüsse (z. B. Aluminium, Molybdän und/oder Kupfer) und dem Silizium des Halbleiterkörpers. Nach dem Schmelzvorgang bildet sich eine metallische Zone mit hoher Leitfähigkeit aus, welche die äußeren Metallanschlüsse dauerhaft kurzschließt und prinzipiell auch in der Lage ist, diese Kurzschlussfunktion unter Strombelastung über eine längere Dauer aufrechtzuerhalten, zum Beispiel bis zur nächsten Instandsetzung.

Ein besonderer Vorteil der erfindungsgemäßen Vorzerstörung durch die Zündstruktur gegenüber einem zunächst lediglich zerstörungsfreien Zünden bzw. Einschalten der Einschaltstruktur liegt darin, dass zu einem Zeitpunkt, der nur in der Nähe des eigentlichen Fehlerereignisses liegen muss, die Vorzerstörung eingeleitet werden kann. Der darauffolgende große Fehler-Laststrom kann dann auch zu einem späteren Zeitpunkt erfolgen, der beispielsweise einige Millisekunden nach dem Aktivieren der Zündstruktur liegen kann.

Im Gegensatz hierzu muss bei einem "vorzerstörungsfreien" (herkömmlichen) Einschalten der Einschaltstruktur durch die Zündstruktur der herkömmliche Zündimpuls hier unmittelbar oder sofort vor dem Fehler-Laststrom erzeugt werden, insbesondere in einem Zeitbereich von lediglich ganz wenigen Mikrosekunden. Denn nur solange der herkömmliche Zündimpuls, der sich auf wenige Zehn Mikrosekunden bis 100 µs beschränkt (abhängig beispielsweise von einem das Einschaltsignal erzeugenden Generatorprinzip), noch anliegt oder seine Wirkung entfaltet, kann der Fehler-Laststrom, welcher Hunderte von Kiloampere betragen kann, in der Einschaltstruktur die gewünschte Zerstörung verursachen und in der Halbleiterstruktur einen permanenten Kurzschluss erzeugen.

Das erfindungsgemäße Kurzschluss-Halbleiterbauelement lässt somit eine wesentlich größere zeitliche Entzerrung zwischen dem Erzeugen des Einschaltsignals (Vorzerstörung) und der anschließend durch den Fehler-Laststrom herbeigeführten vollständigen Durchlegierung des Halbleiterkörpers zu.

Durch Verwendung des halbleiterbasierten Kurzschlussschalters gemäß der Erfindung werden darüber hinaus die Schaltzeiten von herkömmlicherweise etwa 1 ms bis 10 ms auf kleiner 100 µs verringert. Dadurch, dass erfindungsgemäß keine beweglichen mechanischen Teile im Kurzschlussschalter vorhanden sind und zusätzlich die Schaltzeiten derart kurz sind, wird die Sicherheit bzw. Zuverlässigkeit des Kurzschluss-Halbleiterbauelements erheblich verbessert.

Es sei noch einmal hervorgehoben, dass bei dem erfindungsgemäßen Kurzschluss-Halbleiterbauelement stets zwei Stromkreise vorgesehen sind:
1) Der die Vorzerstörung bewirkende Zündstromkreis und
2) Der Laststromkreis zwischen den äußeren Metallanschlüssen des Halbleiterbauelements, das heißt zwischen der vorderseitigen und rückseitigen Elektrode.

Gemäß einem weiteren Aspekt der Erfindung wird ebenfalls ein Verfahren zum Betreiben eines Kurzschluss-Halbleiterbauelements offenbart, das die hierin beschriebenen erfindungsgemäßen Merkmale aufweist. Insbesondere sollen hierbei bezüglich verfahrensbezogener Begriffsdefinitionen sowie der Wirkungen und Vorteile verfahrensgemäßer Merkmale vollumfänglich die hierin dargelegten Erläuterungen sinngemäßer Definitionen, Wirkungen und Vorteile bezüglich der erfindungsgemäßen Vorrichtung gelten. Das heißt, Offenbarungen hierin bezüglich der erfindungsgemäßen Vorrichtung sollen in sinngemäßer Weise auch zur Definition des erfindungsgemäßen Verfahrens herangezogen werden können, sofern dies hierin nicht ausdrücklich ausgeschlossen ist. Ebenso sollen Offenbarungen hierin bezüglich des erfindungsgemäßen Verfahrens in sinngemäßer Weise zur Definition der erfindungsgemäßen Vorrichtung herangezogen werden können, sofern dies hierin nicht ebenfalls ausdrücklich ausgeschlossen ist. Insofern wird hierin auf eine Wiederholung von Erläuterungen sinngemäß gleicher Merkmale, deren Wirkungen und Vorteile bezüglich der hierin offenbarten erfindungsgemäßen Vorrichtung sowie des hierin offenbarten erfindungsgemäßen Verfahrens zugunsten einer kompakteren Beschreibung weitgehend verzichtet.

Bei dem erfindungsgemäßen Verfahren zum Betreiben eines Kurzschluss-Halbleiterbauelements weist dieser einen Halbleiterkörper auf, in dem in einer vertikalen Richtung ausgehend von einer Rückseite mit einem durch ihren geometrischen Schwerpunkt festgelegten rückseitigen Zentrum hin zu einer der Rückseite gegenüberliegenden Vorderseite mit einem durch ihren geometrischen Schwerpunkt festgelegten vorderseitigen Zentrum eine rückseitige Basiszone von einem ersten Leitungstyp, eine Innenzone von einem zum ersten Leitungstyp komplementären zweiten Leitungstyp und eine vorderseitige Basiszone vom ersten Leitungstyp aufeinanderfolgend angeordnet sind, wobei die rückseitige Basiszone mit einer auf der Rückseite aufgebrachten rückseitigen Elektrode mit einer durch ihre laterale Erstreckung gegebenen lateralen rückseitigen Elektrodenweite elektrisch leitend verbunden ist und die vorderseitige Basiszone mit einer auf der Vorderseite aufgebrachten vorderseitigen Elektrode mit einer durch ihre laterale Erstreckung gegebenen lateralen vorderseitigen Elektrodenweite elektrisch leitend verbunden ist, wobei in die vorderseitige Basiszone wenigstens eine vorderseitige Einschaltstruktur eingebettet und von der vorderseitigen Elektrode wenigstens teilweise überdeckt ist und/oder in die rückseitige Basiszone wenigstens eine rückseitige Einschaltstruktur eingebettet und von der rückseitigen Elektrode wenigstens teilweise überdeckt ist, wobei die jeweilige Einschaltstruktur eine mit der auf diese jeweils einbettenden Basiszone aufgebrachten Elektrode elektrisch leitend kontaktierte Emitterstruktur vom zweiten Leitungstyp ist, die mittels wenigstens einer auf diese elektrisch über den Halbleiterkörper einwirkenden Zündstruktur einschaltbar ist, wobei die Zündstruktur wiederum mittels eines ihr zugeführten elektrischen Einschaltsignals aktivierbar ist.

Bei dem erfindungsgemäßen Verfahren wird durch Aktivieren der Zündstruktur mittels des Einschaltsignals eine Vorzerstörung herbeigeführt, indem ein elektrischer Stromstoß mit einem vordefinierten Energieeintrag in den Halbleiterkörper zwischen die Zündstruktur und die vorderseitige und/oder rückseitige Einschaltstruktur derart injiziert wird, dass durch den elektrischen Stromstoß ein zwischen der jeweiligen Einschaltstruktur und diese einbettenden Basiszone gebildeter erster Halbleiterübergang und/oder ein zwischen dieser Basiszone und der Innenzone gebildeter zweiter Halbleiterübergang irreversibel zerstört werden, wobei der Halbleiterkörper im Anschluss an die Vorzerstörung durch einen über die vorderseitige Elektrode und die rückseitige Elektrode fließenden Strom derart zerstört wird, dass sich eine Durchlegierung bildet.

Nach einer vorteilhaften Ausgestaltung der Erfindung ist der Energieeintrag in einem Bereich zwischen etwa 1 Ws bis etwa 3 Ws, beispielsweise 2 Ws, vorbestimmt. Hierdurch kann die Vorzerstörung wenigstens eines der beiden Halbleiterübergänge zuverlässig gewährleistet werden.

Der Begriff "etwa", wie er hierin im Zusammenhang mit der offenbarten Erfindung verwendet wird, gibt einen Toleranzbereich an, den der auf dem vorliegenden Gebiet tätige Fachmann als üblich ansieht. Insbesondere ist unter dem Begriff "etwa" ein Toleranzbereich der bezogenen Größe von bis maximal +/-20 %, bevorzugt bis maximal +/-10 % zu verstehen.

Gemäß einer weiteren vorteilhaften Ausgestaltung der Erfindung weist der Halbleiterkörper in einem zwischen der Zündstruktur und der vorderseitigen und/oder rückseitigen Einschaltstruktur liegenden Bereich, in den der Stromstoß injiziert wird, in radialer Richtung einen Widerstand (größer 0 Ω) von höchstens etwa 10 Ω, bevorzugt höchstens 5 Ω oder noch kleiner auf. Dies bedeutet, dass eine elektrisch verhältnismäßig gut leitende Verbindung zwischen der Zündstruktur und der Einschaltstruktur besteht, so dass dementsprechend auch keine hohe Spannung zwischen die Zündstruktur und die Einschaltstruktur eingeprägt werden kann. Daher kommt es beim Energieeintrag in den Halbleiterkörper vorliegend auf die von der Zündstruktur bereitgestellte Ladungsmenge und der damit zusammenhängenden Höhe des Stromstoßes an, der zwischen der aktivierten Zündstruktur auf der einen und der jeweiligen Einschaltstruktur auf der anderen Seite fließt. Diese Ladungsmenge bzw. die Stärke des Stromstoßes lassen sich jedoch besonders gut festlegen und einstellen, wie hierin dargelegt wird.

Eine weitere vorteilhafte Ausgestaltung der Erfindung sieht vor, dass die vorderseitige Einschaltstruktur eine durch ihre laterale Erstreckung gegebene laterale vorderseitige Einschaltstrukturweite aufweist und die rückseitige Einschaltstruktur eine durch ihre laterale Erstreckung gegebene laterale rückseitige Einschaltstrukturweite aufweist, wobei das Verhältnis der lateralen Einschaltstrukturweite zur entsprechenden lateralen Elektrodenweite der jeweiligen, die entsprechende Einschaltstruktur kontaktierende Elektrode kleiner als 1 ist, bevorzugt kleiner als 4/5, bevorzugter kleiner als 3/4, noch bevorzugter kleiner als 2/3 und weiter bevorzugter kleiner als 1/2.

Die als Emitterstruktur ausgebildete Einschaltstruktur mit einer gewissen lateralen Einschaltstrukturweite bietet den Vorteil, dass sich das Stromplasma vor dem Einsetzen der Durchlegierung über die Fläche der Emitterstruktur ausdehnen kann mit dem Ergebnis, dass die Durchlegierung eine größere laterale Weite und damit insgesamt einen größeren Querschnitt aufweist. Der auf diese Weise erzielte größere Leitungsquerschnitt des durchlegierten Bereichs im Halbleiterkörper bringt in vorteilhafter Weise eine Verringerung des elektrischen Widerstands des durch die Durchlegierung gebildeten Kurzschlussgebiets im Halbleiterkörper mit sich. Dementsprechend kann das Kurzschlussgebiet höhere Kurzschlussströme mit geringen Leitungsverlusten dauerhaft führen. Auf eine aktive Kühlung des erfindungsgemäßen Halbleiter-Bauelements kann vorteilhafterweise verzichtet werden.

Bei der Betrachtung des Verhältnisses zwischen der lateralen Einschaltstrukturweite und der jeweiligen lateralen Elektrodenweite wird gemäß der vorliegenden Erfindung stets die laterale Einschaltstrukturweite der vorderseitigen Einschaltstruktur, sofern diese im Halbleiterkörper vorhanden ist, mit der lateralen Elektrodenweite der vorderseitigen Elektrode verglichen und die laterale Einschaltstrukturweite der rückseitigen Einschaltstruktur, sofern diese im Halbleiterkörper vorhanden ist, mit der lateralen Elektrodenweite der rückseitigen Elektrode verglichen. Dementsprechend wird hierin auch von einer Zuordnung der vorderseitigen Einschaltstruktur zur vorderseitigen Elektrode und von einer Zuordnung der rückseitigen Einschaltstruktur zur rückseitigen Elektrode gesprochen.

Wie bereits weiter oben dargelegt, entsteht der permanente Kurzschluss auf einer lokal begrenzten Fläche im Halbeleiterbauelement, die vorliegend im Wesentlichen durch das jeweilige Verhältnis der lateralen vorderseitigen Einschaltstrukturweite zur lateralen vorderseitigen Elektrodenweite (falls eine vorderseitige Einschaltstruktur im Halbleiterkörper vorhanden ist) bzw. der lateralen rückseitigen Einschaltstrukturweite zur lateralen rückseitigen Elektrodenweite (falls eine rückseitige Einschaltstruktur im Halbleiterkörper vorhanden ist) bestimmt werden kann, so dass es dort anschließend infolge der hohen Stromdichte zu einer Aufschmelzung (Durchlegierung) im stromführenden Bereich kommt. Bei dieser Aufschmelzung kommt es zu einem Verschmelzen der Materialien der äußeren Metallanschlüsse (z. B. Aluminium, Molybdän und/oder Kupfer) und dem Silizium des Halbleiterkörpers. Nach dem Schmelzvorgang bildet sich eine metallische Zone mit hoher Leitfähigkeit aus, welche die äußeren Metallanschlüsse dauerhaft kurzschließt und prinzipiell auch in der Lage ist, diese Kurzschlussfunktion unter Strombelastung über eine längere Dauer aufrechtzuerhalten, zum Beispiel bis zur nächsten Instandsetzung.

Im Vergleich zu einem herkömmlichen Thyristor, bei dem das Verhältnis der lateralen Einschaltstrukturweite zur lateralen Elektrodenweite im Wesentlichen bei 1 liegt, um einen maximalen Stoßstrom und geringste Leitverluste realisieren zu können, ist die Stromtragfähigkeit der vorder- und/oder rückseitigen Einschaltstruktur bei dem erfindungsgemäßen Kurzschluss-Halbleiterbauelement aufgrund des hierin jeweils definierten Verhältnisses kleiner 1 derart definiert begrenzt, dass das Vorzerstören des erfindungsgemäßen Kurzschluss-Halbleiterbauelements sicher zu seiner anschließenden vollständigen Durchlegierung führt. Nach der Durchlegierung befindet sich das Kurzschluss-Halbleiterbauelement in einem permanenten, nicht reversiblen, niederohmig stromführenden Zustand zwischen der vorderseitigen und rückseitigen Elektrode, so dass eine zwischen diesen beiden Elektroden anliegende elektrische Spannung dauerhaft und langzeitstabil kurzgeschlossen werden kann. Mit anderen Worten ist der Spannungsabfall zwischen der vorderseitigen und rückseitigen Elektrode des erfindungsgemäßen Kurzschluss-Halbleiterbauelements im Kurzschlussfall so gering (niederohmig stromführender Zustand), dass auch bei länger andauerndem Kurzschlussbetrieb die elektrischen Verluste im erfindungsgemäßen Kurzschluss-Halbleiterbauelement gering sind und daher in vorteilhafter Weise auf eine aktive Kühlung verzichtet werden kann.

Im Sinne der vorliegenden Erfindung ist die Bedingung "kleiner 1" stets so auszulegen, dass herstellungsbedingte Größenabweichungen zwischen der jeweiligen lateralen Einschaltstrukturweite und der lateralen Elektrodenweite der der betrachteten Einschaltstruktur jeweils zugeordneten Elektrode, die innerhalb der für das jeweilige Herstellungsverfahren des erfindungsgemäßen Kurzschluss-Halbleiterbauelements definierten Herstellungstoleranzen liegen, nicht von der hierin verwendeten Bedingung "kleiner 1" erfasst sind. Mit anderen Worten ist gemäß der vorstehenden Definition ein Verhältnis einer lateralen Einschaltstrukturweite zu einer lateralen Elektrodenweite der entsprechenden Elektrode erst dann als im Sinne der vorliegenden Erfindung "kleiner 1" anzusehen, wenn sich die beiden verglichenen lateralen Weiten in ihrer Größe so sehr voneinander unterscheiden, dass dieser Größenunterschied sicher nicht mehr den herstellungsbedingten Toleranzabweichungen des betreffenden Merkmals zuzurechnen ist, sondern das Ergebnis zielgerichteten Handelns ist.

Es hat sich gezeigt, dass bei einer gegebenen vertikalen Dicke der Halbleiterinnenzone des Halbleiterkörpers der Aufschmelzstrom im Wesentlichen proportional zur Fläche der vorderseitigen und/oder rückseitigen Einschaltstruktur ist und sich somit festlegen lässt. Die im Vergleich zur lateralen Elektrodenweite der jeweiligen Elektrode (wesentlich) kleinere laterale Einschaltstrukturweite der entsprechenden Einschaltstruktur erlaubt zudem eine lokale Begrenzung der Durchlegierung im Kurzschluss-Halbleiterbauelement derart, dass sich die Ausdehnung der Durchlegierung in lateraler bzw. radialer Richtung im Wesentlichen auf die Fläche der vorder- und/oder rückseitigen Einschaltstruktur begrenzen lässt. Somit lässt sich der Bereich der Durchlegierung jedenfalls ausreichend weit von einem radial äußeren Randbereich des erfindungsgemäßen Kurzschluss-Halbleiterbauelements fernhalten. Die Durchlegierung findet dementsprechend ausschließlich im von der vorderseitigen und rückseitigen Elektrode überdeckten inneren Bereich des Kurzschluss-Halbleiterbauelements statt, so dass im Kurzschlussbetrieb keine mechanische Zerstörung des Kurzschluss-Halbleiterbauelements in seinem Randbereich auftritt, die einen Plasmaaustritt aus dem Kurzschluss-Halbleiterbauelement und damit eine Zerstörung eines das Kurzschluss-Halbleiterbauelement möglicherweise umgebenden Gehäuses zur Folge haben könnte.

Es sei an dieser Stelle noch angemerkt, dass das Verhältnis der lateralen vorderseitigen Einschaltstrukturweite zur lateralen vorderseitigen Elektrodenweite kleiner 1 bzw. das Verhältnis der lateralen rückseitigen Einschaltstrukturweite zur lateralen rückseitigen Elektrodenweite kleiner 1 für jeden beliebig betrachteten Ort des erfindungsgemäßen Kurzschluss-Halbleiterbauelements gelten soll. Wenn das erfindungsgemäße Kurzschluss-Halbleiterbauelement beispielsweise als Zylinder mit vollkommen rotationssymmetrischem Aufbau der vorderseitigen und/oder rückseitigen Einschaltstruktur und der entsprechenden Elektrode (vorderseitig und/oder rückseitig) ausgebildet ist, so gilt die Betrachtung des vorstehend definierten Verhältnisses an genau einem beliebigen Ort am Kurzschluss-Halbleiterbauelement unmittelbar auch für alle anderen Orte am Kurzschluss-Halbleiterbauelement. Verändert sich jedoch die laterale Einschaltstrukturweite und/oder die laterale Elektrodenweite bei dem beispielhaft gewählten zylinderförmigen Kurzschluss-Halbleiterbauelement je nach betrachteter Position entlang des Umfangs des Kurzschluss-Halbleiterbauelements, das heißt das Kurzschluss-Halbleiterbauelement ist hinsichtlich der betrachteten Einschaltstruktur und/oder der dieser zugeordneten Elektrode nicht rotationssymmetrisch aufgebaut, so kann sich auch das Verhältnis der lateralen Einschaltstrukturweite zur lateralen Elektrodenweite abhängig von der betrachteten Umfangsposition ändern. Nach vorstehender Definition soll dieses im Sinne der Erfindung jedoch an jedem beliebig betrachteten Ort am Kurzschluss-Halbleiterbauelement kleiner 1 sein.

Weiterhin ist zu verstehen, dass im Sinne der vorliegenden Erfindung in einem Fall, in dem eine Einschaltstruktur in radialer Richtung im Wesentlichen keine konstante Einschaltstrukturweite aufweist, für die Betrachtung des Verhältnisses zwischen der Einschaltstrukturweite und der Elektrodenweite der der Einschaltstruktur entsprechend zugeordneten Elektrode die in radialer Richtung größte auftretende Einschaltstrukturweite als für den Vergleich zu verwendende Einschaltstrukturweite heranzuziehen ist.

Besonders bevorzugt wird das Verhältnis der lateralen Einschaltstrukturweite zur lateralen Elektrodenweite der jeweils der vorderseitigen bzw. rückseitigen Einschaltstruktur entsprechend zugeordneten vorderseitigen bzw. rückseitigen Elektrode kleiner als 4/5 gewählt, zum Beispiel auch kleiner als 3/4, 2/3, 1/2, 1/3, 1/4, 1/5. Somit wird die laterale Einschaltstrukturweite der vorderseitigen bzw. rückseitigen Einschaltstruktur bei dem erfindungsgemäßen Kurzschluss-Halbleiterbauelement wesentlich kleiner gewählt als die laterale Elektrodenweite der jeweiligen Elektrode. Hierdurch lässt sich der Aufschmelzstrom, bei dem es sicher zur Durchlegierung des erfindungsgemäßen Kurzschluss-Halbleiterbauelements kommt, auf einen gewünscht kleinen Wert festlegen. Somit ist sichergestellt, dass auch ein relativ kleiner, von dem erfindungsgemäßen Kurzschluss-Halbleiterbauelement zwischen der vorderseitigen Elektrode und der rückseitigen Elektrode geführter Fehler- bzw. Kurzschlussstrom das Bauelement in gewünschter Weise sicher durchlegiert und somit den nicht reversiblen, niederohmig stromführenden Zustand herstellt (kurzgeschlossener Betriebszustand).

Eine weitere vorteilhafte Ausgestaltung der Erfindung sieht vor, dass die Einschaltstruktur vollständig von der vorderseitigen Elektrode und der rückseitigen Elektrode überdeckt ist, wobei hierunter die Überdeckung in lateraler (radialer) Richtung zu verstehen ist. Die vollständige vorder- und rückseitige Überdeckung der wenigstens einen Einschaltstruktur bietet den Vorteil, dass die Möglichkeit eines Plasmaaustritts aus dem Halbleiterkörper infolge der Durchlegierung noch weiter verringert wird, da sich die Durchlegierung beim erfindungsgemäßen Kurzschluss-Halbleiterbauelement im Wesentlichen derart lokal begrenzen lässt, dass diese im von den beiden Elektroden überdeckten Bereich stattfindet, wie bereits vorstehend beschrieben wurde. Damit wird auch eine Zerstörung eines das Kurzschluss-Halbleiterbauelement möglicherweise umgebenden Gehäuses aufgrund eines auf diese Weise unterbundenen Plasmaaustritts aus dem Kurzschluss-Halbleiterbauelement während der Durchlegierung sicher verhindert. Bevorzugt kann die Überdeckung der jeweiligen Einschaltstruktur von der vorder- bzw. rückseitigen Elektrode im radial äußeren Randbereich (also in Richtung zum radialen Außenrand des erfindungsgemäßen Kurzschluss-Halbleiterbauelements) im Bereich von wenigstens einigen Millimetern liegen, z. B. etwa 1 mm bis 5 mm oder größer.

Weiterhin kann die wenigstens eine Einschaltstruktur vorzugsweise zentrumsnah im Halbleiterkörper angeordnet sein. Hierunter ist zu verstehen, dass der radiale Abstand von einer die Einschaltstruktur radial am weitesten radial nach innen begrenzenden Innenseite zum entsprechenden Zentrum des Halbleiterkörpers, das heißt dem geometrischen Schwer- bzw. Mittelpunkt der Vorder- und/oder Rückseite des Halbleiterkörpers (hierin auch als radiales Zentrum bezeichnet), kleiner ist als der Abstand von einer die Einschaltstruktur radial am weitesten nach außen begrenzenden Außenseite zu einem radialen Außenrand des Halbleiterkörpers. Auch durch diese Maßnahme wird in erster Linie die Möglichkeit eines Plasmaaustritts bei der Durchlegierung des erfindungsgemäßen Kurzschluss-Halbleiterbauelements im Randbereich des Halbleiterkörpers weiter verringert, da die Durchlegierung auf einen zentrumsnahen Bereich des Halbleiterkörpers zwischen der vorderseitigen und der rückseitigen Elektrode begrenzt wird, der von ebendiesen Elektroden überdeckt ist. Eine Zerstörung eines das Kurzschluss-Halbleiterbauelement möglicherweise umgebenden Gehäuses infolge der Durchlegierung wird somit ebenfalls sicher verhindert.

Eine weitere vorteilhafte Ausgestaltung der Erfindung sieht vor, dass die vorderseitige Elektrode und die rückseitige Elektrode das vorderseitige beziehungsweise rückseitige Zentrum des Halbleiterkörpers überdecken und die Einschaltstruktur in diesem Zentrum angeordnet ist. Hierdurch lässt sich der Abstand von einer die Einschaltstruktur radial nach außen begrenzenden Außenseite zu einem radialen Außenrand des Halbleiterkörpers maximieren und damit der Randbereich des Halbleiterkörpers sowie zusätzlich der Bereich zwischen der radialen Außenseite der Einschaltstruktur und dem radialen Außenrand des Halbleiterkörpers abhängig von der gewählten lateralen Elektrodenweite der vorderseitigen und rückseitigen Elektrode, die erfindungsgemäß stets größer ist als die laterale Einschaltstrukturweite, durch die Überdeckung der Vorder- und Rückseite des Halbleiterkörpers vor einem unerwünschten Plasmaaustritt infolge der Durchlegierung des Kurzschluss-Halbleiterbauelements sicher schützen.

Eine noch weitere vorteilhafte Ausgestaltung der Erfindung sieht vor, dass eine elektrisch isolierende Isolatorschicht zwischen der Einschaltstruktur und der diese elektrisch leitend kontaktierenden Elektrode angeordnet ist, wobei sich die Isolatorschicht in radialer Richtung über diese Einschaltstruktur erstreckt und in Umfangsrichtung des Halbleiterkörpers entlang einem in radialer Richtung innen liegenden Innenrand dieser Elektrode erstreckt.

Es ist zu verstehen, dass die Isolatorschicht flächig nicht derart weit ausgedehnt ist, dass eine vollständige elektrische Isolierung der Elektrode von der Einschaltstruktur und der die Einschaltstruktur einbettenden Basiszone besteht. Vielmehr bleibt wenigstens ein Bereich zwischen der Elektrode und der Einschaltstruktur sowie der Basiszone frei von der Isolatorschicht, so dass weiterhin eine elektrisch leitende Verbindung zwischen der Elektrode und der Einschaltstruktur sowie der Basiszone vorhanden ist.

Die Isolatorschicht kann vorzugsweise eine Dicke von wenigstens 10 nm bis höchstens 100 nm aufweisen, bevorzugter von wenigstens 50 nm bis höchstens 100 nm.

Die Isolatorschicht kann bevorzugt eine Siliziumoxidschicht sein.

Weiterhin kann die Isolatorschicht gemäß einer weiteren vorteilhaften Ausgestaltung der Erfindung in radialer Richtung zueinander beabstandete Öffnungen aufweisen, die eine direkte elektrisch leitende Verbindung zwischen der Elektrode und der an dieser anliegenden Basiszone herstellen.

Gemäß einer noch weiteren vorteilhaften Ausgestaltung der Erfindung ist die Zündstruktur eine Gate-Elektrode und das Einschaltsignal der von der Zündstruktur in den Halbleiterkörper injizierte Stromstoß.

Ein beispielhafter Gateaufbau umfasst einen Gatefederdraht, der die Gate-Elektrode von außen kontaktiert. Der Gatefederdraht drückt sich mit seiner Eigenspannung auf den Gateanschluss des Halbleiterkörpers.

Es ist vorstellbar, dass anstelle dieses Feder-Gateaufbaus auch eine andere Form verwendet werden kann, die mehr einen flächigen Übergang zwischen dem Gatezuleitungsdraht und dem Gatekontakt herstellt, um z. B. den Kontaktübergangswiderstand so gering wie möglich zu halten.

Der Übergangs- bzw. Kontaktwiderstand zur Gateelektrode ist kritisch, vor allem bei den gegenüber den üblichen Gateströmen (im Bereich von 10 A) doch sehr hohen Stromimpulsen im Bereich von bis zu mehreren Hundert Ampere, wenn nicht Kiloampere. Der Kontaktwiderstand zum Silizium muss durch eine geeignete Ausführung klein und stabil gehalten werden. Hierfür müssen geeignete Kontaktmaterialien bzw. Oberflächenbeschichtungen gewählt werden. So dürfen diese Oberflächen nicht korrodieren.

Auch die Kontaktkräfte müssen besonders genau eingestellt werden, um einen zu hohen Übergangswiderstand bei diesen hohen Stromimpulsen zu vermeiden.

Gelingt das nicht, kann dies zum Ausfall direkt am Übergang Gatezuleitungsdraht zum Gatemetall führen (Gefahr von Plasmaaustritt, da sich dieser Bereich nicht im gedrückten Bereich befindet).

Um die Langzeitstabilität eines niederohmigen Kontaktübergangs sicherzustellen, kommen Oberflächenbeschichtungen im Bereich des Überganges Gatezuleitungsdraht zu Gatemetall auf der Halbleiteroberfläche in Frage. Geeignete langzeitstabile bzw. besonders korrosionsfeste Oberflächenbeschichtungsmaterialien zur Beschichtung des Gatezuleitungsdrahts sind beispielsweise Ruthenium oder Rhodium, falls z. B. eine Vernickelung nicht ausreichend wäre. Weitere Verbesserungen sind mit Edelmetallbeschichtungen wie Au möglich. So lassen sich nicht nur der Gatedraht, sondern auch die Metalloberfläche des Gatekontaktes des Halbleiters beschichten. Zur Verbesserung der Haftung können zusätzlich noch Haftvermittler wie Titan zum Einsatz kommen.

Weiter kann es hilfreich sein, die (Gate-) Metallisierung des Halbleiters mit einer besonders dicken (weichen) Silberschicht zu versehen, was hilft, den Kontaktwiderstand zum üblicherweise harten bzw. härteren Gatezuleitungsdraht (auch wg. der Federwirkung) zu verringern. Mit anderen Worten kann die Gate-Elektrode vorzugsweise auf ihrer in vertikaler Richtung außen liegenden metallischen Kontaktseite mit einer derartigen Silberschicht beschichtet sein, die einerseits verhältnismäßig dick ist und andererseits wesentlich weicher ist, als der die Silberschicht kontaktierende, externe Gate-Elektroden-Kontaktierungsdraht (Federdraht).

Da diese Maßnahmen kostenintensiv sein können, ist ein möglichst einfaches Kontaktsystem, also ohne zusätzliche aufwändige Beschichtungen anzustreben. Dies ist umso leichter realisierbar, je niedriger die Stromamplitude des Entladestromes/Stoßstrom sein kann. Nachfolgend beschriebene weitere Maßnahmen (z. B. kleine Durchmesser, geringer Abstand zwischen Gate und Einschaltstruktur/Elektrode sowie geringer Umfang der Einschaltstruktur) führen dazu, den notwendigen Entladestrom/Stoßstrom und damit auch den Energieeintrag so gering oder klein wie möglich ausführen zu können.

Eine noch weitere vorteilhafte Ausgestaltung der Erfindung sieht einen Kondensator mit einer dem vorbestimmten Energieeintrag entsprechend vorbestimmten Kapazität vor, der das Einschaltsignal in einem aufgeladenen Zustand bereitstellt, wobei der Kondensator mittels eines elektronischen Schalters elektrisch zwischen die Gate-Elektrode und die vorderseitige Elektrode und/oder die rückseitige Elektrode schaltbar ist.

Der Kondensator kann beispielsweise über eine spezielle Schaltanordnung aufgeladen werden, so dass die Kondensatorenergie aus dem am Halbleiterbauelement anliegenden Lastkreis kommt. Die Aufladung des Kondensators kann alternativ auch über eine Gate-Steuerelektronik erfolgen bzw. der Kondensator noch auf der Primärseite eines Zündtransformators liegen.

Der Durchmesser des Gatezentrums, also von der Mitte (Zentrum) des Halbleiterbauelementes bis zum Beginn des Kathodenemitters (vorderseitige Einschaltstruktur), liegt bei herkömmlichen Thyristorstrukturen im Bereich von 10 mm bis 20 mm, typisch vielleicht bei 15 mm bei größeren Thyristoren mit einem Bauteildurchmesser > 3". Wegen dieser räumlichen Ausdehnung muss die Entladeenergie und damit auch die Energiedichte ausreichend groß gewählt werden, um eine sichere Vorzerstörung erzeugen zu können.

Zum anderen kann die Zerstörungsenergie, welche vom Kondensator gespeichert wird, aber auch nicht beliebig groß gewählt werden. Die im Kondensator gespeicherte Energie beträgt (C×U^2)/2=Q^2/(2×C). Um einen hohen Strom für die Zerstörung zu erhalten, muss man eine ausreichend hohe Kapazität wählen, z. B. 4 mF. Für Ladespannungen von 30 V bzw. 40 V erreicht man damit eine Energie von 1,8 Ws bzw. 3,2 Ws. Damit lässt sich der erreichbare Strom (ΔQ/Δt) schätzen. Nimmt man eine (Entlade-) Zeiteinheit von 100 µs an und bestimmt aus der Energie die im Kondensator gespeicherte Ladungsmenge ΔQ, ergeben sich hohe Stromimpulse/Stromstöße im Bereich von 1,2 kA bis 1,6 kA. Unter der Annahme, dass dieser Strom radialsymmetrisch vom Gatekontakt auf die Innenkante der Elektrode (z. B. Kathode) fließt (Annahme: Strom fließt direkt vom Gatemetall zur kreisförmigen Innenkannte des Kathodenmetalls, aber nicht in eventuell vorhandene Gatefinger), ergibt sich eine linienspezifische Stromdichte am Beginn des inneren kreisförmigen Kathodenemitters (typ. Umfang der kreisförmigen Kathodeinnenkante: ca. 50 mm) von ca. 20 bis 30 A/mm. Wenn man für die Tiefe der leitfähigen Basiszone 50 µm bzw. 0,05 mm annimmt, erhält man am Beginn des inneren Kathodenemitters eine Stromdichte im Bereich von 500 A/mm². Dieser Wert muss am Ende so groß sein, dass dort, also im Bereich des inneren Kathodenemitters die gewünschte Vorzerstörung erzeugt wird, wobei noch die sehr kurze Stromdauer berücksichtig werden muss. Je kürzer die Stromdauer bzw. die Impulslänge, umso höher müssen der eingeprägte Strom bzw. die Ladungsmenge gewählt werden.

Bei einer herkömmlichen Thyristorstruktur befindet sich zwischen der Metallkante des Gatekontaktes und der Innenkante des Kathodenemitters der relativ zum Metall hochohmige Bereich der p-Zone und zusätzlich noch ein oder mehrere ringförmige Amplifying-Gates. Beides führt in diesem Bereich zu einem erhöhten Widerstand, der bei dieser impulsförmigen Strombelastung einen entsprechend hohen Spannungsabfall hervorruft. Dies kann aber zum Ausfall im Amplifying-Gatebereich führen bzw. in diesem Bereich eine unerwünschte Vorzerstörung erzeugen. Das muss aber auf jeden Fall vermieden werden, da dieser Bereich sich nicht innerhalb des gedrückten Bereiches der Kontaktelektroden befindet. Eine Durchlegierung an dieser Stelle führt zum "Ausblasen" von Plasma aus der Gatezuführung (Stelle in der Keramikkapsel, durch die der Gatedraht zugeführt wird).

Daher weist das erfindungsgemäße Halbleiterbauelement bevorzugt folgende Merkmale auf:
- Geringstmöglicher Abstand zwischen der radial äußeren Metallkante des Gateanschlusses G und der radialen Innenkante der Einschaltstruktur (Emitterstruktur), um die Zerstörung im Bereich zwischen Gateanschluss und Einschaltstruktur, also in einem möglicherweise nichtgedrückten Bereich, zu vermeiden;
- Weglassen von Amplifying-Gatestufen;
- Möglichst kleiner Durchmesser für den kreisförmigen Gatemetallanschluss und der Innenkante der Einschaltstruktur (z. B. lediglich 1,75 mm bis einige wenige Millimeter);
- Keine Verwendung von langen Gatefingern, denn dadurch verringert sich die spezifische Stromdichte bzw. die Energiedichte, die zur Zerstörung führen soll, wobei die stromführende Fläche das Produkt aus Umfang und Tiefe der Basiszone (ca. 0,05 mm) ist;
- Möglichst kleiner innerer Umfang des Emitters bzw. der Einschaltstruktur. Das bietet auch den Vorteil, dass der Energieeintrag für die Vorzerstörung und damit auch die Kapazität des Kondensators verringert werden können. Z. B. können anstelle von kreisrunden Einschaltstrukturen nur noch ringsegementförmige Einschaltstrukten verwendet werden;
- Den Entladestrom/Stoßstrom gezielt nur auf eine kleine Stelle der Innenkante der Einschaltstruktur lenken, indem in die Basiszone zwischen Gatemetall und Innenkante des Kathodenmetalls ein hochohmiger Widerstandsbereich angeordnet wird; Dadurch fließt der Entladestrom/Stoßstrom vornehmlich nur zwischen dem Gatemetall und der Einschaltstruktur bzw. einem kleinen Bereich der Einschaltstruktur, was dort zu einer erhöhten Energiedichte führt.

Besonders bevorzugt kann wenigstens ein Bereich der die Emitterstruktur enthaltenden Basiszone, der die elektrische Wirkverbindung zwischen der Gate-Elektrode und der Emitterstruktur bildet, derart ausgebildet sein, dass ein der Gate-Elektrode zugeführtes elektrisches Signal mit einer Stromstärke von wenigstens etwa 1 A, bevorzugt wenigstens etwa 2 A und noch bevorzugter zwischen etwa 5 A und etwa 10 A zum Einschalten/Vorzerstören der Emitterstruktur verwendbar ist. Hierbei ist zu verstehen, dass der Bereich der die Einschaltstruktur einbettenden Basiszone zwischen der Zündstruktur und der jeweiligen Einschaltstruktur derart ausgebildet sein kann, dass die Einschaltstruktur mittels der Zündstruktur mit einem Übersteuerungsfaktor von höchstens 10, bevorzugt höchstens 5, noch bevorzugter höchstens 3, einschaltbar ist, wobei ein das Einschalten/Vorzerstören der Einschaltstruktur bewirkender Mindesteinschaltstrom wenigstens etwa 1 A, bevorzugt wenigstens etwa 2 A und noch bevorzugter zwischen wenigstens etwa 5 A und höchstens etwa 10 A beträgt.

Der Zünd- bzw. Einschaltstrom eines herkömmlichen Thyristors hängt vom spezifischen Flächenwiderstand seiner kathodenseitigen Basiszone ab, in die der kathodenseitige Emitter eingebettet ist, und muss prozesstechnisch so eingestellt werden, dass die Zünd- bzw. Einschaltstromwerte typischerweise im mA-Bereich liegen, insbesondere Werte zwischen 30 mA (125 °C) und 400 mA (Raumtemperatur) annehmen und dementsprechend innerhalb eines relativ engen Bereiches liegen. Damit wird zum Beispiel sichergestellt, dass herkömmliche Thyristoren die hohen Einschaltbelastungen beim Schalten sehr hoher Ströme mit sehr hohen Stromsteilheiten zu Beginn des Einschaltens sicher überstehen, wenn sie von üblichen Zünd- bzw. Einschaltstromgeneratoren mit genau definierten Zünd- bzw. Einschaltstromverläufen (Zünd-IEinschaltstromamplitude und -dauer) angesteuert werden.

Da das erfindungsgemäße Kurzschluss-Halbleiterbauelement nach dem einmaligen Auslösen durchlegiert sein soll, wird für das Kurzschluss-Halbleiterbauelement bevorzugt ein wesentlich höherer minimaler Einschaltstrom gewählt, insbesondere im Ampere-Bereich, zum Beispiel wenigstens 1 A oder wenigstens 2 A oder sogar wenigstens 5 A bis etwa 10 A, da sich hierdurch einerseits der Aufwand für die Kontrolle des spezifischen Flächenwiderstands der die Emitterstruktur enthaltenden Basiszone bei der Herstellung des Kurzschluss-Halbleiterbauelements wesentlich verringern lässt und andererseits an die das elektrische Einschaltsignal erzeugenden Zünd- bzw. Einschaltstromgeneratoren erheblich geringere Anforderungen gestellt werden können, so dass kostengünstigere Ansteuerungskonzepte möglich sind.

Weiterhin ist zu verstehen, dass trotz des bei dem erfindungsgemäßen Kurzschluss-Halbleiterbauelement gemäß dieser Ausführungsform gewählten verhältnismäßig hohen Zünd- bzw. Einschaltstroms das erfindungsgemäße Kurzschluss-Halbleiterbauelement dennoch nur schwach übersteuert angesteuert wird, also z. B. mit einer Übersteuerung von 10 A/5 A = 2. Wird hingegen bei einem herkömmlichen Thyristor ein Zünd- bzw. Einschaltstrom anstatt im mA-Bereich wie vorstehend erläutert im Ampere-Bereich, z. B. im Bereich zwischen 5 A und 10 A, verwendet, führt dies zu einer um ein oder zwei Größenordnung höher liegenden Übersteuerung eines herkömmlichen Thyristors mit einem Übersteuerungsfaktor von beispielsweise 10 A/100 mA = 100. Der große Übersteuerungsfaktor ermöglicht dem herkömmlichen Thyristor ein schnelles Einschalten.

Bei dem erfindungsgemäßen Kurzschluss-Halbleiterbauelement fördert eine schwach gewählte Übersteuerung (mit einem dennoch hohen Zünd- bzw. Einschaltstrom im Ampere-Bereich) den gewünschten Ausfall des Bauelements, das heißt die gewünschte einmalige, irreversible Durchlegierung. Insbesondere stellt die Vorgabe einer maximalen Übersteuerung im Sinne der vorliegenden Ausgestaltung einen für die gewünschte Vorzerstörung erforderlichen Mindestenergieeintrag über die Zündstruktur sicher.

Ein hoher Einschaltstrom bringt darüber hinaus weitere Vorteile. So lässt sich beispielsweise eine einfache Detektion zur Überprüfung der Einsatzbereitschaft des Kurzschluss-Halbleiterbauelements durch einen dauerhaften Prüfstrom zwischen den Anschlüssen der Gate-Elektrode und der Elektrode, welche die durch die Gate-Elektrode einzuschaltende/zu zerstörende Emitterstruktur kontaktiert (vorderseitige oder rückseitige Elektrode), bereitstellen, wobei der Prüfstrom dann sehr viel kleiner als der Einschaltstrom gewählt wird. Darüber hinaus bietet ein hoher Einschaltstrom auch einen höheren EMV-Schutz beispielsweise gegenüber Fehlzündungen verursacht durch schnelle Änderungen von sehr hohen Spannungen und Strömen im Umfeld des Kurzschluss-Halbleiterbauelements, da die Anfälligkeit gegenüber solchen Fehlzündungen mit kleiner werdendem Zünd- bzw. Einschaltstrom zunimmt.

Neben den vorstehend beschriebenen Einschaltstromstärken sind in speziellen Fällen auch Einschaltströme deutlich kleiner als 1 A im Kurzschluss-Halbleiterbauelement gemäß der Erfindung einstellbar, zum Beispiel Einschaltstromstärken kleiner als 1 A bis hinunter zu etwa 500 mA oder noch kleiner bis hin zu etwa 100 mA.

Gemäß einer weiteren vorteilhaften Ausgestaltung der Erfindung ist die Zündstruktur eine Durchbruchstruktur und das Einschaltsignal die zwischen der vorderseitigen Elektrode und der rückseitigen Elektrode anliegende elektrische Spannung. Die Durchbruchstruktur ist dadurch gekennzeichnet, dass sie abhängig von der an den äußeren Elektroden des Kurzschluss-Halbleiterbauelements anliegenden elektrischen Spannung, die einen entsprechenden Spannungsabfall über der Durchbruchstruktur bewirkt, bei Erreichen bzw. Überschreiten einer für die Durchbruchstruktur bestimmbaren Durchbruchspannung einen steilen Stromanstieg in Form eines Avalanchestroms, der vorzugsweise nicht durch einen Schutzwiderstand begrenzt ist, zulässt, durch den die Vorzerstörung wenigstens eines der beiden Halbleiterübergänge mit der als Zündstruktur ausgebildete Durchbruchstruktur erzielbar ist.

Die Durchbruchstruktur kann beispielsweise als BOD-Struktur (BOD: Break Over Diode) ausgebildet sein. Andere funktionell ähnlich wirkende, an sich beispielsweise von herkömmlichen lichtzündbaren Thyristoren (LTT) bekannte Durchbruchstrukturen sind ebenfalls verwendbar, zum Beispiel eine einen gewöhnlichen du/dt-Schutz aufweisende Durchbruchstruktur und/oder eine einen gewöhnlichen Freiwerdezeitschutz mit lokaler Anhebung der Ladungsträgerlebensdauer aufweisende Durchbruchstruktur. Die Durchbruchstruktur stellt darüber hinaus eine weitere Maßnahme zur Vermeidung eines Sperrausfalls in einem radial äußeren Randbereich des Kurzschluss-Halbleiterbauelements im Falle einer nicht vorhersehbaren Überspannung dar. Die Höhe der Durchbruchspannung der Durchbruchstruktur wird dabei so eingestellt, dass sie an genau dem Ort der Durchbruchstruktur ihren niedrigsten Wert des ganzen Halbleiterkörpers annimmt und so einen Durchbruch im Randbereich sicher verhindert. Hierzu ist die Durchbruchstruktur bevorzugt randfern, insbesondere zentrumsnah, im Halbleiterkörper angeordnet. Beispielsweise kann die Durchbruchstruktur in Form einer das Zentrum umgebenden, jedoch von diesem (geringfügig) beabstandeten, umfänglich geschlossenen Struktur wie zum Beispiel einer Ring- und/oder Polygonstruktur ausgebildet sein. Sie kann jedoch in anderen Fällen auch direkt im Zentrum des Halbleiterkörpers angeordnet sein. Als umfängliche Richtung ist hierin eine Erstreckungsrichtung parallel zur Vorderseite bzw. Rückseite des Halbleiterkörpers und im Wesentlichen senkrecht zur radialen bzw. lateralen Richtung des Halbleiterkörpers zu verstehen.

In einer konstruktiv besonders günstig herzustellenden Ausgestaltung der Erfindung weist eine Einschaltstruktur, die zum Beispiel aufgrund einer im Zentrum des Halbleiterkörpers angeordneten Zündstruktur dieses Zentrum und die Zündstruktur beabstandend umgebend angeordnet ist, einen geschlossenen Umfang auf. Die Einschaltstruktur kann beispielsweise als geschlossene Ring- und/oder Polygonstruktur ausgebildet sein. Als umfängliche Richtung ist hierin eine Erstreckungsrichtung der Einschaltstruktur parallel zur Vorderseite bzw. Rückseite des Halbleiterkörpers und im Wesentlichen senkrecht zur radialen bzw. lateralen Richtung des Halbleiterkörpers zu verstehen.

Gemäß einer noch weiteren vorteilhaften Ausgestaltung der Erfindung ist die Einschaltstruktur in radialer Richtung von der Zündstruktur beabstandet und weist wenigstens ein Einschaltstruktursegment mit einer in einer Umfangsrichtung des Halbleiterkörpers verlaufenden Einschaltstrukturweite auf, die überall kleiner ist als eine geschlossene Umfangslänge in Umfangsrichtung durch das Einschaltstruktursegment. Mit anderen Worten ist die Einschaltstruktur in diesem Ausführungsbeispiel umfänglich nicht geschlossen, wie dies zum Beispiel bei einer geschlossenen Ring- und/oder Polygonstruktur der Fall ist. Das heißt die umfängliche Einschaltstrukturweite des wenigstens einen Einschaltstruktursegments, das z. B. lediglich einem Ringsegment entsprechen kann, ist jedenfalls kleiner als eine umfängliche Einschaltstrukturweite, die einer geschlossenen Ring- und/oder Polygonstruktur der Einschaltstruktur und damit einem Umfangswinkel der geschlossenen ring- und/oder polygonförmigen Einschaltstruktur von 360 Grad entsprechen würde. Da eine zum Zentrum des Halbleiterkörpers in radialer Richtung beabstandete Einschaltstruktur mit einer umfänglich geschlossenen Polygon- und/oder Ringstruktur herstellungsbedingt eine gewisse Mindestfläche aufweist, da beispielsweise die laterale Einschaltstrukturweite prozesstechnisch nicht kleiner als eine bestimmte laterale Mindeststrukturweite herstellbar ist, die zum Beispiel wenigstens etwa 50 µm betragen kann, lässt sich durch die vorliegende vorteilhafte Ausgestaltung des erfindungsgemäßen Kurzschluss-Halbleiterbauelements die für die Aufschmelzung des Halbleiterkörpers wirksame Fläche der Einschaltstruktur noch weiter verkleinern, wodurch sich auch besonders kleine Aufschmelzströme, die zum sicheren Durchlegieren des Halbleiterkörpers führen, realisieren lassen. Es wäre demnach zum Beispiel möglich, ein minimales, einzelnes Einschaltstruktursegment mit einer lateralen Einschaltstrukturweite von etwa 50 µm und einer umfänglichen Einschaltstrukturweite, das heißt einer Umfangslänge, von ebenfalls etwa 50 µm im Halbleiterkörper vorzusehen, was die Auslegung eines erfindungsgemäßen Kurzschluss-Halbleiterbauelements mit einem Aufschmelzstrom in der Größenordnung von wenigen mA ermöglicht.

Gemäß einer noch weiteren vorteilhaften Ausgestaltung der Erfindung sind in Umfangsrichtung des Halbleiterkörpers wenigstens zwei voneinander getrennte Einschaltstruktursegmente vorgesehen. Diese sind vorzugsweise äquidistant zueinander beabstandet, um eine im Wesentlichen umfänglich symmetrische Ausgestaltung des Kurzschluss-Halbleiterbauelements zu erzielen, die eine gleichmäßigere Stromverteilung im Halbleiterkörper sowohl des Einschaltstroms zum Einschalten bzw. Vorzerstören der Einschaltstruktur als auch des Aufschmelzstroms zum Herstellen der Durchlegierung im Halbleiterkörper und damit eine gleichmäßigere Wärmeverteilung, insbesondere während des Durchlegierens, über den gesamten Halbleiterkörper, das heißt eine gleichmäßiger verteilte mechanische Belastung, bewirkt.

Eine noch weitere vorteilhafte Ausgestaltung der Erfindung sieht vor, dass der elektrische Widerstand in der die Einschaltstruktur enthaltenden Basiszone wenigstens in einem Abschnitt des radialen Zwischenraums zwischen der Einschaltstruktur und der Zündstruktur (hierin auch als Widerstandsbereich der Basiszone bezeichnet) mit Ausnahme wenigstens eines das wenigstens eine der Einschaltstruktursegmente mit der Zündstruktur elektrisch koppelnden Durchgangskanals erhöht ist. Hierdurch lässt sich der von der Zündstruktur zur Einschaltstruktur fließende Einschaltstrom gezielt auf das einzelne Einschaltstruktursegment lenken, um dieses im Bedarfsfall zum Einleiten der Durchlegierung des erfindungsgemäßen Kurzschluss-Halbleiterbauelements sicher einzuschalten bzw. vorzuzerstören. Durch den gezielt mittels des Durchlasskanals auf das wenigstens eine Einschaltstruktursegment geleiteten Einschaltstrom lässt sich der zum Einschalten/Vorzerstören des bzw. aller Einschaltstruktursegmente notwendige, von der Zündstruktur bereitgestellte Gesamteinschaltstrom gegenüber einer ansonsten in allen radialen Richtungen homogen verlaufenden Einschaltstromverteilung in vorteilhafter Weise zusätzlich verringern.

Unter einem erhöhten Widerstand im Widerstandsbereich der Basiszone im Vergleich zum Widerstandswert im Durchlasskanal ist ein solcher Größenunterschied der Widerstände zu verstehen, der sicher nicht den herstellungsbedingten Größenabweichungen von gewöhnlich in Kauf genommenen Herstellungstoleranzen zuzurechnen ist, sondern das Ergebnis zielgerichteten Handelns ist. So kann der Widerstand im Widerstandsbereich beispielsweise durch eine im Vergleich zum Rest der Basiszone wesentlich geringere Konzentration der Ladungsträger vom selben Leitungstyp wie jener der restlichen Basiszone gezielt erhöht werden und/oder durch Einbringen eines so genannten Pinch-Widerstands mit einem zum Leitungstyp der Basiszone komplementären Leitungstyp in den Widerstandsbereich der Basiszone, wodurch der Widerstand im Widerstandsbereich der Basiszone aufgrund einer Verkleinerung des wirksamen Leitungsquerschnitts in der Basiszone ebenfalls gezielt erhöht wird.

Im Fall der Verwendung eines lediglich kleinen (ringförmigen) Einschaltstruktursegments soll dieses im Fehlerfall angesteuert werden, um dort eine vollständige Durchlegierung zu erzeugen. Das Problem bei dieser Struktur liegt darin, dass der Widerstand zwischen den Metallkanten des Gatekontaktes und des Elektrodenkontaktes wegen der recht hohen spezifischen Leitfähigkeit der Basiszone so klein ist, dass ein Großteil des Stromes, der ja eigentlich die Einschaltstruktur lokal zerstören soll, in den gesamten Metallkontakt der Elektrodenmetallisierung fließt und dadurch die Energiedichte des Entladestromimpulses/Stoßstroms so stark herabsetzt, dass es nicht zu einer Vorzerstörung kommt. Daher kann ein zusätzlicher Widerstand bzw. eine Widerstandszone in die Basiszone angebracht sein, wie hierin beschrieben ist.

Alternativ oder in Ergänzung zu der zusätzlichen Widerstandszone ist es auch denkbar, dass im gesamten Bereich des Elektrodenkontaktes die weiter oben bereits beschriebene sehr dünne Isolatorschicht im Nanometer-Bereich aufgebracht wird. Z. B. lässt sich eine ganzflächige SiO2-Schicht auf der Halbleiteroberfläche (Vorderseite bzw. Rückseite) des Halbleiterkörpers erzeugen. Mittels Fotostrukturierung lässt sich dann innerhalb des Gatebereiches bzw. innerhalb der Innenkante der Einschaltstruktur und in einem kleinen Bereich der Einschaltstruktur diese Isolatorschicht entfernen, so dass nur in diesen Bereichen, die frei von dieser Isolatorschicht sind, ein direkter Kontakt zwischen der Siliziumoberfläche des Halbleiterkörpers und der Metallisierung der Elektrode entsteht. Der größte Bereich der Elektrodenmetallisierung hat also keinen direkten Kontakt zur Silizium-/Halbleiterkörperoberfläche. Auf diese Weise wird der Strom "gezwungen", direkt auf den segmentartigen Einschaltstrukturbereich zu fließen, welcher jetzt auch dem Bereich entspricht, der nicht von der zusätzlichen Isolatorschicht bedeckt ist. Auf diese Weise können die zusätzlichen Widerstandsbereiche auch weggelassen werden.

Mit dieser Isolatorschicht sind aber auch weitere Ausgestaltungen möglich, wie nachfolgend dargelegt wird.

Üblicherweise darf die Einschaltstruktur nicht von der Elektrodenmetallisierung bzw. der Kontaktscheibe radial nach innen hin überdeckt werden, da sonst der Einschaltstrom vom Gate-Kontakt G direkt über die Basiszone zum Elektrodenanschluss fließt, ohne dass die Einschaltstruktur einschaltet bzw. gezündet wird, da der Elektrodenkontakt die Einschaltstruktur in diesem Falle überbrücken bzw. kurzschließen würde. Das heißt, bei allen ohne Isolatorschicht ausgeführten Halbleiterbauelementen ragt die Einschaltstruktur unter dem Elektrodenkontakt radial nach innen hervor.

Mit der hierin beschriebenen zusätzlichen lokal aufgebrachten Isolatorschicht, vorzugsweise wird eine sehr dünne thermische Oxidschicht (z. B. SiO2) am Ende aller Hochtemperaturschritte zur Herstellung des Halbleiterkörpers erzeugt, die dann fotolithographisch strukturiert wird, kann der Elektrodenkontakt bzw. die Kontaktscheibe jetzt bis zur radial innen liegenden Innenkante der Einschaltstruktur gehen, ohne dass diese überbrückt wird. Damit liegt der Bereich der Vorzerstörung immer unter dem gedrückten Kontaktbereich. Diese Maßnahme stellt eine weitere Verbesserung dar. Ob sie am Ende erforderlich ist, hängt davon ab, ob das Hervorragen der Einschaltstruktur bzw. des Emitters radial nach innen unter dem Elektrodenkontakt zum Gatebereich hin sich kritisch auswirkt. Im schlechtesten Falle reicht die Emitterschicht zum Gate-Kontakt hin so weit unter dem Elektrodenkontakt hervor, dass es dort zu einer Vorzerstörung kommt und am Ende das Plasma zum Gatezuleitungskontakt nach außen gelangen kann (Druckwelle "bläst" zum Gatekontakt raus).

Wenn man die Isolatorschicht großflächig aufbringt bzw. nur an einer Stelle, an der die Einschaltstruktur zünden bzw. die Vorzerstörung erzeugt werden soll und anschließend der Fehler-Laststrom an dieser Stelle die Durchlegierung erzeugt, besteht dort zwischen der Metallisierung der jeweiligen Elektrode und der Halbleiteroberfläche - dieses ist entweder die Basiszone oder ein Teilgebiet der als Emitter ausgebildeten Einschaltstruktur - kein direkter elektrischer Kontaktübergang. Dies könnte zu einem Durchschlag zwischen der Isolatorschicht und der Metallisierung führen, da der Sperrstrom im Halbleiterkörper im isolierten Bereich einen weiten Weg bis zum nächsten direkt angekoppelten Kontaktbereich vorfindet. Dadurch treten in der Basiszone unterhalb der Isolatorschicht hohe transversale (laterale) Spannungen parallel zur Halbleiteroberfläche auf, die dann zum elektrischen Durchbruch führen können. Um dies zu vermeiden, sollte die Isolatorschicht in bestimmten Abständen die hierin beschriebenen Öffnungen oder Aussparungen aufweisen, ähnlich einer Kurzschlussstruktur in der großflächigen Einschaltstruktur. Dann kann der Sperrstrom bei anliegender Sperrspannung zum entsprechenden Elektrodenanschluss abfließen, ohne dass zu große elektrische Spannungen in der zugeordneten Basiszone auftreten. Das können ringförmige Aussparungen oder auch Kurzschlusslöcher sein, die jeweils von ausreichender Größe sein müssen, um die in der Basiszone unerwünschten lateralen Spannungsabfälle, verursacht durch den Sperrstrom, zu vermeiden. Ist die laterale Breite einer als Isolatorring ausgebildeten Isolatorschicht nicht zu breit, kann auf derartige Unterbrechungen auch verzichtet werden.

Ferner kann mit der zusätzlichen Isolatorschicht die laterale Lage der Einschaltstruktur beliebig weit von der Innenkante der die Basiszone kontaktierenden Elektrode zur Bauelementmitte weg bzw. nach außen verschoben werden. Das kann von Bedeutung sein, wenn die Gefahr besteht, dass bei einem Fehlerereignis mit einem Strom im 100 kA-Bereich die Durchlegierung sich in den nicht druckkontaktierten Bereich zum Gate-Anschluss hin ausdehnen kann (Gefahr des Ausblasens im Bereich der Gate-Drahtzuführung).

Die Ausbildung der Isolatorschicht durch ein thermisches Oxid, z. B. SiO2, hat den Vorteil, dass diese mit herkömmlichen Diffusionsprozessen ganz am Ende der Hochtemperaturschritte bzw. vor dem Abscheiden der Metallschichten erzeugt werden kann, nämlich durch eine thermische Oxidation in Sauerstoffatmosphäre bei hohen Temperaturen im Bereich von 800 °C - 900 °C. Falls dies aber für die Haftung der Metallisierung aus verschiedenen prozesstechnischen Gründen von Nachteil wäre, kann auch eine andere Isolatorschicht, z. B. Si3N4 (Siliziumnitrid) abgeschieden werden. Solche Isolatorschichten lassen sich auch mit geeigneten Prozessen wie LPCVD (Low-Pressure Chemical Vapour Deposition) bei Temperaturen weit unter 1000 °C aus der Gasphase abscheiden. Als Vorbehandlung zur Metallabscheidung kommen ätzchemische Materialien zur sicheren Entfernung der natürlichen Oxidschicht (liegt im Bereich von 20 nm bis 40 nm) auf der Si-Oberfläche zum Einsatz, z. B. eine gepufferte HF-Ätzmischung. Eine Nitridschicht ist im Gegensatz zu einem thermischen Oxid resistent gegenüber Ätzlösungen auf HF-Basis.

Wichtig für alle abgeschiedenen Isolatorschichten ist, dass deren Dicke im Vergleich zur Dicke der Metallschicht der Elektrode nicht zu groß gewählt ist, um eine Stufe an der Kante der Isolatorschicht zu vermeiden. Daher ist eine Isolatorschichtdicke im Bereich von 50 nm bis 100 nm zu wählen. Im Vergleich zur großen Dicke der Elektrodenmetallisierung, die im Bereich von typisch 10 µm bis 30 µm liegt, ist die Stufe am Übergang zur Isolatorschicht dann vernachlässigbar.

Die Isolatorschicht soll nur lokal aufgebracht werden, aber stets so, dass der elektrische Kontakt zwischen der leitfähigen Si-Oberfläche des Halbleiterkörpers und der Elektrodenmetallisierung zwar lokal sehr hochohmig bzw. ganz vermieden wird, aber es muss wie oben beschrieben immer einen (noch) ausreichenden direkten elektrischen Kontakt zwischen der Elektrode und der entsprechenden Basiszone geben.

Da eine wie vorstehend beschriebene als Zündstruktur oder Einschaltstruktur ausgebildete Durchbruchstruktur ihr Einschaltsignal aus der an den äußeren beiden Elektroden des Halbleiterkörpers anliegenden elektrischen Spannung bezieht und dem Kurzschluss-Halbleiterbauelement somit kein weiteres externes, zum Beispiel optisches oder elektrisches, Einschaltsignal zugeführt werden muss, sofern die Einschaltstruktur oder die einer Einschaltstruktur zugeordnete Zündstruktur lediglich als Durchbruchstruktur ausgebildet ist, kann zur Aufnahme des derart ausgebildeten Kurzschluss-Halbleiterbauelements in besonders vorteilhafter Weise ein Diodengehäuse verwendet werden, das keinen zusätzlichen Anschluss für ein zusätzliches externes Einschaltsignal aufweist. Besonders bevorzugt kann in einem solchen Fall die Durchbruchstruktur im Zentrum des Halbleiterkörpers angeordnet sein, wobei sich die vorder- und rückseitigen Elektroden vollständig über das Zentrum und damit über die Einschaltstruktur hinweg erstrecken können, da keine Aussparung zur Zuführung eines externen Einschaltsignals vorgesehen werden muss.

Gemäß einer weiteren vorteilhaften Ausgestaltung der Erfindung weist die Einschaltstruktur wenigstens einen sich vom Rest der Einschaltstruktur in lateraler Richtung radial nach außen erstreckenden Einschaltstrukturfinger auf (auch als Verfingerung der Einschaltstruktur bezeichnet). Mit anderen Worten steht der wenigstens eine Einschaltstrukturfinger vom Rest der Einschaltstruktur in radialer Richtung nach außen vor. Wie bereits weiter oben ausgeführt wurde, bestimmt sich das minimale Schmelzstromintegral, bei dem es zur Durchlegierung des Kurzschluss-Halbleiterbauelements kommen soll, im Wesentlichen durch die laterale Einschaltstrukturweite der jeweiligen Einschaltstruktur, zum Beispiel durch eine laterale Emitterstrukturweite einer Emitterstruktur oder durch eine laterale Durchbruchstrukturweite einer Durchbruchstruktur, und damit gleichbedeutend durch die bei der Aufschmelzung des Halbleiterkörpers wirksame Fläche der Einschaltstruktur. Mit anderen Worten hat ein gemäß der Erfindung angestrebtes kleines Verhältnis der lateralen Einschaltstrukturweite der entsprechenden Einschaltstruktur zur lateralen Elektrodenweite der zugehörigen Elektrode, die auf der die Einschaltstruktur aufweisenden Basiszone aufgebracht ist, einen gewünscht kleinen Aufschmelzstrom, bei dem es sicher zur Durchlegierung des Kurzschluss-Halbleiterbauelements kommt, zur Folge, so dass auch ein relativ kleiner von dem Kurzschluss-Halbleiterbauelement zwischen der vorderseitigen und rückseitigen Elektrode geführter Fehler- bzw. Kurzschlussstrom das Kurzschluss-Halbleiterbauelement in gewünschter Weise sicher durchlegiert und somit den nicht reversiblen, niederohmig stromführenden Zustand herstellt (kurzgeschlossener Betriebszustand).

Andererseits sollte die wirksame Fläche der Einschaltstruktur, zum Beispiel einer Emitterstruktur oder einer Durchbruchstruktur, und damit auch die gesamte Fläche des Halbleiterkörpers generell an die Höhe des von dem Kurzschluss-Halbleiterbauelement im Kurschlussfall dauerhaft aufzunehmenden Kurzschlussstromes angepasst sein um zu verhindern, dass bei einer zu kleinen Fläche der Einschaltstruktur der Schmelzvorgang gleich zu Beginn des Stromflusses explosionsartig einsetzt und dies zu einer mechanischen Zerstörung des gesamten Kurzschluss-Halbleiterbauelements führen und damit eine Gefährdung der Umgebung darstellen könnte. Eine größere Fläche der Einschaltstruktur kann sich günstig auf die Größe der lateralen Ausdehnung des durchlegierten Bereichs auswirken, wobei eine lateral weitere Ausdehnung des durchlegierten Bereichs aufgrund eines größer resultierenden Leitungsquerschnitts in vorteilhafter Weise eine Verringerung des elektrischen Widerstands des durch die Durchlegierung gebildeten Kurzschlussgebiets im Halbleiterkörper zur Folge hat. Die Verfingerung der Einschaltstruktur ermöglicht in vorteilhafter Weise einen Kompromiss zwischen den gegensätzlichen Forderungen nach einer möglichst kleinen Fläche der Einschaltstruktur zur Herabsenkung des für die sichere Durchlegierung erforderlichen Kurzschluss- bzw. Aufschmelzstroms und einer ausreichend großen Fläche zum sicheren Führen des Kurzschlussstroms, ohne eine mechanische Zerstörung des Kurzschluss-Halbleiterbauelements in Kauf nehmen zu müssen, denn bei der verfingerten Einschaltstruktur kann sich der durch das Einschaltsignal eingeschaltete, stromführende Bereich des Kurzschluss-Halbleiterbauelements über einen größeren Umfang verteilen.

Die Verfingerung der Einschaltstruktur hilft außerdem, den Aufschmelzbereich vom Zentrum des Kurzschluss-Halbleiterbauelements fernzuhalten. Dies ist insbesondere dann von besonderem Vorteil, wenn sich im Zentrum des Halbleiterkörpers eine Zündstruktur befindet, der ein externes Einschaltsignal (z. B. optisch oder elektrisch) zum Einschalten der Einschaltstruktur bzw. des Kurzschluss-Halbleiterbauelements zugeführt wird. In einem solchen Fall ist nämlich der Bereich, in dem das Einschaltsignal der Zündstruktur zugeführt wird, nicht von der den elektrischen Hauptanschluss für das Kurzschlusshalbleiterbauelement bereitstellenden Elektrode (z. B. Kathoden- oder Anodenelektrode) bedeckt, die auf der die Einschaltstruktur aufweisenden Basiszone aufgebracht ist, so dass Plasma beim Durchlegieren aus dem Bereich der unbedeckten Vorder- und/oder Rückseite des Halbleiterkörpers entweichen könnte und infolgedessen zu einer Beschädigung eines das Kurzschluss-Halbleiterbauelement umgebenden Gehäuses und damit zu einer Gefährdung der Umgebung führen könnte.

Eine weitere vorteilhafte Ausgestaltung der Erfindung sieht vor, dass bei Vorhandensein wenigstens einer Zündstruktur und einer wie vorstehend beschriebenen verfingerten Einschaltstruktur die Zündstruktur wenigstens einen der Kontur bzw. Form des wenigstens einen Einschaltstrukturfingers entsprechenden bzw. folgenden Zündstrukturfinger aufweist. Hierdurch kann ein über den gesamten Verlauf der verfingerten Einschaltstruktur gleichmäßiger Abstand, zum Beispiel in lateraler bzw. radialer Richtung und/oder in vertikaler Richtung, zwischen der Zündstruktur und der Einschaltstruktur gewährleistet werden, so dass die Zündstruktur gleichmäßig über den gesamten Verlauf der Einschaltstruktur auf diese im Sinne der vorliegenden Erfindung einwirken kann.

Gemäß einer weiteren bevorzugten Ausgestaltung der Erfindung weist der wenigstens eine Einschaltstrukturfinger eine maximale laterale, das heißt radiale, Fingerlänge auf, die kleiner ist als 4/5 der lateralen Elektrodenweite der Elektrode, die auf der die Einschaltstruktur aufweisenden Basiszone aufgebracht ist. Somit kann die maximale radiale Fingerlänge beispielsweise auch kleiner sein als 3/4, 2/3, 1/2, 1/3, 1/4, 1/5 der lateralen Elektrodenweite. Bei Vorhandensein einer ebenfalls verfingerten, der Verringerung der Einschaltstruktur entsprechenden bzw. folgenden Zündstruktur wie vorstehend beschrieben kann ebenso der wenigstens eine Zündstrukturfinger eine Fingerlänge aufweisen, die der Fingerlänge des jeweiligen Einschaltstrukturfingers entspricht.

Gemäß einer noch weiteren vorteilhaften Ausgestaltung der Erfindung ist eine Dicke der Innenzone in vertikaler Richtung größer als 400 µm, bevorzugter größer als 600 µm und noch bevorzugter größer als 800 µm oder 900 µm oder sogar 1000 µm. Generell ist festzustellen, dass der Gefahr eines Randausfalles des Kurzschluss-Halbleiterbauelements im Falle einer Überspannung durch eine im Vergleich zu einem herkömmlichen Thyristor deutlich dickere Innenzone des Halbleiterkörpers vorgebeugt werden kann. Es gibt praktisch keine maximale Dicke für diese Innenzone, wie das bei einem herkömmlichen Thyristor der Fall ist, da es für das erfindungsgemäße Kurzschluss-Halbleiterbauelement keine Leit- oder dynamischen Verluste gibt, die die Dicke der Innenzone nach oben begrenzen. So wäre für eine geforderte Spannungsklasse von zum Beispiel V_{DRM/}V_{RRM} = 2.2 kV ein herkömmlicher Thyristor mit einer Dicke Wₙ₁ im Bereich von etwa 320 µm und einem spezifischen Siliziumwiderstand von 85 Ω·cm einzusetzen. Für das Kurzschluss-Halbleiterbauelement der vorliegenden Erfindung kann hingegen zum Beispiel eine Dicke W, von etwa 850 µm gewählt werden. Mit einem spezifischen Widerstand von 270 Ω·cm ergäbe sich für die Halbleiterstruktur des erfindungsgemäßen Halbleiterkörpers mehr als die zweifache symmetrische Sperrfähigkeit (V_{DRM}/V_{RRM} = 5.2 kV). Selbst Sperrfähigkeiten > 10 kV (Mittelspannungsnetze) sind bei entsprechender Auslegung der Dicke der Innenzone möglich. Zusammen mit der entsprechenden Einstellung der Lebensdauer durch eine hohe Bestrahlungsdosis für die Elektronenbestrahlung kann der Sperrstrom sehr niedrig eingestellt werden. Damit kann das Sperrvermögen des Kurzschluss-Halbleiterbauelements sehr viel höher eingestellt werden als die bei der Verwendung des Kurzschluss-Halbleiterbauelements maximal vorkommende Überspannung, und dies ohne nachteilige Auswirkungen sowohl auf das Kurzschluss-Halbleiterbauelement als auch seine Anwendung. Ein möglichst kleiner Sperrstrom ist für das erfindungsgemäße Kurzschluss-Halbleiterbauelement deshalb von großem Vorteil, da dieses im Einsatz praktisch dauernd an Sperrspannung liegt und daher möglichst kleine Sperrströme erzielt und damit einhergehende Sperrverluste möglichst klein gehalten werden können, so dass das Kurzschluss-Halbleiterbauelement ohne aktive Kühlung betrieben werden kann. Das Auftreten eines Ausfalls im Randbereich des Kurzschluss-Halbleiterbauelements, der für den Gehäusebruchstrom kritisch ist, wird durch diese Maßnahme ebenfalls im Wesentlichen eliminiert.

Gemäß einer noch weiteren vorteilhaften Ausgestaltung der Erfindung sind die vorderseitige Elektrode und die rückseitige Elektrode jeweils mittels einer metallischen Kontaktscheibe elektrisch leitend druckkontaktiert. Hierbei kann die jeweilige Kontaktscheibe vorzugsweise dieselbe laterale Weite wie die entsprechende Elektrode aufweisen, so dass die Kontaktscheibe die entsprechende Elektrode vollständig überdeckt. Die Kontaktscheiben können fest, beispielsweise mittels einer Legierung, mit der entsprechenden Metallelektrode des Halbleiterkörpers verbunden sein oder nur lose auf diesen aufliegen. Die Kontaktscheiben können als reine Molybdänscheiben ausgebildet sein oder aus einer Kombination aus einer Molybdän- und Kupferscheibe bestehen, wobei sich vorzugsweise Molybdän in direktem Kontakt mit der Metallisierung des Halbleiterkörpers befindet. In vorteilhafter Weise stellt die vorliegende Erfindung, wie vorstehend beschrieben, sicher, dass sich das Gebiet der zwischen der vorderseitigen und rückseitigen Elektrode des Kurzschluss-Halbleiterbauelements im Kurzschlussfall erzeugten Durchlegierung stets im von den metallischen Kontaktscheiben druckkontaktierten Bereich des Kurzschluss-Halbleiterbauelements befindet.

Die Dicke der Molybdänscheibe bzw. der Kombination aus Molybdän und Kupfer liegt vorzugsweise zwischen 1 mm und 5 mm. Hierbei ist zu verstehen, dass die Dicke der Kontaktscheiben an die Höhe des durch das Kurzschluss-Halbleiterbauelement fließenden Kurzschlussstromes angepasst werden kann. Bei der Durchlegierung im Kurzschlussbetriebsfall verschmelzen das Silizium des Halbleiterkörpers und die Metallbereiche der Kontaktscheiben so miteinander, dass sich eine metallische Zone bildet. Die Dicke der Kontaktscheiben wird je nach Anwendungsfall bzw. Höhe des dauerhaft maximal zu leitenden Kurzschlussstromes so ausgelegt, dass die den jeweiligen Elektroden des Halbleiterkörpers abgewandten Seiten der Kontaktscheiben im Wesentlichen keine allzu starke mechanische Veränderung nach dem Auftreten der Aufschmelzungen zeigen. Insbesondere soll hierdurch ein eine elektrisch leitfähige, niederohmige und thermische Ankopplung sicherstellender Druckkontakt zwischen den die Metallisierungen des Halbleiterkörpers kontaktierenden Kontaktscheiben und jeweiligen Kontaktstempeln, zum Beispiel Kupferstempeln, eines das Kurzschluss-Halbleiterbauelement aufnehmenden Gehäuses, die mit einem ausreichenden Flächendruck gegen die Kontaktscheiben beaufschlagt sind, im Kurzschlussbetriebsfall des Kurzschluss-Halbleiterbauelements aufrechterhalten werden, so dass die Entstehung eines Lichtbogens außerhalb des von den Kontaktscheiben druckkontaktierten Bereichs nach dem Auslösen des Kurzschluss-Halbleiterbauelements sicher verhindert wird, Auf keinen Fall soll die Schmelzzone während der Durchlegierung durch die (Kupfer-)Kontaktstempel des Gehäuses nach außen dringen.

Es ist zu verstehen, dass die vorstehend beschriebenen unterschiedlichen Arten von Einschaltstrukturen innerhalb eines einzigen Kurzschluss-Halbleiterbauelements gemäß der Erfindung beliebig miteinander kombiniert werden können, insbesondere wenn mehr als eine Einschaltstruktur im Kurzschluss-Halbleiterbauelement vorgesehen ist. In sinngemäßer Weise sind auch die vorstehend beschriebenen unterschiedlichen Arten an Zündstrukturen beliebig miteinander in einem einzigen Kurzschluss-Halbleiterbauelement gemäß der Erfindung kombinierbar, wenn mehr als eine Zündstruktur im Kurzschluss-Halbleiterbauelement vorgesehen ist. Ebenso sind die vorstehend beschriebenen unterschiedlichen Arten an Zündstrukturen beliebig mit den unterschiedlichen Arten an Einschaltstrukturen kombinierbar.

So kann das erfindungsgemäße Kurzschluss-Halbleiterbauelement beispielsweise über ein oder mehrere elektrische Einschaltsignale einschaltbar sein, wobei dementsprechende Einschaltstrukturen im Halbleiterkörper vorgesehen werden. Die Einschaltsignale können dem Kurzschluss-Halbleiterbauelement lediglich einseitig, zum Beispiel auf der Vorderseite des Halbleiterkörpers, zugeführt werden, oder auch beidseitig, also auf der Vorder- und Rückseite des Halbleiterkörpers, wobei entsprechende Zündstrukturen an den jeweiligen Seiten des Halbleiterkörpers vorgesehen werden.

Weiterhin kann das erfindungsgemäße Kurzschluss-Halbleiterbauelement eine oder mehrere Durchbruchstrukturen als Zündstruktur oder Einschaltstruktur aufweisen, wobei mehrere vorhandene Durchbruchstrukturen für dieselben oder für jeweils unterschiedliche Durchbruchspannungen ausgelegt sein können.

Die als Zündstruktur dienenden Durchbruchstrukturen, zum Beispiel eine BOD-Struktur, aber auch eine einen du/dt-Schutz aufweisende Durchbruchstruktur sowie eine einen Freiwerdezeitschutz mit lokaler Anhebung der Ladungsträgerlebensdauer aufweisende Durchbruchstruktur, können innerhalb einer Amplifying-Gate-Struktur angeordnet sein, das heißt lateral zur vorder- bzw. rückseitigen Elektrode beabstandet und dementsprechend außerhalb eines von diesen Elektroden elektrisch kontaktierten Bereichs. Die Anordnung innerhalb einer Amplifying-Gate-Struktur ist jedoch nicht zwingend erforderlich. Die Durchbruchstrukturen, die sowohl als Zündstruktur als auch als Einschaltstruktur dienen, können ebenso vertikal unterhalb der vorder- bzw. rückseitigen Elektrode angeordnet sein, beispielsweise in der von der jeweiligen Elektrode elektrisch kontaktierten Basiszone.

Ferner lassen sich die hierin beschriebenen Zünd- und Einschaltstrukturen lediglich einseitig, das heißt in lediglich der vorderseitigen oder der rückseitigen Basiszone, oder auch beidseitig, also in beiden Basiszonen, des Halbleiterkörpers des erfindungsgemäßen Kurzschluss-Halbleiterbauelements vorsehen.

Zusammenfassend sind im Folgenden nochmals stichpunktartig die hierin verwendeten Begriffsdefinitionen dargelegt:
I. Einschaltstruktur:
   Struktur zum Erzeugen einer Durchlegierung im Halbleiterkörper des erfindungsgemäßen Kurzschluss-Halbleiterbauelements, um nach ihrem Einschalten bzw. ihrer Vorzerstörung einen elektrisch niederohmig leitenden Zustand (Kurzschluss) zwischen den mit dem Kurzschluss-Halbleiterbauelement elektrisch verbundenen, externen und von dem Halbleiterkörper im Normalbetriebsfall (Nicht-Kurzschlussfall) elektrisch voneinander getrennten elektrischen Hauptanschlüssen (Kathode/Anode) herzustellen.
   Mögliche Ausführungsform als:
      a. Emitterstruktur
      b. Durchbruchstruktur (z. B. in Form einer BOD-, du/dt-, Freiwerdezeitschutz-Struktur)
II. Einschaltsignal:
   Signal zum Einleiten des Einschaltens bzw. Vorzerstörens einer Einschaltstruktur.
   Mögliche Ausführungsform als:
      a. Separates, dem erfindungsgemäßen Kurzschluss-Halbleiterkörper extern zugeführtes elektrisches Signal
      b. An den elektrischen Hauptanschlüssen (Kathode/Anode) des erfindungsgemäßen Kurzschluss-Halbleiterbauelements anliegende elektrische Spannung/Betriebsspannung
III. Einschaltstrom:
   Ein aus dem Einschaltsignal gewonnener, einer als Emitterstruktur ausgebildeten Einschaltstruktur zugeführter Strom, um diese zu zünden bzw. einzuschalten.
IV. Aufschmelzstrom:
   Ein eine Durchlegierung im Halbleiterkörper herbeiführender Strom.
V. Zündstruktur:
   Optionale Hilfsstruktur zum Weiterleiten des der Hilfsstruktur stets zugeführten Einschaltsignals an eine Einschaltstruktur.
   Mögliche Ausführungsform als:
      a. Gate-Elektrode - Zugeführtes Einschaltsignal: II.a
      b. Durchbruchstruktur (z. B. in Form einer BOD-, du/dt-, Freiwerdezeitschutz-Struktur) - Zugeführtes Einschaltsignal: II.b

Weitere Merkmale und Vorteile der Erfindung ergeben sich aus der folgenden Beschreibung nicht einschränkend zu verstehender Ausführungsbeispiele der Erfindung, die im Folgenden unter Bezugnahme auf die Zeichnung näher erläutert wird. In dieser Zeichnung zeigen schematisch:
- Fig. 1: einen Vertikalschnitt durch einen Thyristor nach dem Stand der Technik,
- Fig. 2: einen Vertikalschnitt durch ein Ausführungsbeispiel eines Kurzschluss-Halbleiterbauelements gemäß der Erfindung mit einer Einschaltstruktur und einer Zündstruktur,
- Fig. 3: eine Draufsicht auf ein weiteres Ausführungsbeispiel eines Kurzschluss-Halbleiterbauelements gemäß der Erfindung mit einer verfingerten Einschaltstruktur,
- Fig. 4: einen Vertikalschnitt durch ein weiteres Ausführungsbeispiel eines Kurzschluss-Halbleiterbauelements gemäß der Erfindung mit zwei Einschaltstrukturen und einer Zündstruktur,
- Fig. 5: einen Vertikalschnitt durch ein noch weiteres Ausführungsbeispiel eines Kurzschluss-Halbleiterbauelements gemäß der Erfindung mit zwei Einschaltstrukturen und zwei Zündstrukturen,
- Fig. 6: einen Vertikalschnitt durch ein noch weiteres Ausführungsbeispiel eines Kurzschluss-Halbleiterbauelements gemäß der Erfindung mit einer Einschaltstruktur und einer Zündstruktur,
- Fig. 7: einen Vertikalschnitt durch ein weiteres Ausführungsbeispiel eines Kurzschluss-Halbleiterbauelements gemäß der Erfindung mit zwei Einschaltstrukturen und zwei Zündstrukturen,
- Fig. 8: zwei Schaltbilder jeweils eines Ausführungsbeispiels einer Verschaltung des Kurzschluss-Halbleiterbauelements aus Fig. 2,
- Fig. 9: einen Vertikalschnitt durch ein noch weiteres Ausführungsbeispiel eines Kurzschluss-Halbleiterbauelements gemäß der Erfindung mit zwei Einschaltstrukturen und zwei Zündstrukturen,
- Fig. 10: einen Vertikalschnitt durch ein weiteres Ausführungsbeispiel eines Kurzschluss-Halbleiterbauelements gemäß der Erfindung mit zwei Einschaltstrukturen und einer Zündstruktur,
- Fig. 11: in den Ansichten (a), (b) und (c) jeweils einen Konzentrationsverlauf durch das Kurzschluss-Halbleiterbauelement aus Fig. 10 entlang der dort gezeigten Konzentrationsverlaufslinien Na, Nb bzw. Nc,
- Fig. 12: einen Vertikalschnitt durch ein weiteres Ausführungsbeispiel eines Kurzschluss-Halbleiterbauelements gemäß der Erfindung mit zwei Einschaltstrukturen und zwei Zündstrukturen,
- Fig. 13: eine Teildraufsicht auf ein noch weiteres Ausführungsbeispiel eines Kurzschluss-Halbleiterbauelements gemäß der Erfindung mit einer in einer Umfangsrichtung des Halbleiterkörpers offenen, ein Einschaltstruktursegment aufweisenden Einschaltstruktur und einer Zündstruktur,
- Fig. 14: eine Teildraufsicht auf ein noch weiteres Ausführungsbeispiel eines Kurzschluss-Halbleiterbauelements gemäß der Erfindung mit einer in einer Umfangsrichtung des Halbleiterkörpers offenen, ein Einschaltstruktursegment aufweisenden Einschaltstruktur und einer Zündstruktur,
- Fig. 15: einen Vertikalschnitt durch das Kurzschluss-Halbleiterbauelement aus Fig. 14 entlang der Schnittlinie X-X dar,
- Fig. 16: eine Teildraufsicht auf ein noch weiteres Ausführungsbeispiel eines Kurzschluss-Halbleiterbauelements gemäß der Erfindung mit einer in einer Umfangsrichtung des Halbleiterkörpers offenen, ein Einschaltstruktursegment aufweisenden Einschaltstruktur und einer Zündstruktur,
- Fig. 17: eine Teildraufsicht auf ein noch weiteres Ausführungsbeispiel eines Kurzschluss-Halbleiterbauelements gemäß der Erfindung mit einer in einer Umfangsrichtung des Halbleiterkörpers offenen, ein Einschaltstruktursegment aufweisenden Einschaltstruktur und einer Zündstruktur,
- Fig. 18: einen Vertikalschnitt durch das Kurzschluss-Halbleiterbauelement aus Fig. 17 entlang der Schnittlinie Y-Y dar,

In den unterschiedlichen Figuren sind hinsichtlich ihrer Funktion gleichwertige Teile stets mit denselben Bezugszeichen versehen, so dass diese in der Regel auch nur einmal beschrieben werden.

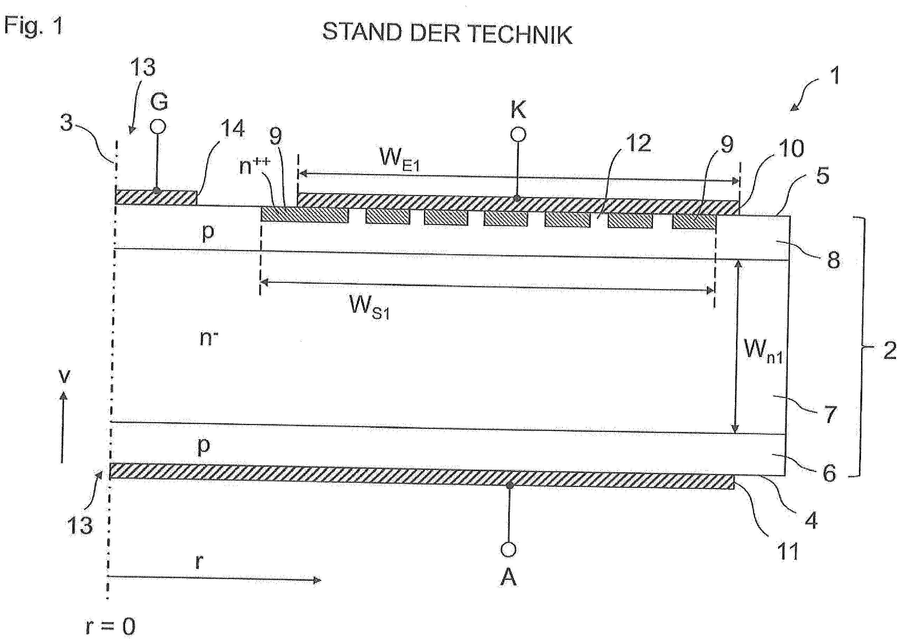

Fig. 1 stellt einen Vertikalschnitt durch einen Thyristor 1 nach dem Stand der Technik dar. Der Thyristor 1 weist einen Halbleiterkörper 2 auf, der im Wesentlichen die Gestalt eines sehr flachen Zylinders aufweist, dessen Grundflächen senkrecht zu einer vertikalen Richtung v verlaufen. Jede Richtung senkrecht zur vertikalen Richtung v wird hierin als radiale oder laterale Richtung bezeichnet, wobei in Fig. 1 die laterale Richtung mit dem Bezugszeichen r dargestellt ist.

Der Halbleiterkörper 2 ist aus einem Halbleitermaterial, zum Beispiel Silizium, gebildet und weist p- und n-leitend dotierte Halbleiterzonen auf, welche die elektrischen Eigenschaften des Thyristors in an sich bekannter Weise festlegen. Der Thyristor 1 und/oder der Halbleiterkörper 2 sind rotationssymmetrisch bezüglich einer in der vertikalen Richtung v verlaufenden Mittelachse 3 ausgebildet.

In dem Halbleiterkörper 2 des dargestellten Thyristors 1 nach dem Stand der Technik sind in der vertikalen Richtung v ausgehend von einer Rückseite 4 hin zu einer der Rückseite 4 gegenüberliegenden Vorderseite 5 eine p-dotierte rückseitige Basiszone 6, eine n-dotierte Innenzone 7 und eine p-dotierte vorderseitige Basiszone 8 aufeinanderfolgend angeordnet.

Angrenzend an die Vorderseite 5 des Halbleiterkörpers 2 ist in die p-dotierte vorderseitige Basiszone 8 ein n-dotierter vorderseitiger Emitter 9 eingebettet, wobei der vorderseitige Emitter 9 eine durch seine laterale Erstreckung gegebene gesamte laterale Emitterweite W_{S1} aufweist. Als laterale Gesamtstrukturweite des Emitters 9 ist hierin der Abstand einer die gezeigte Emitterstruktur 9 radial am weitesten nach innen begrenzenden Innenseite zu einer die gezeigte Emitterstruktur 9 radial am weitesten nach außen begrenzenden Außenseite zu verstehen. Der Emitter 9 weist bei dem in Fig. 1 dargestellten herkömmlichen Thyristor 1 eine die Mittelachse 3 konzentrisch umschließende, umfänglich geschlossene Ringstruktur auf, wobei der Halbleiterkörper 2 bzw. der Thyristor 1 im Wesentlichen als zur Mittelachse 3 rotationssymmetrischer Zylinder ausgebildet ist.

Des Weiteren ist Fig. 1 zu entnehmen, dass der n-dotierte vorderseitige Emitter 9 mit einer auf der Vorderseite 5 aufgebrachten Metallisierungsschicht 10 (zum Beispiel Aluminium) elektrisch leitend verbunden ist, die eine vorderseitige Elektrode 10 des Thyristors 1 bildet, wobei die vorderseitige Elektrode 10 bei dem gezeigten Beispiel des herkömmlichen Thyristors 1 auch als Kathodenelektrode bezeichnet werden kann, die einen Kathodenanschluss K aufweist. Die vorderseitige Elektrode 10 weist eine durch ihre laterale Erstreckung gegebene gesamte laterale vorderseitige Elektrodenweite W_{E1} auf. Die p-dotierte rückseitige Basiszone 6 ist mit einer auf der Rückseite 4 aufgebrachten Metallisierungsschicht 11 (zum Beispiel Aluminium) elektrisch leitend verbunden, die eine rückseitige Elektrode 11 des Thyristors 1 bildet, wobei die rückseitige Elektrode 11 bei dem gezeigten Beispiel des herkömmlichen Thyristors 1 auch als Anodenelektrode bezeichnet werden kann, die einen Anodenanschluss A aufweist.

Wie in Fig. 1 außerdem zu erkennen ist, ist der n-dotierte vorderseitige Emitter 9 in allgemein bekannter Weise von säulenartig ausgebildeten, komplementär zum vorderseitigen Emitter 9 dotierten Kurzschlüssen 12 (auch als Kathodenkurzschluss bezeichnet) durchsetzt, die die p-dotierte vorderseitige Basiszone 8 elektrisch direkt an die vorderseitige Elektrode 10 anschließen.

Des Weiteren ist Fig. 1 zu entnehmen, dass der Thyristor 1 in einem durch den geometrischen Schwerpunkt der Vorderseite 5 festgelegten Zentrum 13 (r = 0) des Halbleiterkörpers 2 eine Zündstruktur in Form einer Gate-Elektrode 14 aufweist, durch die in Abhängigkeit von einem elektrischen Zünd- oder Einschaltsignal (Gate-Strom) eine elektrisch leitende, niederohmige Verbindung zwischen der vorderseitigen Elektrode 10 (hier: Kathode) und der rückseitigen Elektrode 11 (hier: Anode) in allgemein bekannter Weise herstellbar ist. Übrigens ist auch durch den geometrischen Schwerpunkt der Rückseite 4 des Halbleiterkörpers 2 ein Zentrum 13 festgelegt, das aufgrund des symmetrischen Aufbaus des Halbleiterkörpers 2 mit der lateralen Lage des vorderseitigen Zentrums 13 übereinstimmt, weswegen die beiden Zentren mit demselben Bezugszeichen 13 versehen sind. Die beiden Zentren 13 legen den Verlauf der Mittelachse 3 (auch Symmetrieachse) fest.

Liegt zum Beispiel zwischen der rückseitigen Elektrode 11 und der vorderseitigen Elektrode 10 ein positives Potential, wird die in Blockierrichtung (U_{D}) sperrende npnp-Struktur des Thyristors 1 durch den Gate-Strom (positive Stromrichtung von Gate 14 zur vorderseitigen Elektrode 10) gezündet bzw. eingeschaltet. Das Stromplasma breitet sich beim Einschalten ausgehend von der dem Zentrum 13 zugewandten Seite des n-hochdotierten vorderseitigen Emitters 9 mit einer Geschwindigkeit von etwa 0,1 mm/µs radial bzw. lateral nach außen über den ganzen vorderseitigen Elektrodenbereich W_{E1} aus, bis je nach Durchmesser des Thyristors 1 der ganze vorderseitige Elektrodenbereich W_{E1} nach ca. 1 bis 4 ms den Strom führt und zwischen vorderseitiger Elektrode (Kathode) 10 und rückseitiger Elektrode (Anode) 11 ein hoher Laststrom fließt. Dann nimmt die anliegende Durchlassspannung im Leitzustand des Thyristors 1 ihren kleinsten Wert an. Erst wenn der durch den Thyristor 1 fließende Strom wieder einen Nullwert erreicht, "erlischt" er und wechselt in den Sperrzustand (U_{R} bzw. negatives Potential zwischen rückseitiger Elektrode 11 und vorderseitiger Elektrode 10). Zwischen diesen beiden Zuständen ist eine wie in Fig. 1 gezeigte intakte, herkömmliche Thyristorstruktur beliebig oft schaltbar.

Die Sperr- bzw. Blockierspannung des Thyristors 1 ergibt sich aus der minimalen Dicke Wₙ₁ und dem spezifischen Widerstand ρ der n-dotierten Innenzone 7, während seine minimale Fläche des n-dotierten vorderseitigen Emitters 9 die Höhe des zulässigen Stoßstromes und die Durchlassverluste (Leitverluste) festlegt. Die Dicke Wₙ₁ ist dabei nicht beliebig groß wählbar, um zum Beispiel die Sperrfähigkeit zu erhöhen, da dies den Stoßstrom und die Leitverluste negativ beeinflusst. Die Fläche des Emitters 9 und die Siliziumdicke Wₙ₁ sind dementsprechend genau auf die jeweilige Anwendung des herkömmlichen Thyristors 1 zugeschnitten.

Wie Fig. 1 weiter zu entnehmen ist, ist die laterale Weite W_{S1} des vorderseitigen Emitters 9 im Wesentlichen gleich der lateralen Weite W_{E1} der vorderseitigen Elektrode 10. Somit ist das Verhältnis der lateralen vorderseitigen Emitterweite W_{S1} zur lateralen vorderseitigen Elektrodenweite W_{E1} bei dem herkömmlichen Thyristor 1 im Wesentlichen gleich 1 oder sogar noch etwas größer als 1.

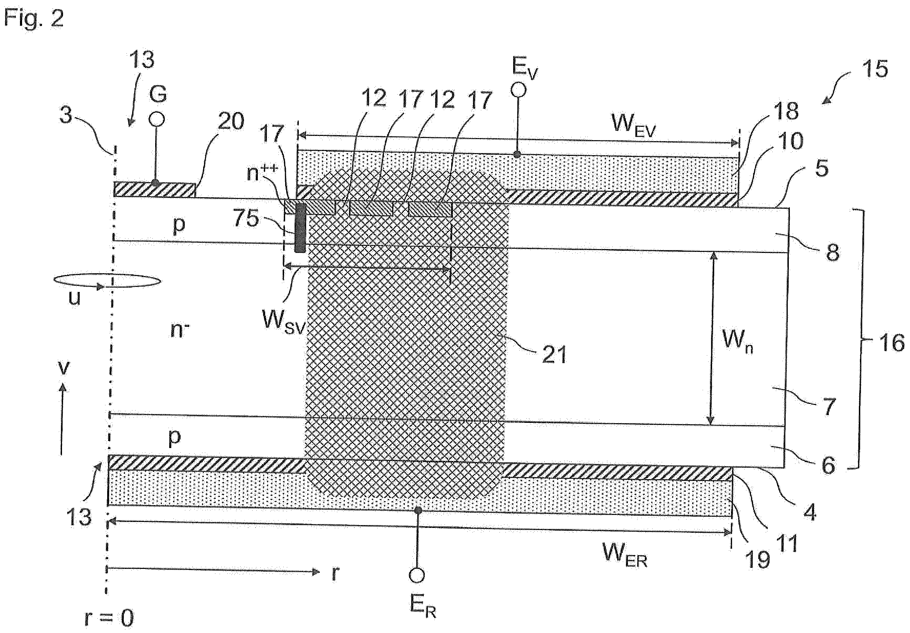

Fig. 2 stellt einen Vertikalschnitt durch ein Ausführungsbeispiel eines Kurzschluss-Halbleiterbauelements 15 gemäß der Erfindung dar. Das Kurzschluss-Halbleiterbauelement 15 weist einen Halbleiterkörper 16 auf, in dem in ähnlicher Weise wie beim in Fig. 1 dargestellten herkömmlichen Thyristor 1 in der vertikalen Richtung v ausgehend von der Rückseite 4 hin zu der der Rückseite 4 gegenüberliegenden Vorderseite 5 eine p-dotierte rückseitige Basiszone 6, eine n-dotierte Innenzone 7 und eine p-dotierte vorderseitige Basiszone 8 aufeinanderfolgend angeordnet sind.

Wie Fig. 2 zu entnehmen ist, ist die rückseitige Basiszone 6 mit der auf der Rückseite 4 aufgebrachten rückseitigen Elektrode 11 mit einer durch ihre laterale Erstreckung gegebenen gesamten lateralen rückseitigen Elektrodenweite W_{ER} elektrisch leitend verbunden und die vorderseitige Basiszone 8 mit der auf der Vorderseite 5 aufgebrachten vorderseitigen Elektrode 10 mit einer durch ihre laterale Erstreckung gegebenen gesamten lateralen vorderseitigen Elektrodenweite W_{EV} elektrisch leitend verbunden.

Angrenzend an die Vorderseite 5 des Halbleiterkörpers 16 ist in die p-dotierte vorderseitige Basiszone 8 eine vorderseitige Einschaltstruktur 17 mit einer durch ihre laterale Erstreckung gegebenen lateralen vorderseitigen Einschaltstrukturweite W_{SV} eingebettet. Die vorderseitige Einschaltstruktur 17 ist bei dem in Fig. 2 gezeigten Ausführungsbeispiel als n-dotierte vorderseitige Emitterstruktur 17 ausgebildet, die beispielsweise als umfänglich geschlossene Ring- und/oder Polygonstruktur ausgebildet sein kann. Wie in Fig. 2 zu erkennen ist, ist die Emitterstruktur 17 mit der auf der Vorderseite 5 aufgebrachten Metallisierungsschicht 10 (zum Beispiel Aluminium) elektrisch leitend verbunden. Wie weiter zu erkennen ist, überdeckt die vorderseitige Elektrode 10 die vorderseitige Emitterstruktur 17 wenigstens teilweise. Insbesondere ist in Fig. 2 zumindest größenordnungsmäßig dargestellt, dass die Überdeckung der Einschaltstruktur 17 von der vorderseitigen Elektrode 10 im äußeren Randbereich, das heißt in Richtung zum radialen Außenrand des Kurzschluss-Halbleiterbauelements 15 (r > 0), wenigstens im Millimeter-Bereich liegt, z. B. wenigstens etwa 1 mm bis 5 mm oder auch noch größer. Wie in Fig. 2 dargestellt ist, ragt die Emitterstruktur 17 an der radialen, dem Zentrum 13 zugewandten Innenseite der Metallisierungsschicht 10 etwas über diese hinaus. Die n-dotierte vorderseitige Emitterstruktur 17 ist bei dem in Fig. 2 gezeigten Ausführungsbeispiel ebenfalls von den säulenartig ausgebildeten, komplementär zur Emitterstruktur 17 dotierten Kurzschlüssen 12 durchsetzt, die die p-dotierte vorderseitige Basiszone 8 elektrisch an die vorderseitige Elektrode 10 anschließen.

Die Form der Kurzschlüsse 12 kann variieren, je nach Stärke der gewünschten Kurzschlusswirkung. Üblich sind kreisrunde oder mehreckige, zum Beispiel sechseckige, kleine punktuelle Aussparungen innerhalb der durch die laterale vorderseitige Emitterstrukturweite W_{SV} festgelegten, zusammenhängenden Emitterstrukturfläche der gesamten Emitterstruktur 17, wobei die Kurzschlüsse 12 Abmessungen in der Größenordnung von etwa 100 µm aufweisen können. Es sind jedoch auch andere Formen derartiger Kurzschlüsse 12 möglich, zum Beispiel streifenartige Unterbrechungen oder ringförmige Unterbrechungen, die die Emitterstruktur 17 in einzelne, konzentrische Ringe trennen. Die Breite solcher Unterbrechungen liegt typischerweise im Bereich von etwa 100 µm.

Im Vergleich zum in Fig. 1 dargestellten herkömmlichen Thyristor 1 kann bei dem erfindungsgemäßen Kurzschluss-Halbleiterbauelement 15 die Kurzschlusswirkung der Kurzschlüsse 12 durch eine gezielte Ausgestaltung auch sehr stark erhöht werden, indem die Kurzschlussöffnungen der Kurzschlüsse 12 beispielsweise deutlich größer ausgebildet sind als bei dem in Fig. 1 gezeigten herkömmlichen Thyristor 1 und/oder die Dichte der Kurzschlüsse 12 bezogen auf die Emitterstrukturfläche der Emitterstruktur 17 deutlich höher gewählt ist, das heißt der Abstand benachbarter Kurzschlüsse 12 zueinander deutlich geringer gewählt ist, als bei dem herkömmlichen Thyristor 1. Hierdurch lässt sich der flächenspezifische Stoßstrom in kA/cm² bei dem erfindungsgemäßen Kurzschluss-Halbleiterbauelement 15 noch weiter verringern (im Gegensatz zum herkömmlichen Thyristor 1, bei dem der Stoßstrom bekanntlich stets maximiert wird), um die wie hierin beschriebene Durchlegierung des Halbleiterkörpers 16 im Kurzschlussfall sicher zu gewährleisten.

Die auf die vorbeschriebene Weise angeordneten zwei pn- bzw. np-Übergänge im Halbleiterkörper 16 erzeugen ein in beiden Spannungspolaritäten sperrendes Kurzschluss-Halbleiterbauelement 15.

Ein Unterschied des in Fig. 2 dargestellten Kurzschluss-Halbleiterbauelements 15 zum in Fig. 1 gezeigten herkömmlichen Thyristor 1 ist das Verhältnis der lateralen Einschalt- bzw. Emitterstrukturweite W_{SV} zur lateralen Elektrodenweite W_{EV}, das bei dem Kurzschluss-Halbleiterbauelement 15 deutlich kleiner 1 ist und bevorzugt kleiner 1/2 oder noch kleiner gewählt werden kann, was jedoch nicht zwingend erforderlich ist.

Ferner ist Fig. 2 zu entnehmen, dass die vorderseitige Elektrode 10 und die rückseitige Elektrode 11 jeweils mittels einer metallischen vorderseitigen und rückseitigen Kontaktscheibe 18 bzw. 19 elektrisch leitend kontaktiert, insbesondere druckkontaktiert, sind. Die Kontaktscheiben 18 und 19 können als reine Molybdänscheiben ausgebildet sein oder aus einer Kombination aus einer Molybdän- und Kupferscheibe bestehen, wobei sich bevorzugt Molybdän in direktem Kontakt mit der jeweiligen Elektrode 10 bzw. 11 des Halbleiterkörpers 16 befindet. Die Dicke der Kontaktscheiben 18 und 19 liegt vorzugsweise zwischen 1 und 5 mm.

Des Weiteren ist in Fig. 2 eine als Gate-Elektrode 20 ausgebildete vorderseitige Zündstruktur 20 des Kurzschluss-Halbleiterbauelements 15 zu erkennen, die die vorderseitige Basiszone 8 elektrisch leitend kontaktiert und in Abhängigkeit von einem der Gate-Elektrode 20 über ihren Gate-Anschluss G zugeführten elektrischen Einschaltsignal aktivierbar ist und infolgedessen die vorderseitige Einschalt- bzw. Emitterstruktur 17 einschalten bzw. vorzerstören kann, die über die vorderseitige Basiszone 8 elektrisch mit der Gate-Elektrode 20 wirkverbunden ist. Nach dem Einschalten/Vorzerstören der Einschalt- bzw. Emitterstruktur 17 stellt diese einmalig eine dauerhafte, irreversible, elektrisch leitende, niederohmige Verbindung zwischen der vorderseitigen Elektrode 10 und der rückseitigen Elektrode 11 her. Die Gate-Elektrode 20 wird im Betrieb über einen mittels Federwirkung angedrückten elektrisch leitenden Draht (nicht dargestellt) kontaktiert.

Wie bereits weiter oben erwähnt wurde und in Fig. 2 zu erkennen ist, ragt die Emitterstruktur 17 an der radialen, dem Zentrum 13 zugewandten Innenseite der Metallisierungsschicht 10 etwas über diese hinaus. Dies ist hier erforderlich, um die Emitterstruktur 17 nicht kurzzuschließen. Bei einem derartigen Kurzschluss würde der Strom des über die Zündstruktur bzw. Gate-Elektrode 20 zugeführten Einschaltsignals direkt von dieser zur Elektrode 10 fließen können, was jedoch die gewünschte Funktion der Einschalt- bzw. Emitterstruktur 17 zumindest teilweise negativ beeinträchtigen könnte.

Des Weiteren ist das Kurzschluss-Halbleiterbauelement 15 im Betrieb gewöhnlich in einer als Gehäuse ausgebildeten hermetisch dichten Keramikkapsel (nicht dargestellt) oder Kunststoffkapsel aufgenommen. Für die Zuführung des externen elektrischen Einschalt- bzw. Gate-Signals ist ein Metallrohr in der Keramik-/Kunststoffkapsel angebracht, das mit dem metallisierten Gate-Bereich 20 über den Draht zur Einkopplung des externen Einschaltsignals verbunden ist. Das Keramik-/Kunststoffgehäuse weist ferner zwei Kupferkontaktstempel auf, die auf beiden Seiten des Kurzschluss-Halbleiterbauelements 15 direkt auf den Kontaktscheiben 18 bzw. 19 der vorderseitigen Elektrode 10 bzw. rückseitigen Elektrode 11 aufliegen. Die elektrische Verbindung dieses in der Keramik-/Kunststoffkapsel befindlichen Kurzschluss-Halbleiterbauelements 15 nach außen geschieht über einen entsprechenden mechanischen Druckverbund, welcher die beiden Kupferkontaktstempel mit einem ausreichenden Flächendruck zusammenpresst, während zur Ansteuerung mittels des Einschaltsignals das in der Keramik-/Kunststoffkapsel befindliche Metallrohr außerhalb der Kapsel über eine geeignete Steckverbindung oder feste Lötung mit einer elektrischen Leitung verbunden ist.

Die Hauptfunktion des erfindungsgemäßen Kurzschluss-Halbleiterbauelements 15 besteht nun darin, dass bei einem einzigen Impuls des Einschalt- bzw. Gate-Signals mit ausreichender Stromhöhe, das heißt bei Aktivierung der Zündstruktur mittels des Einschaltsignals, ein vordefinierter Energieeintrag in den Halbleiterkörper zwischen die Zündstruktur und die vorderseitige Einschaltstruktur injiziert wird und hierdurch ein zwischen der jeweiligen Einschaltstruktur und diese einbettenden Basiszone gebildeter erster Halbleiterübergang, vorliegend zwischen dem n-Emitter und der p-Basiszone, und/oder ein zwischen dieser Basiszone und der Innenzone gebildeter zweiter Halbleiterübergang irreversibel zerstört wird, was in Fig. 2 durch einen eingezeichneten Vorzerstörungsbereich 75 dargestellt ist. Anschließend wird der Halbleiterkörper 16 durch den über die Elektrodenanschlüsse E_{V} und E_{R} fließenden Fehlerstrom derart zerstört, dass sich in der Umgebung des initial gezündeten Bereichs des Halbleiterkörpers 16 eine Aufschmelzung bzw. Durchlegierung 21 bildet, deren Größe bzw. radiale/laterale Ausdehnung u. a. auch von der Größe des zwischen den Anschlüssen Ev und E_{R} fließenden Kurzschlussstroms abhängt. Nach dem Erkalten der Schmelze bildet sich eine metallische Zone, die sich aus dem geschmolzenen Silizium des Halbleiterkörpers 16 und dem Metall der Kontaktscheiben 18 bzw. 19 zusammensetzt und eine dauerhaft sicher leitende, niederohmige elektrische Verbindung (Kurzschluss) zwischen den beiden Hauptanschlüssen E_{V} und E_{R} bereitstellt. Die Höhe des Aufschmelzstroms wird bestimmt durch eine nach dem dauerhaft aufzunehmenden Kurzschlussstrom auszulegende maximale Fläche für die n-dotierte vorderseitige Emitterstruktur 17, wobei für kleine Aufschmelzströme ein möglichst kleines Verhältnis W_{SV}/W_{EV} angestrebt wird und die laterale Weite W_{EV} der Metallkontaktscheibe 18 bzw. der vorderseitigen Elektrode 10 nach der Höhe des Kurzschlussstroms derart festgelegt wird, dass die räumliche Ausdehnung der durchlegierten Zone 21 nicht in einen äußeren Randbereich des Kurzschluss-Halbleiterbauelements 15 gelangt. Um weiterhin auch einen durch eine mögliche Überspannung hervorgerufenen Randausfall zu vermeiden, kann die Dicke Wₙ der die Sperrfähigkeit des Kurzschluss-Halbleiterbauelements 15 bestimmenden n-dotierten Innenzone 7 nahezu beliebig groß gewählt werden, wobei zusätzlich der spezifische Widerstand der Innenzone 7 an die gewünschte Höhe der Sperrfähigkeit entsprechend angepasst wird.

Im Störfall wird also bei dem in Fig. 2 dargestellten Kurzschluss-Bauelement 15 einmalig ein elektrisches Einschaltsignal erzeugt, das über die elektrische Zuführung zum Gate-Anschluss G auf die Gate-Elektrode 20 im Zentrum 13 des Halbleiterkörpers 16 gegeben wird. Infolgedessen wird die npnp-Struktur 75 des Halbleiterkörpers 16 vorzerstört, woraufhin es zum Stromfluss zwischen der vorderseitigen Elektrode 10 und der rückseitigen Elektrode 11 kommt, der zur Aufschmelzung 21 im stromführenden Bereich des Halbleiterkörpers 16 führt. Danach befindet sich das Kurzschluss-Halbleiterbauelement 15 in einem permanenten, nicht reversiblen, niederohmig stromführenden Zustand.

Die Stromtragfähigkeit der n-dotierten vorderseitigen Emitterstruktur 17 ist gegenüber dem n-dotierten kathodenseitigen Emitter 9 des in Fig. 1 dargestellten herkömmlichen Thyristors 1 sehr stark begrenzt, denn sie ist durch das Verhältnis der lateralen Emitterstrukturweite W_{SV} der n-dotierten vorderseitigen Emitterstruktur 17 zur Gesamtweite W_{EV} der durch die Metallisierung bzw. vorderseitigen Elektrode 10 und der Kontaktscheibe 18 kontaktierten Fläche bestimmt.

Die Lage der n-dotierten vorderseitigen Emitterstruktur 17 nahe dem Zentrum 13 des Halbleiterkörpers 16 hält den durchlegierten Bereich 21 in der Nähe der Initialzündung und verhindert, dass das Plasma den durch die vorderseitige Elektrode 10 und die Kontaktscheibe 18 kontaktierten Bereich des Halbleiterkörpers 16 verlassen und in den radial äußeren Randbereich gelangen kann. Der Aufbau des in Fig. 2 gezeigten Ausführungsbeispiels des Kurzschluss-Halbleiterbauelements 15 stellt also sicher, dass die Durchlegierung 21 stets innerhalb des von der Elektrode 10 und der Kontaktscheibe 18 überdeckten Bereichs, das heißt innerhalb der Elektrodenweite W_{EV}, verbleibt.

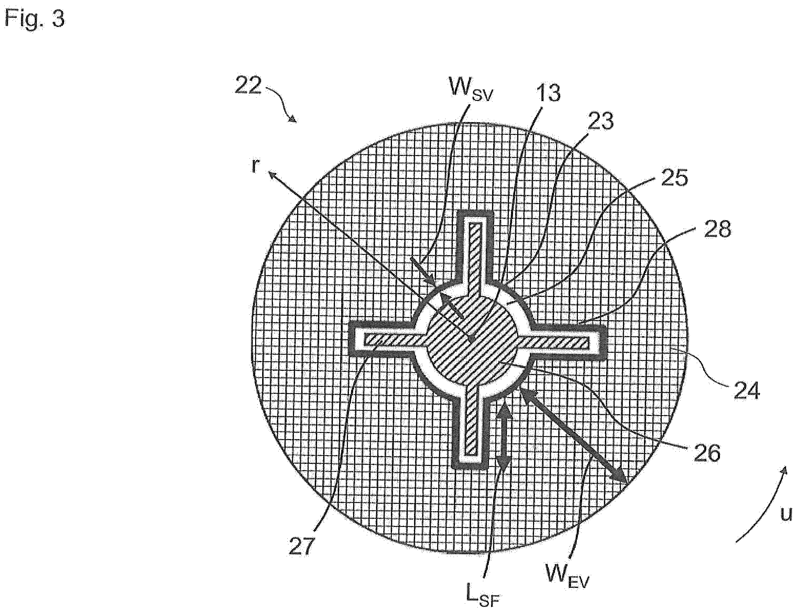

Fig. 3 stellt eine Draufsicht auf ein weiteres Ausführungsbeispiel eines Kurzschluss-Halbleiterbauelements 22 gemäß der Erfindung mit einer verfingerten Einschaltstruktur 23 dar. In Fig. 3 ist eine vorderseitige Elektrode 24 zu erkennen, die auf der Vorderseite eines Halbleiterkörpers 25 mit erfindungsgemäßem Aufbau aufgebracht ist. Im Zentrum 13 des Kurzschluss-Halbleiterbauelements 22 ist eine als Zündstruktur ausgebildete Gate-Elektrode 26 auf den Halbleiterkörper 25 aufgebracht, die, wie in Fig. 3 zu erkennen ist, von der vorderseitigen Elektrode 24 radial beabstandet ist. Wie Fig. 3 weiter zu entnehmen ist, weist die Gate-Elektrode 26 bei dem gezeigten Kurzschluss-Halbleiterbauelement 22 vier sich vom Rest, das heißt vom zentralen Bereich, der Gate-Elektrode 26 radial nach außen erstreckende Zündstruktur- bzw. Gate-Finger 27 auf. Die vorderseitige Elektrode 24 weist den Gate-Fingern 27 entsprechende Ausnehmungen auf, damit sich die Gate-Finger 27 beabstandet zur Elektrode 24 radial nach außen erstrecken können. Entsprechend den Ausnehmungen der Elektrode 24 weist auch die von der Elektrode 24 elektrisch kontaktierte, unterhalb der Elektrode 24 liegende und von dieser wenigstens teilweise überdeckte, in dem Halbleiterkörper 25 eingebettete Einschaltstruktur 23, hier eine Emitterstruktur, einen der Kontur der Elektrodenausnehmungen folgenden Verlauf auf.

Die Emitterstruktur 23 und deren Verlauf ist in Fig. 3 durch eine breit gezeichnete Umrisslinie der Elektrodenausnehmungen angedeutet. Die laterale Emitterstrukturweite W_{SV} entspricht somit anschaulich im Wesentlichen der Breite der in Fig. 3 gezeichneten Umrisslinie. Im Querschnitt gesehen kann die Emitterstruktur 23 beispielsweise ähnlich der Emitterstruktur 17 aus Fig. 2 ausgebildet sein und auch die Kurzschlüsse 12 aufweisen. Dies ist jedoch nicht zwingend erforderlich.

Es ist in Fig. 3 zu erkennen, dass die Emitterstruktur 23 in lateraler Richtung r vier sich radial vom zentrumsnahen Rest der Emitterstruktur 23, das heißt von einem zentrumsnahen Bereich der Emitterstruktur 23, nach außen erstreckende Einschaltstrukturfinger 28 aufweist. Bei dem in Fig. 3 dargestellten Ausführungsbeispiel des Kurzschluss-Halbleiterbauelements 22 ist die Einschalt- bzw. Emitterstruktur 23 linienförmig der Kontur der Elektrodenausnehmungen folgend ausgebildet. Eine solche linienförmige Einschaltstruktur 23 kann vorzugsweise eine laterale Strukturweite Wsv (s. Fig. 2) von etwa 500 µm aufweisen. Die in Fig. 3 gezeigte Einschalt- bzw. Emitterstruktur 23 ist somit teilweise als umfänglich geschlossene Ringstruktur und teilweise als umfänglich geschlossene Polygonstruktur (Emitterfinger 28) ausgebildet, die sich aus der Ringstruktur radial nach außen erstreckt.

Es ist zu verstehen, dass die Verfingerung der Einschaltstruktur 23 und die entsprechende Verfingerung der Zündstruktur 26, hier der Gate-Elektrode 26, selbstverständlich viele andere denkbaren Ausgestaltungen annehmen kann. So ist die Anzahl der Einschaltstrukturfinger 28 bzw. Zündstrukturfinger 27 nicht auf die in Fig. 3 dargestellte Anzahl vier beschränkt. Es können mehr oder auch weniger Finger vorhanden sein. Auch ist der Verlauf der Finger 28 bzw. 27 nicht auf den geradlinigen Verlauf des in Fig. 3 dargestellten Ausführungsbeispiels beschränkt. Der Verlauf kann beispielsweise auch gekrümmt sein. Weiterhin ist es denkbar, dass sich von jedem Finger 28 bzw. 27 noch zusätzlich ein oder mehrere verzweigte Fingerabschnitte von jedem in Fig. 3 dargestellten Finger 28 bzw. 27 weg erstrecken können und so ein- oder mehrfach verzweigte Finger bilden.

Aus der Darstellung der Fig. 3 ist zu erkennen, dass die Zündstruktur 26 der Form bzw. Kontur der Einschaltstrukturfinger 28 entsprechende, das heißt folgende Zündstrukturfinger 27 aufweist. Diese Ausgestaltung stellt aufgrund eines über den gesamten Verlauf der verfingerten Einschaltstruktur 23 sich einstellenden gleichmäßigen Abstands, hier insbesondere in lateraler Richtung, zwischen der Zündstruktur 26 und der Einschaltstruktur 23 gleichmäßige elektrische Wirkung der Zündstruktur 26 auf die Einschaltstruktur 23 sicher.

Die verringerte Einschaltstruktur 23 bietet den wesentlichen Vorteil, dass sich der eingeschaltete bzw. gezündete Bereich des Kurzschluss-Halbleiterbauelements 22 über einen größeren Umfang verteilen kann. Eine laterale Erstreckung der Einschaltstrukturfinger 28 vom zentrumsnahen Rest der Einschaltstruktur 23, das heißt eine radiale Fingerlänge L_{SF} der Einschaltstruktur, wird hierbei bevorzugt kleiner als W_{EV}/2 gewählt. Bei dem hier gezeigten Ausführungsbeispiel des Kurzschluss-Halbleiterbauelements 22 gilt dies ebenfalls für die radiale Fingerlänge der Zündstrukturfinger 27. Diese Maßnahme hilft, den Aufschmelzbereich 21 (s. Fig. 2) einerseits vom Zentrum 13 des Halbleiterkörpers 22 und damit von der Gate-Elektrode 26 fernzuhalten und andererseits ebenso ausreichend weit weg vom radialen Außenrand des Kurzschluss-Halbleiterbauelements 22. Da der zentrale Bereich 13 bei dem in Fig. 3 gezeigten Ausführungsbeispiel des Kurzschluss-Halbleiterbauelements 22 nicht von der Elektrode 24 und damit auch nicht von der dicken Kontaktscheibe 18 (Fig. 2) kontaktiert bzw. bedeckt ist, könnte Plasma im Zentrum 13 auf die elektrische Zuleitung zum Gate-Anschluss G und auf das Metallrohr in der Keramik-/Kunststoffkapsel (nicht dargestellt) gelenkt werden und dort die Kapsel beschädigen. Dies wird durch das in Fig. 3 gezeigte Ausführungsbeispiel des Kurzschluss-Halbleiterbauelements 22 sicher verhindert, da die Durchlegierung 21 (Fig. 2) im Kurzschlussfall stets innerhalb des von der Elektrode 24 überdeckten Bereichs der Emitterstruktur 23 ausgelöst wird.

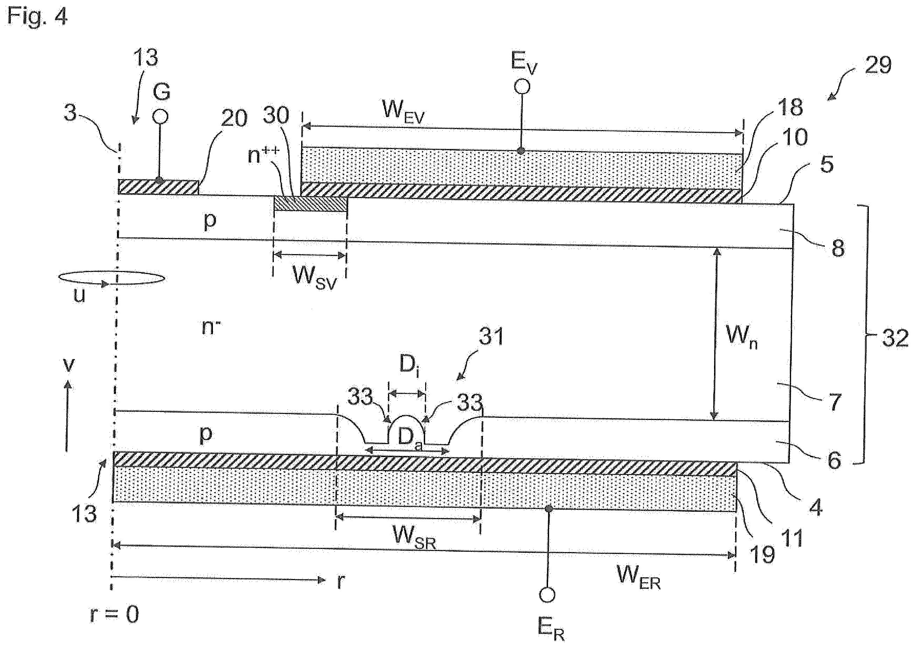

Fig. 4 stellt einen Vertikalschnitt durch ein weiteres Ausführungsbeispiel eines Kurzschluss-Halbleiterbauelements 29 gemäß der Erfindung mit zwei Einschaltstrukturen 30 und 31 und der Zündstruktur 20 (Gate-Elektrode) dar. Wie Fig. 4 zu entnehmen ist, weist das Kurzschluss-Halbleiterbauelement 29 in einem Halbleiterkörper 32 eine n-dotierte vorderseitige Einschalt- bzw. Emitterstruktur 30 auf, deren laterale Emitterstrukturweite Wsv im Vergleich zur lateralen vorderseitigen Elektrodenweite W_{EV} noch deutlich kleiner gewählt ist als bei dem Kurzschluss-Halbleiterbauelement 15 aus Fig. 2. Ebenfalls ist in Fig. 4 zu erkennen, dass die Emitterstruktur 30 in diesem Ausführungsbeispiel keine Kurzschlüsse 12 wie in Fig. 2 dargestellt aufweist, was jedoch nicht zwingend erforderlich ist. Die Einschalt- bzw. Emitterstruktur 30 kann als umfänglich geschlossene Ring- und/oder Polygonstruktur ausgebildet sein, die die Zündstruktur 20 in einem gewissen radialen Abstand umgibt. Auch die Emitterstruktur 30 ragt an der radialen, dem Zentrum 13 zugewandten Innenseite der Elektrode 10 etwas über diese hinaus, wie dies bereits im Zusammenhang mit der Emitterstruktur 17 in Fig. 2 beschrieben wurde.

Außerdem weist der Halbleiterkörper 32 zusätzlich zur durch die Gate-Elektrode 20 gebildeten, im Zentrum 13 des Halbleiterkörpers 32 angeordneten Zündstruktur 20 eine zweite Einschaltstruktur 31 in Form einer Durchbruchstruktur 31 auf, die in diesem Ausführungsbeispiel als umfänglich geschlossene, ringförmige BOD-Struktur ausgebildet ist. Mittels der Durchbruchstruktur 31 ist das Kurzschluss-Halbleiterbauelement 29 abhängig von der an den Elektrodenanschlüssen E_{V} und E_{R} anliegenden Betriebsspannung ebenfalls einschaltbar, in dem gezeigten Ausführungsbeispiel bei einer an der rückseitigen Elektrode 11 gegenüber der vorderseitigen Elektrode 10 anliegenden negativen Polarität. Sie dient außerdem zur zusätzlichen Vermeidung eines Sperrausfalles im radial äußeren Randbereich des Kurzschluss-Halbleiterbauelements 29 im Falle einer nicht vorhersehbaren, an den Elektrodenanschlüssen E_{V} und E_{R} anliegenden Überspannung.

Wie in Fig. 4 zu erkennen ist, befindet sich die Durchbruchstruktur 31 auf der der vorderseitigen Emitterstruktur 30 gegenüberliegenden Seite des Halbleiterkörpers 32 und stellt somit eine rückseitige Einschaltstruktur 31 des Kurzschluss-Halbleiterbauelements 29 dar. Die Höhe der Durchbruchspannung dieser Durchbruchstruktur 31 wird dabei so eingestellt, dass sie an genau dem Ort ihrer Anordnung ihren niedrigsten Wert des ganzen Halbleiterkörpers 32 annimmt und so auch einen Durchbruch im äußeren Randbereich des Halbleiterkörpers 32 verhindert. Der Krümmungsradius des pn-Überganges, d. h. seine geometrische Krümmung, in einem in Fig. 4 mit dem Bezugszeichen 33 gekennzeichneten Bereich bestimmt zusammen mit dem spezifischen Widerstand und dem Verhältnis der Durchmesser D_{I} (Innendurchmesser) und Dₐ (Außendurchmesser) bzw. der lateralen rückseitigen Einschaltstrukturweite W_{SR} der Durchbruchstruktur 31 die Höhe der Durchbruchspannung in an sich bekannter Weise, wie dies beispielsweise in der DE 42 15 378 C1 beschrieben ist. Im Falle einer auftretenden Überspannung in Sperrrichtung U_{R} (negative Polarität am rückseitigen Elektrodenanschluss E_{R}) kommt es im Bereich 33 ab einer bestimmten Spannung zu einem steilen Anstieg des zwischen den Hauptanschlüssen E_{V} und E_{R} fließenden Sperrstroms. Die Stromdichte erreicht dabei so hohe Werte, dass am Ende zwischen den beiden Hauptanschlüssen E_{V} und E_{R} ein lokaler Schmelzkanal entsteht. Die Sperrfähigkeit der npnp-Struktur bricht zusammen und der Kurzschlussstrom führt im Bereich der BOD-Struktur 31 zur Durchlegierung. Mit Durchbruchstrukturen nach Art der Durchbruchstruktur 31 lassen sich allgemein höhere Durchbruchspannungen bzw. sehr hohe Sperrspannungen bis in den kV-Bereich technisch sehr gut beherrschen.

Da die Durchbruchstruktur 31 bei dem in Fig. 4 gezeigten Ausführungsbeispiel des Kurzschluss-Halbleiterbauelements 29 eine rückseitige Einschaltstruktur ist, die in der rückseitigen Basiszone 6 eingebettet ist, auf welche wiederum die rückseitige Elektrode 11 aufgebracht ist, ist für das Verhältnis der lateralen rückseitigen Einschaltstrukturweite W_{SR} der Durchbruchstruktur 31 zur lateralen rückseitigen Elektrodenweite W_{ER} der rückseitigen Elektrode 11 ebenfalls die erfindungsgemäße Bedingung W_{SR}/W_{ER} < 1 zu erfüllen, was bei dem in Fig. 4 dargestellten Kurzschluss-Halbleiterbauelement 29 offensichtlich der Fall ist.

Wie Fig. 4 zu entnehmen ist, ist die laterale Einschaltstrukturweite W_{SR} der Durchbruchstruktur 31 auf denjenigen lateralen Bereich der Basiszone 6 festgelegt, in dem die Geometrie des zwischen dieser Basiszone 6 und der Innenzone 7 gebildeten pn-Übergangs deutlich gegenüber der Geometrie des restlichen pn-Übergangs, das heißt des pn-Übergangs außerhalb des durch die laterale rückseitige Einschaltstrukturweite W_{SR} festgelegten Bereichs, verändert ist. Hierbei ist insbesondere zu verstehen, dass eine veränderte Geometrie dieses pn-Übergangs im Sinne der vorliegenden Erfindung erst dann vorliegt, wenn diese Veränderung sicher nicht den herstellungsbedingten Toleranzabweichungen bei der Herstellung der Basiszone 6 und der Innenzone 7 zuzurechnen ist, sondern das Ergebnis zielgerichteten Handelns ist.

Die Durchbruchstruktur 31 des in Fig. 4 dargestellten Kurzschluss-Halbleiterbauelements 29 weist eine das Zentrum 13 des Halbleiterkörpers 32 umgebende Ringform auf und ist dementsprechend zum Zentrum 13 radial beabstandet. Insbesondere ist die Durchbruchstruktur bzw. rückseitige Einschaltstruktur 31 bei dem in Fig. 4 gezeigten Ausführungsbeispiel des Kurzschluss-Halbleiterbauelements 29 vollständig von der vorderseitigen Elektrode 10 und der rückseitigen Elektrode 11 überdeckt. Die vollständige vorder- und rückseitige Überdeckung der Durchbruchstruktur 31 bietet den Vorteil, dass ein Plasmaaustritt aus dem Halbleiterkörper 29 aufgrund der lokalen Begrenzung der Durchlegierung im Bereich um die beidseitig von den Elektroden 10 und 11 überdeckte Durchbruchstruktur 31 sicher verhindert wird.

Die als Einschaltstruktur fungierende Durchbruchstruktur 31 kann prinzipiell jedoch auch im Zentrum 13 des Halbleiterkörpers 32 angeordnet sein, wie dies beispielsweise ebenfalls in der DE 42 15 378 C1 beschrieben ist. In einem solchen, in Fig. 4 nicht dargestellten Fall wäre die Durchbruchstruktur 31 bevorzugt ebenfalls sowohl auf der Vorderseite 5 des Halbleiterkörpers 32 als auch auf seiner Rückseite 4 von den jeweiligen Elektroden 10 und 11 überdeckt, um dieselbe Wirkung bezüglich eines Plasmaaustritts zu erzielen wie vorstehend beschrieben. Mit anderen Worten bräuchte ein Kurzschluss-Halbleiterbauelement mit wenigstens einer im Zentrum angeordneten Einschaltstruktur, insbesondere einer als Einschaltstruktur ausgebildeten Durchbruchstruktur, keine dort angeordnete Zündstruktur wie zum Beispiel die in Fig. 4 gezeigte Gate-Elektrode 20 mit einem Gate-Anschluss G. Da die Durchbruchstruktur 31 das Einschaltsignal aus der an den Elektrodenanschlüssen E_{V} und E_{R} anliegenden Spannung bezieht, kann auf die Zuführung eines zusätzlichen externen Einschaltsignals verzichtet werden.

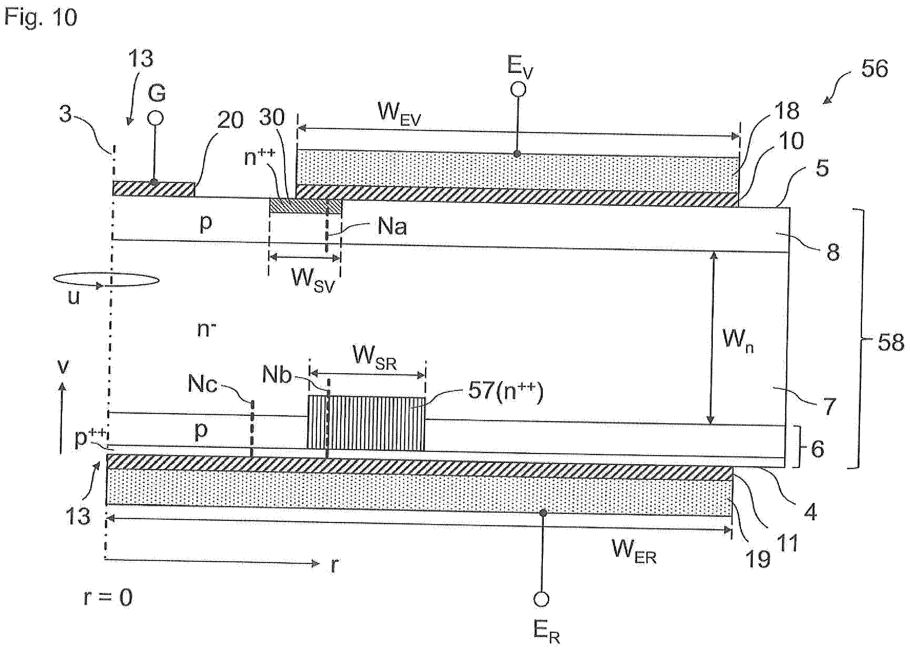

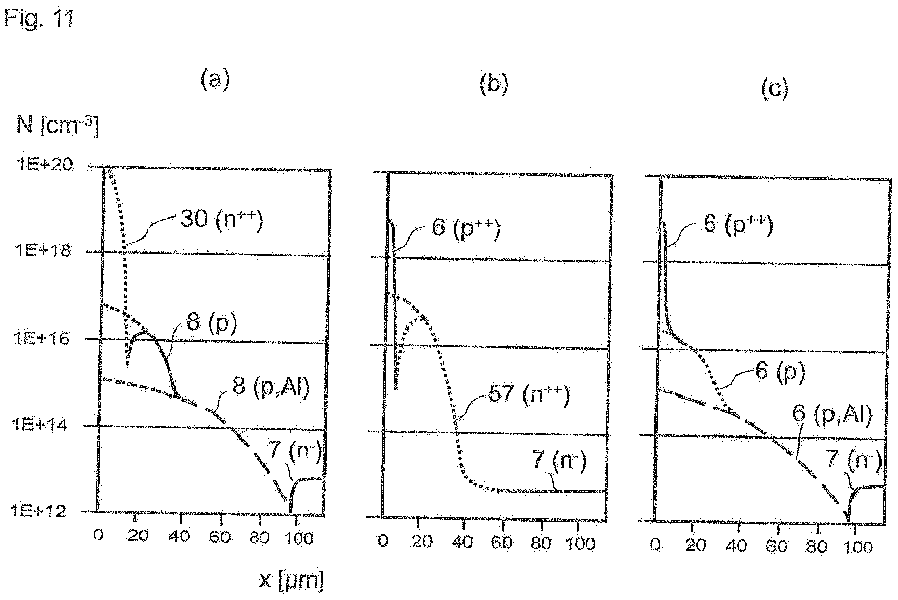

Es sei an dieser Stelle angemerkt, dass die in Fig. 4 als BOD-Struktur gezeigte Durchbruchstruktur 31 auch durch jede andere an sich wohl bekannte Durchbruchstruktur mit ähnlicher Wirkung ersetzt werden kann, sofern sie als Einschaltstruktur dazu ausgebildet ist, die Durchlegierung des entsprechenden Kurzschluss-Halbleiterbauelements in Abhängigkeit von einem Einschaltsignal, das sich bei einer im Halbleiterkörper integrierten Durchbruchstruktur stets implizit aus der an den äußeren Elektroden 10 und 11 anliegenden elektrischen Spannung ergibt, einzuleiten. Derartige andere Durchbruchstrukturen sind zum Beispiel eine einen an sich bekannten du/dt-Schutz aufweisende Durchbruchstruktur oder eine einen an sich bekannten Freiwerdezeitschutz mit lokaler Anhebung der Ladungsträgerlebensdauer aufweisende Durchbruchstruktur. Eine noch weitere, zur Durchbruchstruktur 31 alternative Durchbruchstruktur wird weiter unten im Zusammenhang mit der Erläuterung der Fig. 10 und 11 beschrieben.

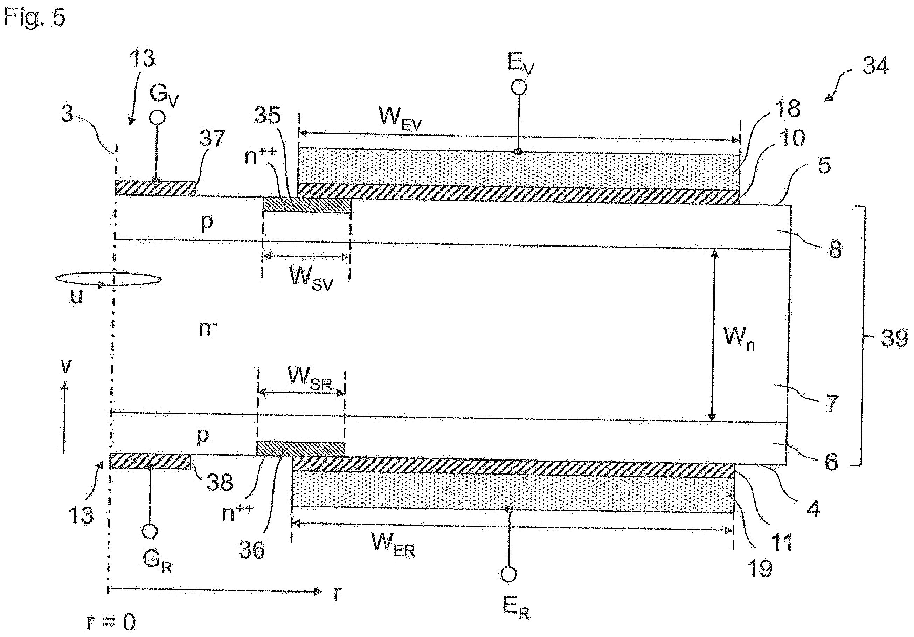

Fig. 5 stellt einen Vertikalschnitt durch ein noch weiteres Ausführungsbeispiel eines Kurzschluss-Halbleiterbauelements 34 gemäß der Erfindung mit zwei Einschaltstrukturen 35, 36 und zwei Zündstrukturen 37, 38 dar. Die zwei Einschaltstrukturen 35 und 36 sind jeweils als n-dotierte Emitterstrukturen ausgebildet, die jeweils in der vorderseitigen bzw. rückseitigen Basiszone 8 bzw. 6 eines Halbleiterkörpers 39 eingebettet sind. Die Einschalt- bzw. Emitterstrukturen 35, 36 können als umfänglich geschlossene Ring- und/oder Polygonstrukturen ausgebildet sein. Wie Fig. 5 deutlich zu entnehmen ist, ragen beide Emitterstrukturen 35 und 36 jeweils etwas über den radialen, dem jeweiligen Zentrum 13 zugewandten Innenrand der jeweiligen Elektrode 10 bzw. 10 hinaus. Die beiden Zündstrukturen 37 und 38 sind jeweils als Gate-Elektroden 37, 38 mit je einem vorder- bzw. rückseitigen Gate-Anschluss G_{V} bzw. G_{R} ausgebildet, wobei die vorderseitige Gate-Elektrode 37 im Zentrum 13 der vorderseitigen Basiszone 8 diese elektrisch kontaktierend angeordnet ist und die Gate-Elektrode 38 im Zentrum 13 der rückseitigen Basiszone 6. Bei dem in Fig. 5 dargestellten Ausführungsbeispiel des Kurzschluss-Halbleiterbauelements 34 weisen beide Einschaltstrukturen 35, 36 dieselbe laterale Einschaltstrukturweite W_{SV} bzw. W_{SR} auf, was jedoch nicht zwingend erforderlich ist. Die lateralen Elektrodenweiten W_{EV} und W_{ER} der vorder- bzw. rückseitigen Elektroden 10 und 11 weisen bei dem Kurzschluss-Halbleiterbauelement 34 ebenfalls dieselbe Größe auf, was ebenfalls nicht zwingend erforderlich ist. Das Kurzschluss-Halbleiterbauelement 34 ist folglich bezüglich der vertikalen Richtung vollkommen symmetrisch aufgebaut. Die lateralen Elektrodenweiten W_{EV} und W_{ER} können deutlich größer als die entsprechenden lateralen Einschaltstrukturweiten W_{SV} bzw. W_{SR} sein, so dass auch für dieses Kurzschluss-Halbleiterbauelement 34 die Bedingungen W_{SV}/W_{EV} < 1 und W_{SR}/W_{ER} < 1 gelten, was jedoch nicht zwingend erforderlich ist. Das Kurzschluss-Halbleiterbauelement 34 lässt sich demnach sowohl über ein dem vorderseitigen Gate-Anschluss Gv zugeführtes elektrisches Einschaltsignal als auch über ein dem rückseitigen Gate-Anschluss G_{R} zugeführtes elektrisches Einschaltsignal einschalten.

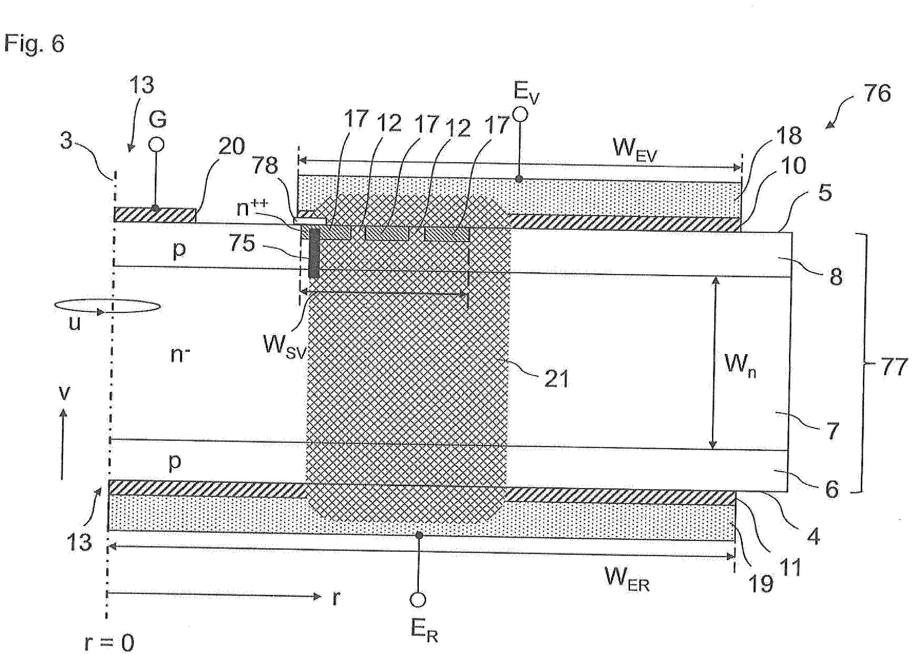

Fig. 6 stellt einen Vertikalschnitt durch ein noch weiteres Ausführungsbeispiel eines Kurzschluss-Halbleiterbauelements 76 gemäß der Erfindung dar. Im Wesentlichen entspricht das Halbleiterbauelement 76 dem Aufbau des in Fig. 2 gezeigten Kurzschluss-Halbleiterbauelements 15, wobei das Halbleiterbauelement 76 zusätzlich eine Isolatorschicht 78 zwischen der vorderseitigen Elektrode 10 und der Vorderseite 5 des Halbleiterkörpers 77 bzw. der Kontaktfläche der Einschalt-/Emitterstruktur 17 aufweist. Es ist zu erkennen, dass sich die Isolatorschicht 78 in radialer Richtung r über diese Einschaltstruktur 17 erstreckt und in Umfangsrichtung u entlang einem in radialer Richtung r innen liegenden Innenrand dieser Elektrode 10 erstreckt. Die Isolatorschicht 78 ist vorliegend eine Siliziumdioxidschicht, die in einem thermischen Prozess bei der Herstellung des Halbleiterkörpers hergestellt wird. Sie weist bevorzugt eine Dicke von wenigstens 50 nm bis höchstens 100 nm auf.

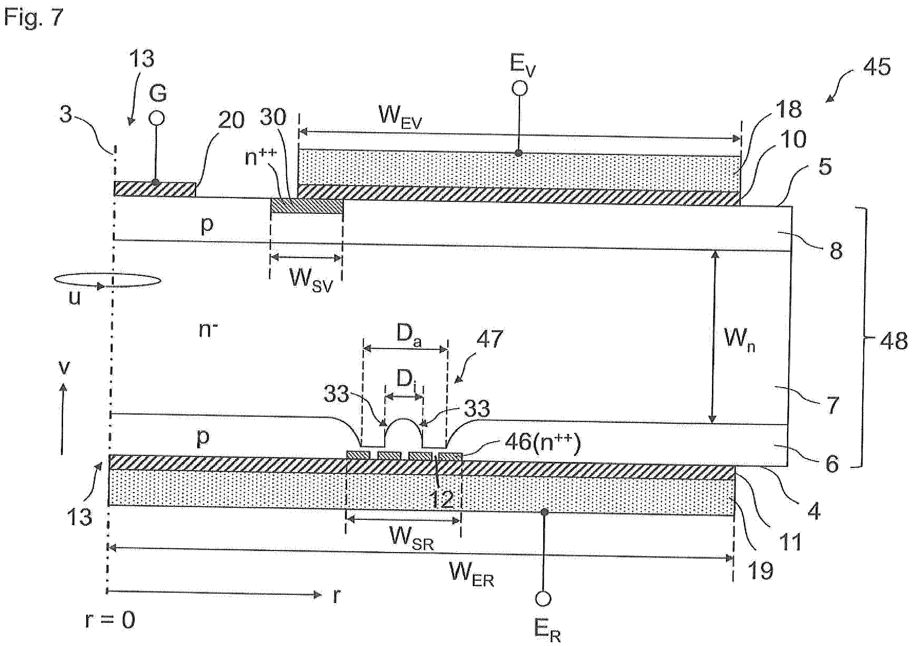

Fig. 7 stellt einen Vertikalschnitt durch ein weiteres Ausführungsbeispiel eines Kurzschluss-Halbleiterbauelements 45 gemäß der Erfindung mit zwei Einschaltstrukturen 30 und 46 und zwei Zündstrukturen 20 und 47 dar. In einem Halbleiterkörper 48 ist die rückseitige Einschaltstruktur 46 als n-dotierte Emitterstruktur 46 mit Kurzschlüssen 12 und einer lateralen rückseitigen Einschaltstrukturweite W_{SR} angrenzend an die Rückseite 4 in die rückseitige Basiszone 6 eingebettet und von der rückseitigen Elektrode 11 elektrisch leitend kontaktiert und vollständig bedeckt. Die Einschalt- bzw. Emitterstruktur 46 kann als umfänglich geschlossene Ring- und/oder Polygonstruktur ausgebildet sein. Im selben lateralen Bereich der Einschaltstruktur 46, jedoch in vertikaler Richtung v hierzu versetzt, ist die als Durchbruchstruktur, zum Beispiel als BOD-Struktur, ausgebildete rückseitige Zündstruktur 47 angeordnet. Wie bereits im Zusammenhang mit Fig. 4 beschrieben wurde, setzt bei Erreichen bzw. Überschreiten der für die Durchbruchstruktur 47 festgelegten Durchbruchspannung, die unmittelbar von der an den äußeren Elektroden 10 und 11 anliegenden, als Einschaltsignal dienenden elektrischen Spannung abhängt, ein steiler, lokal begrenzter Stromanstieg im Bereich 33 ein, der bei dem in Fig. 7 gezeigten Beispiel des Kurzschluss-Halbleiterbauelements 45 zum Einschalten der rückseitigen Emitterstruktur 46 bzw. Vorzerstören des in Fig. 2 oder 6 gezeigten Vorzerstörungsbereichs 75 genutzt wird, wodurch letztendlich das Durchlegieren des Kurzschluss-Halbleiterbauelements 45 eingeleitet wird. Das Vorsehen der Emitterstruktur 46 als Einschaltstruktur, die von der Durchbruchstruktur 47 eingeschaltet bzw. vorzerstört wird, hat den Vorteil einer lateralen Aufweitung des durchlegierten Bereichs gegenüber der in Fig. 4 gezeigten, als Durchbruchstruktur ausgebildeten Einschaltstruktur 31, bei der der von der Durchbruchstruktur 31 zur Durchlegierung ausgehende Schmelzkanal lokal eng begrenzt ist. Die Emitterstruktur 46 hilft aufgrund der lateralen Aufweitung des Schmelzkanals, die Durchlegierung "weicher" ablaufen zu lassen. Zudem erlaubt ein im Querschnitt größerer Durchlegierungsbereich im Halbleiterkörper 48 aufgrund des verringerten Leitungswiderstands ein dauerhaftes Führen höherer Kurzschlussströme mit geringeren Leitungsverlusten.

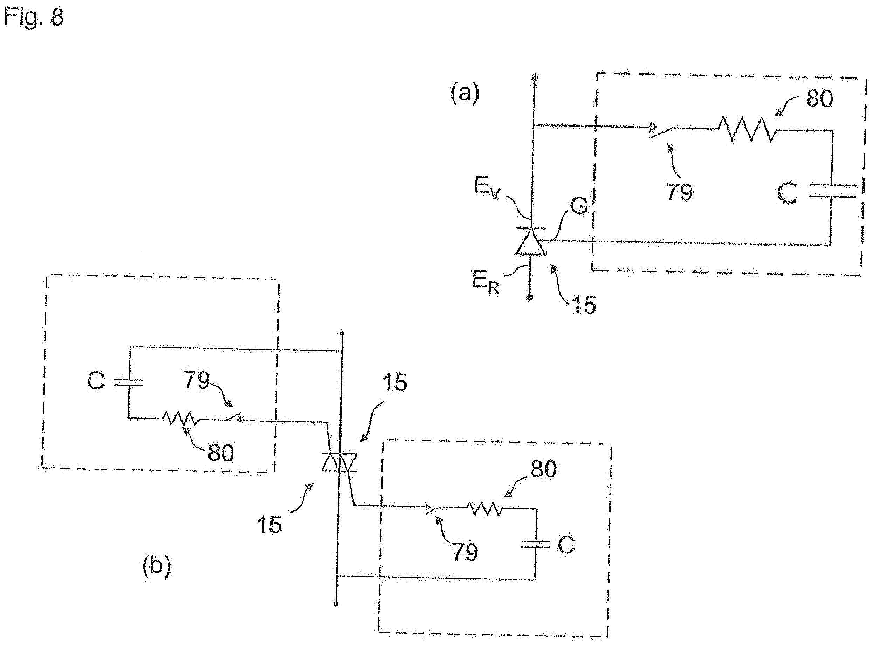

Fig. 8 stellt in einer Ansicht (a) ein erstes Schaltbild eines Ausführungsbeispiels einer Verschaltung des Kurzschluss-Halbleiterbauelements 15 aus Fig. 2 und in einer weiteren Ansicht (b) ein Schaltbild eines weiteren Ausführungsbeispiels einer Verschaltung des Kurzschluss-Halbleiterbauelements 15 aus Fig. 2 dar.

In Fig. 8(a) ist ein Kondensator C mit einer dem vorbestimmten Energieeintrag entsprechend vorbestimmten Kapazität zu erkennen, der das Einschaltsignal in einem aufgeladenen Zustand bereitstellt, wobei der Kondensator C vorliegend mittels eines elektronischen Schalters 79 elektrisch zwischen die Gate-Elektrode 20 bzw. den Gate-Anschluss G und die vorderseitige Elektrode 10 bzw. den vorderseitigen Elektrodenanschluss Ev schaltbar ist. Der Kurzschluss-Halbleiterschalter 15 fungiert hierbei als unidirektionaler Schalter. Der Halbleiterschalter 15 muss den Strom nur in einer Richtung führen, die andere Stromrichtung kann z. B. durch eine zum Halbleiterschalter 15 antiparallel angeordnete druckkontaktierte Diode (nicht dargestellt) gewähreistet werden.

In Fig. 8(b) ist die Schaltungsanordnung der Fig. 8(a) doppelt dargestellt, wobei diese dann antiparallel verschaltet sind. Auf diese Weise lässt sich mit zwei an sich jeweils unidirektionalen Halbleiterschaltern 15 ein insgesamt bidirektionaler Aufbau schaffen, bei dem jedem Halbleiterschalter 15 vorzugsweise jeweils eine Gate-Ansteuereinheit (entspricht dem Kondensator C sowie dem elektronischen Schalter) zugewiesen ist. Die bidirektionale Ausführung bzw. antiparallele Verschaltung der beiden Halbleiterschalter 15 kann den Strom somit in beiden Richtungen führen.

Alternativ zu der bidirektionalen, antiparallelen Verschaltung der beiden unidirektionalen Halbleiterschalter 15 wie in Fig. 8(a) gezeigt kann auch ein direkt bidirektional arbeitender Halbleiterschalter, beispielsweise der Halbleiterschalter 34 aus Fig. 5, verwendet werden. Jedenfalls ist es bevorzugt, beide unidirektionalen Halbleiterbauelemente bzw. das eine bidirektionale Halbleiterbauelement in einem Gehäuse aufzunehmen.

In Fig. 8 ist weiterhin eine Impedanz 80 dargestellt, welche für den parasitären Widerstand bzw. eine Induktivität im Gate-Elektroden-Kreis steht. Je kleiner die Impedanz, umso höher sind der für die Vorzerstörung zur Verfügung stehende Stromstoß bzw. Energieeintrag.

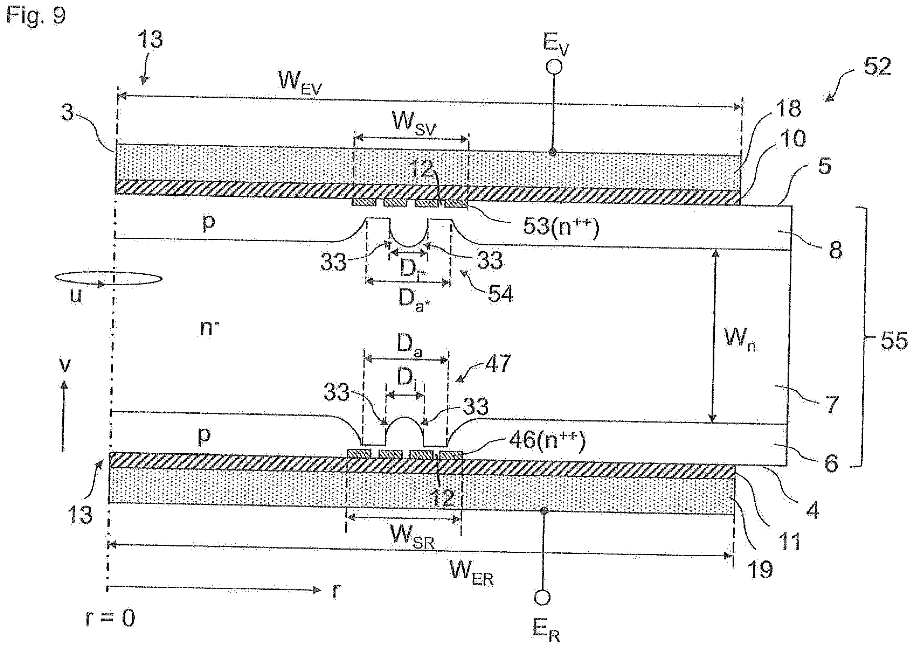

Fig. 9 stellt einen Vertikalschnitt durch ein noch weiteres Ausführungsbeispiel eines Kurzschluss-Halbleiterbauelements 52 gemäß der Erfindung mit zwei Einschaltstrukturen 46 und 53 und zwei Zündstrukturen 47 und 54 dar. In einem Halbleiterkörper 55 sind rückseitig die bereits in Fig. 7 gezeigte, als Emitterstruktur ausgebildete Einschaltstruktur 46 sowie die mit dieser elektrisch wirkverbundene rückseitige, als Durchbruchstruktur ausgebildete Zündstruktur 47 eingebettet. Vorderseitig ist in ähnlicher Weise die als n-dotierte Emitterstruktur ausgebildete vorderseitige Einschaltstruktur 53 in die vorderseitige Basiszone 8 angrenzend an die Vorderseite 5 eingebettet und von der vorderseitigen Elektrode 10 elektrisch kontaktiert. Der vorderseitigen Emitterstruktur 53 ist die vorderseitige Zündstruktur 54 zugeordnet, die ebenfalls als Durchbruchstruktur ausgebildet ist und die Emitterstruktur 53 im Durchbruchfall einschaltet bzw. vorzerstört. Die Wirkungsweise der Kombination der vorderseitigen Emitterstruktur 53 mit der vorderseitigen Durchbruchstruktur 54 entspricht der Kombination der rückseitigen Emitterstruktur 46 mit der rückseitigen Durchbruchstruktur 47 und wurde bereits im Zusammenhang mit der Beschreibung der Fig. 7 erläutert. Beide Einschalt- bzw. Emitterstrukturen 46, 53 sowie beide Zündstrukturen 47, 54 können jeweils als umfänglich geschlossene Ring- und/oder Polygonstrukturen ausgebildet sein.

Die Einschalt- und Zündstrukturen 46, 53, 46, 54 des Kurzschluss-Halbleiterbauelements 52 können exakt mittig, das heißt im jeweiligen Zentrum 13, angeordnet werden, ohne jedoch hierauf beschränkt zu sein.

Fig. 10 stellt einen Vertikalschnitt durch ein weiteres Ausführungsbeispiel eines Kurzschluss-Halbleiterbauelements 56 gemäß der Erfindung mit zwei Einschaltstrukturen 30 und 57 und einer Zündstruktur 20 dar. In einem Halbleiterkörper 58 ist zusätzlich zur bereits aus Fig. 4 bekannten vorderseitigen Einschaltstruktur 30 die rückseitige Einschaltstruktur 57 in Form einer noch weiteren Ausbildung einer Durchbruchstruktur eingebettet. Insbesondere ist in Fig. 10 gut zu erkennen, dass die rückseitige Einschaltstruktur 57 lokal begrenzt ist, insbesondere in radialer Richtung r lokal begrenzt ist, und damit eine laterale Strukturweite W_{SR} aufweist, die deutlich kleiner ist als die laterale Elektrodenweite W_{ER} der zugeordneten rückseitigen Elektrode 11, wie es bei allen hierin offenbarten lateralen Einschaltstrukturweiten bezogen auf die entsprechenden lateralen Elektrodenweiten der jeweiligen Elektroden des erfindungsgemäßen Kurzschluss-Halbleiterbauelements der Fall ist.

Weiterhin ist Fig. 10 zu entnehmen, dass die rückseitige Basiszone 6 einen der Rückseite 4 zugewandten, flachen, im Vergleich zum der Innenzone 7 zugewandten Bereich hoch p-dotierten p⁺⁺-Bereich aufweist. In einem lateralen Abschnitt, welcher der lateralen Einschaltstrukturweite W_{SR} entspricht, ist in den gewöhnlich p-dotierten Bereich der rückseitigen Basiszone 6 ein gegenüber der n-dotierten Innenzone 7 wesentlich höher n-dotierter n⁺⁺-Bereich eingefügt, der in vertikaler Richtung v bis in die Innenzone 7 reicht. Die Rückseite 4 des Halbleiterkörpers 58, auf dem die rückseitige Elektrode 11 aufgebracht ist, erreicht der n⁺⁺-Bereich nicht, da der hochdotierte p⁺⁺-Bereich der Basiszone 6 den eingefügten n⁺⁺-Bereich von der durch die Elektrode 11 kontaktierten Rückseite 4 beabstandet. Die Konzentration des p⁺⁺-Bereichs der rückseitigen Basiszone 6 wird höher gewählt als die Konzentration des den p-Bereich der Basiszone 6 unterbrechenden n⁺⁺-Bereichs, um einen Kurzschluss zwischen der Innenzone 7 und der rückseitigen Elektrode 11 zu verhindern.

Auch für die in Fig. 10 gezeigte Durchbruchstruktur 57 lässt sich eine Durchbruchspannung gezielt einstellen, beispielsweise durch die Wahl der Dotierkonzentration der schwach n-dotierten Innenzone 7 und/oder des hochdotierten n⁺⁺-Bereichs 57 und/oder der p-dotierten Basiszone 6, insbesondere ihres hochdotierten, die Durchbruchstruktur 57 zur Rückseite 4 des Halbleiterkörpers 58 hin beabstandenden p⁺⁺-Bereichs, wobei die Durchbruchspannung der Durchbruchstruktur 57 sinkt je höher die Konzentration ihres n⁺⁺-Bereichs und/oder des p⁺⁺-Bereichs der Basiszone 6 gewählt wird. Es lassen sich auf diese Weise Durchbruchspannungen im Bereich weit unter 10 V bis zur maximal möglichen Sperrfähigkeit des Halbleiterkörpers 58 festlegen. Durchbruchstrukturen nach Art der Durchbruchstruktur 57 sind technisch besonders vorteilhaft im Hinblick auf das Einstellen von verhältnismäßig kleinen Sperrspannungen im Bereich von einigen wenigen Zehn Volt bis etwa 100 V.

Fig. 11 stellt in den Ansichten (a), (b) und (c) jeweils einen Konzentrationsverlauf durch das Kurzschluss-Halbleiterbauelement 56 aus Fig. 10 entlang der dort gezeigten Konzentrationsverlaufslinien Na, Nb bzw. Nc dar. In Fig. 11a ist demnach der Konzentrationsverlauf entlang der in Fig. 10 dargestellten Verlaufslinie Na, in Fig. 11b der Konzentrationsverlauf entlang der Verlaufslinie Nb und in Fig. 11c der Konzentrationsverlauf entlang der Verlaufslinie Nc gezeigt. In den jeweiligen Konzentrationsverläufen der Fig. 11a, 11b und 11c ist auf der entsprechenden Abszisse jeweils die Eindringtiefe x in µm des jeweiligen Dotierstoffs aufgetragen. Die Ordinaten stellen jeweils die Konzentration N pro cm⁻³ des jeweiligen Dotierstoffs dar.

In Fig. 11a ist der Konzentrationsverlauf entlang der in Fig. 10 gezeigten Verlaufslinie Na dargestellt, der sich von der Vorderseite 5 des Halbleiterkörpers 58 durch die vorderseitige Einschalt- bzw. Emitterstruktur 30 und die vorderseitige Basiszone 8 bis in die Innenzone 7 erstreckt. In Fig. 11a ist ausgehend von x = 0 der flache Profilverlauf, das heißt ein Verlauf mit geringer Eindringtiefe (hier kleiner etwa 20 µm), der beispielsweise mit Phosphor dotierten n⁺⁺-Emitterstruktur 30 hoher Konzentration (bis etwa 1E20 cm⁻³) in Form einer punktierten Kurve zu erkennen. Hieran schließt mit zunehmender Eindringtiefe x (etwa von 20 µm bis etwa 40 µm) der Konzentrationsverlauf der beispielsweise mit Bor dotierten p-Basiszone 8 in Form einer durchgezogenen Kurve an. Bei dem in Fig. 10 dargestellten Kurzschluss-Halbleiterbauelement 56 ist dem mit Bor dotierten ersten p-Bereich der Basiszone 8 noch ein mit Aluminium (Al) dotierter zweiter p-Bereich der Basiszone 8 mit deutlich geringerer Konzentration (z. B. zwischen etwa 1E13 bis etwa 1E15 cm⁻³) vorgelagert, wie dem Konzentrationsverlauf der Fig. 11a anhand der gestrichelten Kurve zu entnehmen ist. Dieses Al-Profil in der Basiszone 8 ist jedoch nicht zwingend erforderlich. An die Basiszone 8 schließt sich im Konzentrationsverlauf der Fig. 11a mit weiter zunehmender Eindringtiefe x (hier etwa ab 100 µm) der Verlauf der schwach n-dotierten Innenzone 7 mit im Wesentlichen konstanter Konzentration (hier etwa 1E13 cm⁻³) an.

In Fig. 11b ist der Konzentrationsverlauf entlang der in Fig. 10 gezeigten Verlaufslinie Nb dargestellt, der sich von der Rückseite 4 des Halbleiterkörpers 58 durch die rückseitige Basiszone 6 und die rückseitige Einschalt- bzw. Durchbruchstruktur 57 bis in die Innenzone 7 erstreckt. In Fig. 11b ist ausgehend von x = 0 zunächst der sehr flache Profilverlauf des beispielsweise mit Bor dotierten p⁺⁺-Bereichs der Basiszone 6 mit hoher Konzentration von bevorzugt etwa 5E18 cm⁻³ und einer Eindringtiefe von vorzugsweise etwa 5 bis 20 µm in Form einer durchgezogenen Kurve zu sehen. Hieran schließt sich mit zunehmender Eindringtiefe x der Konzentrationsverlauf der beispielsweise mit Phosphor oder Arsen dotierten n⁺⁺-Einschalt- bzw. Durchbruchstruktur 57 an, der in Fig. 11b als punktierte Kurve dargestellt ist. Es ist in Fig. 11b gut zu erkennen, dass die Konzentration N der hochdotierten n⁺⁺-Durchbruchstruktur 57 deutlich geringer ist als die Konzentration N des rückseitig vorgelagerten p⁺⁺-Bereichs der Basiszone 6. Der Konzentrationsverlauf der Durchbruchstruktur 57 geht mit weiter zunehmender Eindringtiefe x in den Verlauf der schwach n⁻-dotierten Innenzone 7 über.

In Fig. 11c ist der Konzentrationsverlauf entlang der in Fig. 10 gezeigten Verlaufslinie Nc dargestellt, der sich von der Rückseite 4 des Halbleiterkörpers 58 durch die rückseitige Basiszone 6 bis in die Innenzone 7 erstreckt. In Fig. 11c ist ausgehend von x = 0 zunächst der sehr flache Profilverlauf des hier mit Bor dotierten p⁺⁺-Bereichs der Basiszone 6 mit hoher Konzentration von bevorzugt etwa 5E18 cm⁻³ und einer Eindringtiefe von vorzugsweise etwa 5 bis 20 µm in Form einer durchgezogenen Kurve zu erkennen. Hieran schließt sich mit zunehmender Eindringtiefe x der Konzentrationsverlauf der restlichen p-dotierten Basiszone 6 mit deutlich geringerer Konzentration N (hier kleiner 1E16 cm⁻³) an, der in Fig. 11c als punktierte Kurve dargestellt ist. Die rückseitige Basiszone 6 weist ebenso wie die vorderseitige Basiszone 8 (siehe Fig. 11a) noch einen Richtung Innenzone 7 vorgelagerten, beispielsweise mit Aluminium Al schwachdotierten p-Bereich der Basiszone 6 mit einer Konzentration um etwa 1E15 cm⁻³ bis in eine Eindringtiefe x von etwa 100 µm auf, wie in Fig. 11c anhand einer gestrichelten Kurve dargestellt ist. Dieser Al-dotierte p-Bereich der Basiszone 6 ist jedoch nicht zwingend erforderlich. An diesen Bereich der Basiszone 6 schließt sich, wie in Fig. 11b dargestellt, erneut die schwach n⁻-dotierte Innenzone 7 an.

Besonders bevorzugt ist es, die vorder- und/oder rückseitigen Basiszonen 8 bzw. 6 im Bereich der in Fig. 10 angegebenen Konzentrationsverlaufslinien Na und Nc mit einer Eindringtiefe bzw. Dicke von wenigstens 50 µm vorzusehen, beispielsweise etwa 100 µm, wie dies auch in den Fig. 11a und 11c zu erkennen ist.

Wie bereits vorstehend zur Beschreibung der Fig. 10 erwähnt, ist die einstellbare Durchbruchspannung der Durchbruchstruktur 57 in Sperrrichtung bestimmt durch die zusätzlich eingebrachte Menge an Donatoratomen, die die in Fig. 10 gezeigte n⁺⁺-Durchbruchstruktur 57 bildet. Je größer diese Konzentration, umso geringer die Durchbruchspannung. Auch die Höhe der Konzentration des p⁺⁺-Bereichs der p-dotierten rückseitigen Basiszone 6 am Übergang zur n⁺⁺-Durchbruchstruktur 57 sowie der Verlauf der Konzentration des p⁺⁺-Profils der Basiszone 6 am Übergang zur n⁺⁺-Durchbruchstruktur 57 (siehe Fig. 11b) bestimmen die Durchbruchspannung: je flacher der Gradient des Konzentrationsverlaufes am Übergang vom p⁺⁺-Bereich der Basiszone 6 zum n⁺⁺-Bereich der Durchbruchstruktur 57, desto größer die Sperrfähigkeit bei sonst gleichen Verhältnissen. So kann zum Beispiel nach dem Eindiffundieren des flachen, hochdotierten p⁺⁺-Bereichs der Basiszone 6 die Sperrfähigkeit der Durchbruchstruktur 57 durch die Eintreibzeit des p⁺⁺-Bereichs eingestellt werden, denn mit zunehmender Eintreibzeit wird der Konzentrationsgradient am Übergang vom p⁺⁺-Bereich der Basiszone 6 zum n⁺⁺-Bereich der Durchbruchstruktur 57 flacher, was die Durchbruchspannung erhöht. Für sehr kleine Durchbruchspannungen der Durchbruchstruktur 57 muss man also ein sehr flaches (geringe Eindringtiefe x) und sehr hochdotiertes p⁺⁺-Profil der Basiszone 6 herstellen. Beispielsweise ergibt sich auf diese Weise für eine angenommene Durchbruchspannung von etwa 30 V eine mittlere Konzentration des n⁺⁺-Bereichs der Durchbruchstruktur 57 von ca. 5E16 cm⁻³.

Die Sperrfähigkeit der Durchbruchstruktur 57 ist über einen weiten Bereich einstellbar. Allerdings kommt sie an ihre Grenze, wenn die Konzentration sehr klein wird und in die Nähe der Konzentration der schwach n⁻-dotierten Innenzone 7 kommt, die beispielsweise für hochsperrende Halbleiterbauelemente eine Konzentration N kleiner 1E14 cm⁻³ aufweisen kann. Die Durchbruchspannung der Durchbruchstruktur 57 lässt sich hingegen sehr gut einstellen, wenn sich ihre Sperrfähigkeit sehr deutlich von der maximal möglichen Sperrfähigkeit des Kurzschluss-Halbleiterbauelements 56, die durch die Siliziumdicke Wₙ und die Konzentration N der schwachdotierten Innenzone 7 vorgegeben ist, unterscheidet, wenn diese also zum Beispiel kleiner 100 V beträgt, wobei die geforderte Sperrfähigkeit des Kurzschluss-Halbleiterbauelements 56 dann deutlich über 1000 V liegt, wenn also das Verhältnis von maximal möglicher Sperrfähigkeit des Kurzschluss-Halbleiterbauelements 56 zur eingestellten Sperrfähigkeit der Durchbruchstruktur 57 in einem Bereich von etwa 50 bis etwa 100 liegt.

Die in Fig. 10 beschriebene Durchbruchstruktur 57 kann in derselben Weise wie die anderen hierin beschriebenen Durchbruchstrukturen als Einschaltstruktur und/oder Zündstruktur im erfindungsgemäßen Kurzschluss-Halbleiterbauelement verwendet werden. Die Einschalt- bzw. Durchbruchstruktur 57 des Kurzschluss-Halbleiterbauelements 56 kann als umfänglich geschlossene Ring- und/oder Polygonstruktur ausgebildet sein.

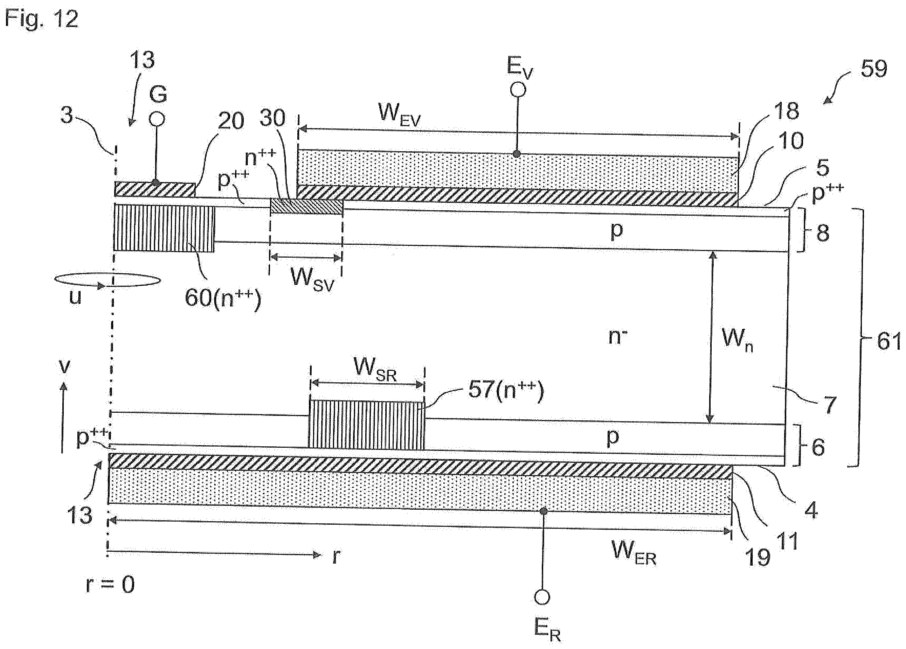

Fig. 12 stellt einen Vertikalschnitt durch ein weiteres Ausführungsbeispiel eines Kurzschluss-Halbleiterbauelements 59 gemäß der Erfindung mit zwei Einschaltstrukturen 30 und 57 und zwei Zündstrukturen 20 und 60 dar. In einem Halbleiterkörper 61 ist zusätzlich zur in Fig. 10 gezeigten Ausgestaltung des Kurzschluss-Halbleiterbauelements 56 die vorderseitige als Zündstruktur 60 ausgebildete Durchbruchstruktur in vertikaler Richtung v unterhalb der als Gate-Elektrode 20 ausgebildeten vorderseitigen Zündstruktur 20 angeordnet. Die Zündstruktur 60 weist strukturell denselben Aufbau auf wie die rückseitige Einschaltstruktur 57, wie Fig. 12 zu entnehmen ist. Zur Einbettung der Durchbruchstruktur 60 in die vorderseitige Basiszone 8 ist diese wie die rückseitige Basiszone 6 in einen der Vorderseite 5 zugewandten, hochdotierten, flachen p⁺⁺-Bereich und den der Innenzone 7 zugewandten gewöhnlichen p-Bereich aufgeteilt, so dass der p⁺⁺-Bereich in vertikaler Richtung v zwischen der Gate-Elektrode 20 und dem n⁺⁺-Bereich der Durchbruchstruktur 60 angeordnet ist. Die vorderseitige Emitterstruktur 30 ist an die Vorderseite 5 angrenzend in die vorderseitige Basiszone 8 eingebettet und von der vorderseitigen Elektrode 10 elektrisch leitend kontaktiert.

Die vorderseitige Einschaltstruktur 30 kann bei dem in Fig. 12 gezeigten Kurzschluss-Halbleiterbauelement 59 demnach sowohl durch ein dem Gate-Anschluss G extern zugeführtes elektrischen Einschaltsignal eingeschaltet werden, aber zusätzlich auch durch die Zündstruktur 60, wenn die an ihr anliegende, durch die an den Hauptelektroden 10 und 11 anliegende elektrische Spannung vorgegebene Blockierspannung die für die Durchbruchstruktur 60 festgelegte Durchbruchspannung überschreitet. In diesem Fall steigt der Durchbruchstrom an der Durchbruchstruktur 60 soweit an, bis dieser die in derselben Basiszone 8 eingebettete Einschaltstruktur 30 einschaltet bzw. vorzerstört, was letztendlich zur gewünschten Durchlegierung des Kurzschluss-Halbleiterbauelements 59 führt.

Wie bei den in den Fig. 2 und 6 schematisch veranschaulichten Vorzerstörungsgebieten 75 zwischen den beiden Halbleiterübergängen ist auch bei dem Kurzschluss-Halbleiterbauelement 59 der Fig. 12 zu verstehen, dass die durch die Zündstrukturen 20 und/oder 60 bewirkte Vorzerstörung der Einschaltstruktur 30 stets räumlich von der jeweiligen Zündstruktur 20 bzw. 60 getrennt stattfindet (in radialer Richtung weiter außen). Dies stellt sicher, dass die Durchlegierung immer innerhalb des von der jeweiligen Elektrode (vorliegend 10) überdeckten (insbesondere gedrückten) Bereiches des Halbleiterkörpers 61 stattfindet. Um dies zu gewährleisten, kann der von der jeweiligen Zündstruktur 20 und/oder 60 erzeugte Zündstrom gegebenenfalls zusätzlich begrenzt sein, z. B. durch Vorsehen einer entsprechenden Widerstandszone, um eine Vorzerstörung infolge eines zu hohen Zündstroms im Gate-Bereich/Gate-Elektrode 20 bzw. Zentrum 13 sicher zu verhindern.

Bei dem in Fig. 12 gezeigten Fall der Kombination der beiden an bzw. in derselben Basiszone (hier vorderseitige Basiszone 8) angeordneten Zündstrukturen 20 und 60 ist zu verstehen, dass die Zünd- bzw. Eischaltempfindlichkeit der diesen beiden Zündstrukturen 20 und 60 zugeordneten und nachgeschalteten Einschaltstruktur (hier Emitterstruktur 30) an den von den Zündstrukturen 20 bzw. 60 zur Verfügung stellbaren Einschaltstrom angepasst ist, wobei der von einer Zündstruktur kleinste zur Verfügung stellbare Einschaltstrom ausschlaggebend ist. Mit anderen Worten ist die Einschaltstruktur 30 bei dem in Fig. 12 dargestellten Beispiel auf einen minimalen Einschaltstrom, ab dem die Einschaltstruktur 30 sicher einschaltet, aufgrund des Vorhandenseins der als Durchbruchstruktur 60 ausgebildeten Zündstruktur, die typischerweise Einschaltströme lediglich im mA-Bereich liefert, im Bereich von deutlich unter 1 A, bevorzugt etwa um 50 mA, ausgelegt, damit der von der Durchbruchstruktur 60 im Durchbruchfall erzeugte Sperrstrom die Einschaltstruktur 30 sicher einschalten bzw. vorzerstören kann, ohne hierbei selbst zerstört zu werden. Dies könnte nämlich passieren, wenn die Zünd- bzw. Einschaltempfindlichkeit der Einschaltstruktur 30 zu hoch gewählt würde. Dann ließe sich die Emitterstruktur 30 zwar durch ein externes, über die Gate-Elektrode 20 zugeführtes Einschaltsignal im Bereich von etwa 1 A zünden, aber die unter der Gate-Elektrode 20 angeordnete Durchbruchstruktur 60 würde hierbei zerstört werden, da diese bei einem über die Gate-Elektrode 20 eingeprägten Einschaltstrom von 1 A überlastet würde. Da sich die Zündstruktur 60 nicht im von der Elektrode 10 und der Kontaktscheibe 18 überdeckten Bereich des Halbleiterkörpers 61 befindet, könnte eine solche Zerstörung der Zündstruktur 60 einen Plasmaaustritt im Bereich des nicht überdeckten Zentrums 13 zur Folge haben, was jedoch durch die vorstehend beschriebene Auslegung der Einschaltstruktur 30 bzgl. ihrer Einschaltempfindlichkeit bei dem in Fig. 12 gezeigten Ausführungsbeispiel des Kurzschluss-Halbleiterbauelements 59 sicher verhindert wird.

Sofern beispielsweise prozesstechnisch die Ausbildung der Durchbruchstruktur 60 für ein bestimmtes zu erzielendes Sperrspannungsniveau (insbesondere z. B. für Durchbruchspannungen im kV-Bereich) des Kurzschluss-Halbleiterbauelements 59 nur unter besonders hohem technischen Aufwand oder nicht sicher herzustellen sein sollte, kann anstelle der in Fig. 12 gezeigten Durchbruchstruktur 60 des Halbleiterbauelements 59 auch eine wie z. B. in Fig. 4 gezeigte Durchbruchstruktur 31 verwendet werden. Wie dort bereits erläutert wurde, bietet diese Durchbruchstruktur 31 besonder Vorteile zum Einstellen auch sehr hoher Sperrspannungen/Durchbruchspannungen bis in den kV-Bereich.

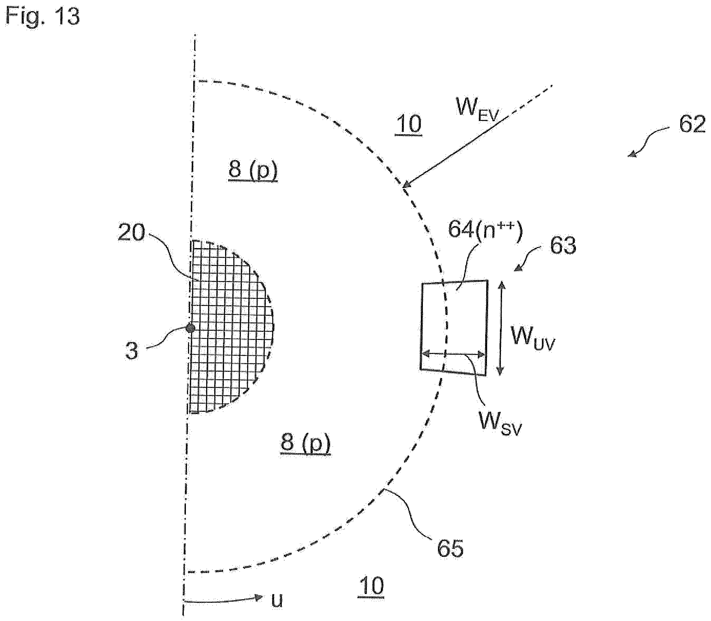

Fig. 13 stellt eine Teildraufsicht auf ein noch weiteres Ausführungsbeispiel eines Kurzschluss-Halbleiterbauelements 62 gemäß der Erfindung mit einer in einer Umfangsrichtung u des Halbleiterkörpers offenen, wenigstens ein Einschaltstruktursegment 64 (vorliegend ein Ringsegment) aufweisenden Einschaltstruktur 63 und einer Zündstruktur 20 dar. In der Draufsicht der Fig. 13 ist von dem Halbleiterkörper lediglich die vorderseitige Basiszone 8 zu erkennen. In der Darstellung der Fig. 13 ist die vorderseitige Elektrode 10 nicht dargestellt, sondern lediglich ihr radialer Innenrand 65, um die unter der Elektrode 10 angeordnete, als Emitterstruktur ausgebildete Einschaltstruktur 63 erkennen zu können. Es ist in Fig. 13 zu erkennen, dass die Emitterstruktur 63 bzw. das Emitterstruktursegment 64 in diesem Ausführungsbeispiel zur Zündstruktur bzw. Gate-Elektrode 20 einen radialen Abstand aufweist. Wie weiter zu erkennen ist, ist die Einschaltstruktur 63 in diesem Fall in Umfangsrichtung u des Halbleiterkörpers nicht geschlossen, das heißt die Einschaltstruktur 63 des in Fig. 13 gezeigten Kurzschluss-Halbleiterbauelements 62 weist keine geschlossene Ring- und/oder Polygonstruktur auf. Das Einschaltstruktursegment 64 weist die laterale Emitterstrukturweite Wsv und eine sich in Umfangsrichtung u erstreckende umfängliche Emitterstrukturweite Wuv auf. Die umfängliche Emitterstrukturweite Wuv ist kleiner als eine umfängliche Einschaltstrukturweite, die einer geschlossenen Ring- und/oder Polygonstruktur der Einschaltstruktur und damit einem Umfangswinkel der geschlossenen ring- und/oder polygonförmigen Einschaltstruktur von 360 Grad entsprechen würde.

Bei dem in Fig. 13 dargestellten Ausführungsbeispiel des Kurzschluss-Halbleiterbauelements 62 ist der Einschaltstrom zum Einschalten bzw. Vorzerstören der Einschaltstruktur 63 in einem Bereich um etwa 2 A, bevorzugt zwischen etwa 1 A und etwa 5 A festgelegt. Wsv kann nun so groß gewählt werden, damit die Einschaltstruktur 63 prozesstechnisch keine Probleme bereitet, also mit einer ausreichenden Weite Wsv realisiert werden kann. Wird W_{SV} zu klein gewählt, besteht das Problem, dass der radial innere Elektrodenrand 65 die hier hoch n-dotierte Emitterstruktur 64 nicht mehr sicher und nicht mehr genau genug abdeckt, wobei die umfängliche Strukturweite W_{UV} hierbei weniger kritisch ist. Mit dem in Fig. 13 gezeigten Ausführungsbeispiel lassen sich in besonders vorteilhafter Weise relativ kleine Aufschmelzströme aufgrund im Vergleich zu einer geschlossenen Ring- und/oder Polygonstruktur relativ kleiner Abmessungen W_{SV} und W_{UV} realisieren, wobei der zum Einschalten/Vorzerstören der Einschaltstruktur 63 erforderliche Einschaltstrom eher große Werte im Bereich von vorzugsweise etwa 1 A bis etwa 5 A mit den hierin bereits beschriebenen Vorteilen annehmen kann.

Es ist zu verstehen, dass ein wie in Fig. 13 dargestelltes Kurzschluss-Halbleiterbauelement 62 auch mehr als eine Einschaltstruktur 63 aufweisen kann, die dann in Umfangsrichtung u des Halbleiterkörpers verteilt angeordnet sind, vorzugsweise mit äquidistantem Abstand zueinander, um einen umfänglich im Wesentlichen symmetrischen Aufbau eines solchen Kurzschluss-Halbleiterbauelements mit den hierein bereits beschriebenen Vorteilen zu erzielen.

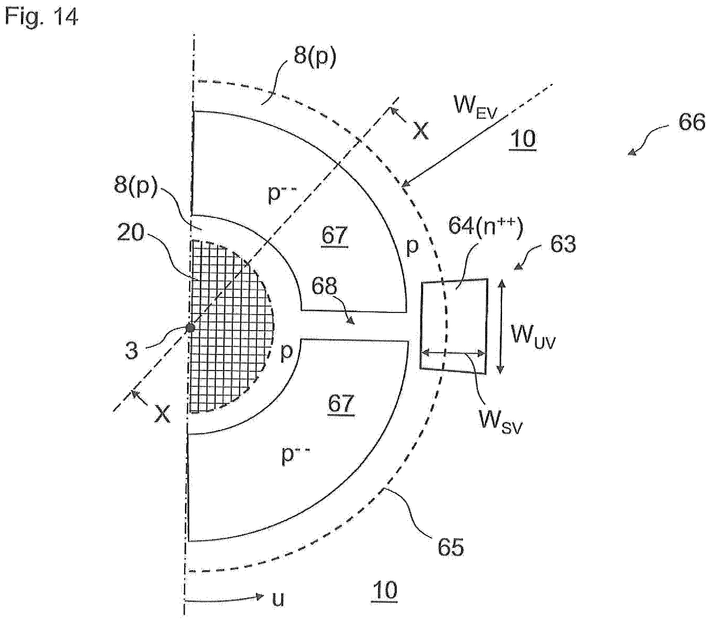

Fig. 14 stellt eine Teildraufsicht auf ein noch weiteres Ausführungsbeispiel eines Kurzschluss-Halbleiterbauelements 66 gemäß der Erfindung mit der bereits in Fig. 13 gezeigten, wenigstens ein Einschaltstruktursegment 64 (vorliegend ein Ringsegment) aufweisenden Einschaltstruktur 63 und einer Zündstruktur 20 dar. In der Darstellung der Fig. 14 ist die vorderseitige Elektrode 10 nicht dargestellt, sondern lediglich ihr radialer Innenrand 65, um die unter der Elektrode 10 angeordnete, als Emitterstruktur ausgebildete Einschaltstruktur 63 erkennen zu können.

Wie Fig. 14 zu entnehmen ist, ist bei dem Kurzschluss-Halbleiterbauelement 66 in der p-dotierten vorderseitigen Basiszone 8, in der die Einschaltstruktur 63 eingebettet ist, ein im Vergleich zu dem gewöhnlich p-dotierten Basiszonenbereich wesentlich niedriger p-dotierter p⁻⁻-Abschnitt 67 vorgesehen, der gegenüber dem Rest der Basiszone 8 einen deutlich höheren elektrischen Widerstand darstellt. Die Dotierstoffkonzentration dieses Widerstandsabschnitts 67 beträgt bevorzugte etwa 1E15 cm⁻³ bis etwa 1E16 cm⁻³ bei einer Eindringtiefe von bevorzugt etwa 60 bis 120 µm. Dieser Widerstandsabschnitt 67 weist dem Einschaltstruktursegment 64 gegenüberliegend einen Durchlasskanal 68 auf, der von dem gewöhnlich dotierten, restlichen p-Bereich der Basiszone 8 gebildet ist und das Einschaltstruktursegment 64 unmittelbar über den p-Bereich der Basiszone 8 elektrisch an die Zündstruktur bzw. Gate-Elektrode 20 ankoppelt.

Durch die in Fig. 14 gezeigte Ausgestaltung des Kurzschluss-Halbleiterbauelements 66 wird erreicht, dass einerseits sehr kleine zur Durchlegierung führende Aufschmelzströme durch die segmentartige Ausbildung der Einschaltstruktur 63 realisiert werden können, wie beispielsweise auch bei dem in Fig. 13 gezeigten Kurzschluss-Halbleiterbauelement 62, und andererseits der von der Zündstruktur 20 zur Einschaltstruktur 63 fließende Einschaltstrom gezielt auf das Einschaltstruktursegment 64 gelenkt wird, um dieses im Bedarfsfall zum Einleiten der Durchlegierung sicher einzuschalten bzw. zu zerstören. Hierdurch ist die gezielte Auslegung des Kurzschluss-Halbleiterbauelements 66 mit Einschaltströmen möglich, die, anders als bei dem in Fig. 13 gezeigte Kurzschluss-Halbleiterbauelement 62, im mA-Bereich liegen, zum Beispiel bei etwa 150 mA.

Der Kanal 68 kann übrigens unterschiedliche Formen annehmen, zum Beispiel auch eine Trapezform, bei der sich der Kanal 68 ausgehend von der Zündstruktur 20 hin zum Einschaltstruktursegment 64 verjüngt, um eine noch gezieltere Lenkung des durch diesen Kanal 68 fließenden Einschaltstroms auf das Einschaltstruktursegment 64 zu erreichen und damit den am Einschaltstruktursegment 64 vorbeifließenden Einschaltstrom so gering wie möglich zu halten.

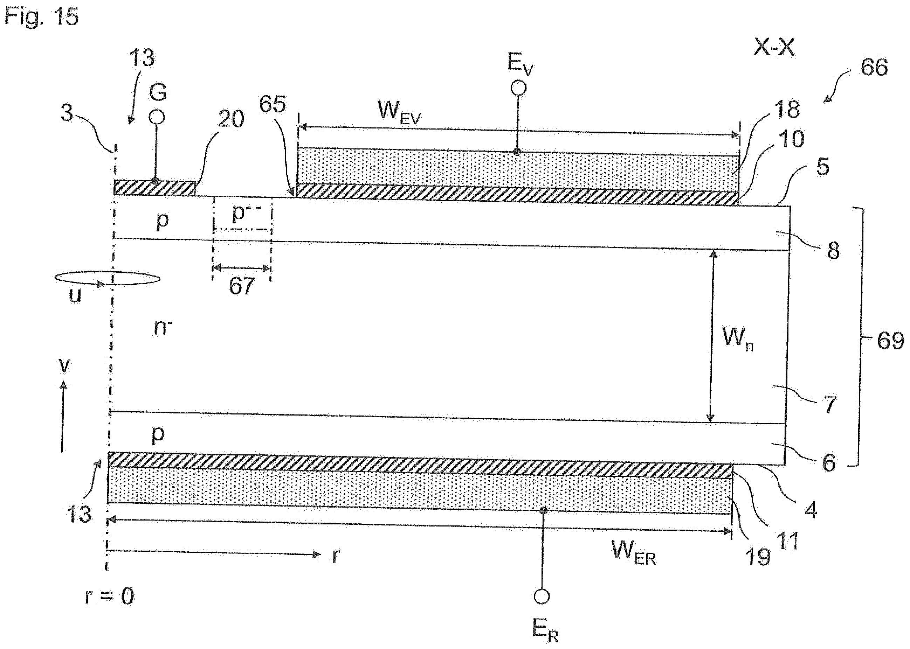

Fig. 15 zeigt einen Vertikalschnitt durch das in Fig. 14 dargestellte Kurzschluss-Halbleiterbauelement 66 entlang der in Fig. 14 dargestellten Schnittlinie X-X. Es ist zu erkennen, dass sich in einem Halbleiterkörper 69, insbesondere in der vorderseitigen p-dotierten Basiszone 8, der p⁻⁻-Widerstandsabschnitt 67 lateral zwischen der Zündstruktur bzw. Gate-Elektrode 20 und dem Innenrand 65 der vorderseitigen Elektrode 10 erstreckt. Das Einschaltstruktursegment 64 ist in dem Vertikalschnitt X-X nicht zu erkennen.

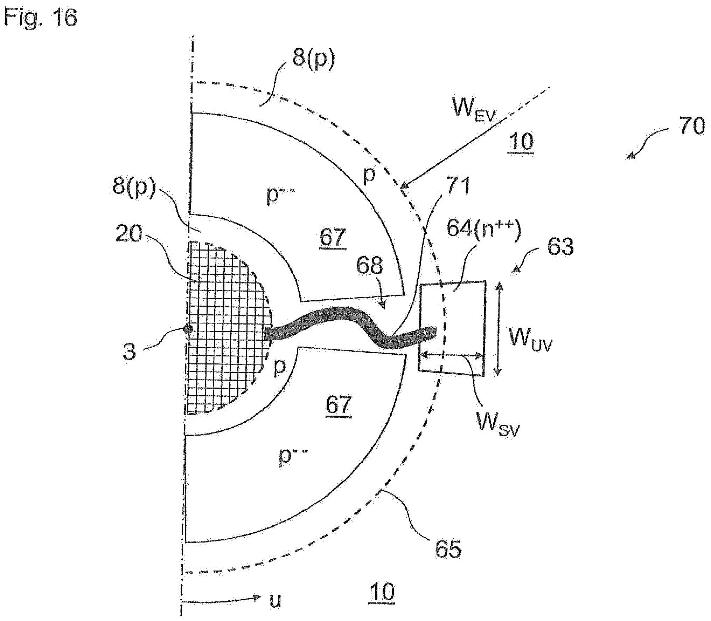

Fig. 16 stellt eine Teildraufsicht auf ein noch weiteres Ausführungsbeispiel eines Kurzschluss-Halbleiterbauelements 70 gemäß der Erfindung dar, das im Wesentlichen dem Ausführungsbeispiel des in Fig. 14 gezeigten Kurzschluss-Halbleiterbauelements 66 entspricht, wobei das Einschaltstruktursegment 64 des Kurzschluss-Halbleiterbauelements 70 in Fig. 16 über einen Shuntwiderstand 71 in Form eines im Kanal 68 angeordneten n-dotierten (z. B. mit Phosphor dotierten) Gebietsstreifens elektrisch direkt mit der Zündstruktur bzw. Gate-Elektrode 20 verbunden ist. Die Breite dieses Shuntwiderstands 71 kann vorzugsweise auf etwa 55 µm festgelegt sein. Auf diese Weise lässt sich der erforderliche Einschaltstrom zum Einschalten/Vorzerstören der Einschaltstruktur 63 gegenüber dem Kurzschluss-Halbleiterbauelement 66 der Fig. 14 wieder etwas anheben, zum Beispiel auf etwa 400 mA und bevorzugt in einen Bereich von etwa 400 mA bis etwa 1000 mA, bei ansonsten gleichen Abmessungen,

Die in Fig. 16 dargestellte Schlangenform des Shuntwiderstands 71 erlaubt es, eine Länge des Shuntwiderstands 71 in gewünschter Weise zu variieren, um hierdurch den Einschaltstrom in dem vorstehend genannten Bereich nahezu beliebig einzustellen. Die Länge des in Fig. 15 dargestellten schlangenförmigen Shuntwiderstands 71 innerhalb des Kanals 68 kann zum Beispiel auf einen Wert aus einem Bereich um etwa 200 µm, also zum Beispiel etwa 150 µm bis etwa 250 µm, festgelegt werden.

Der Shuntwiderstand 71 ist mit seinem radial inneren Ende elektrisch direkt mit der Gate-Elektrode 20 kontaktiert. Bei dem in Fig. 16 gezeigten Kurzschluss-Halbleiterbauelement 70 mündet das gegenüberliegende, radial äußere Ende des Shuntwiderstands 71 direkt in das Emitterstruktursegment 64.

Der Shuntwiderstand 71 könnte anstelle der in Fig. 16 gezeigten Anordnung im Durchlasskanal 68 auch über den Widerstandsabschnitt 67 gelegt sein. In diesem Fall wäre das radial äußere Ende des Shuntwiderstands 71 elektrisch direkt mit der vorderseitigen Elektrode 10, zum Beispiel am Elektrodenrand 65, kontaktiert.

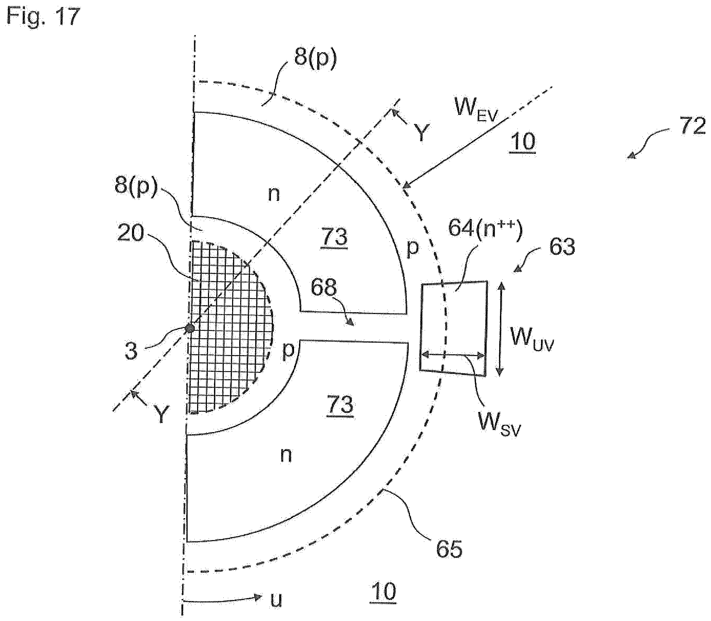

Fig. 17 stellt eine Teildraufsicht auf ein noch weiteres Ausführungsbeispiel eines Kurzschluss-Halbleiterbauelements 72 gemäß der Erfindung mit einer in einer Umfangsrichtung u des Halbleiterkörpers offenen, wenigstens ein Einschaltstruktursegment 64 (vorliegend ein Ringsegment) aufweisenden Einschaltstruktur 63 und einer Zündstruktur 20 dar. Die Darstellung der Fig. 17 entspricht im Wesentlichen der Darstellung der Fig. 14 mit der Ausnahme, dass bei dem in Fig. 17 dargestellten Kurzschluss-Halbleiterbauelement 72 in die p-dotierte vorderseitige Basiszone 8 ein n-dotierter Widerstandsabschnitt 73 eingebracht ist, der auch als Pinch-Widerstand 73 bezeichnet wird,

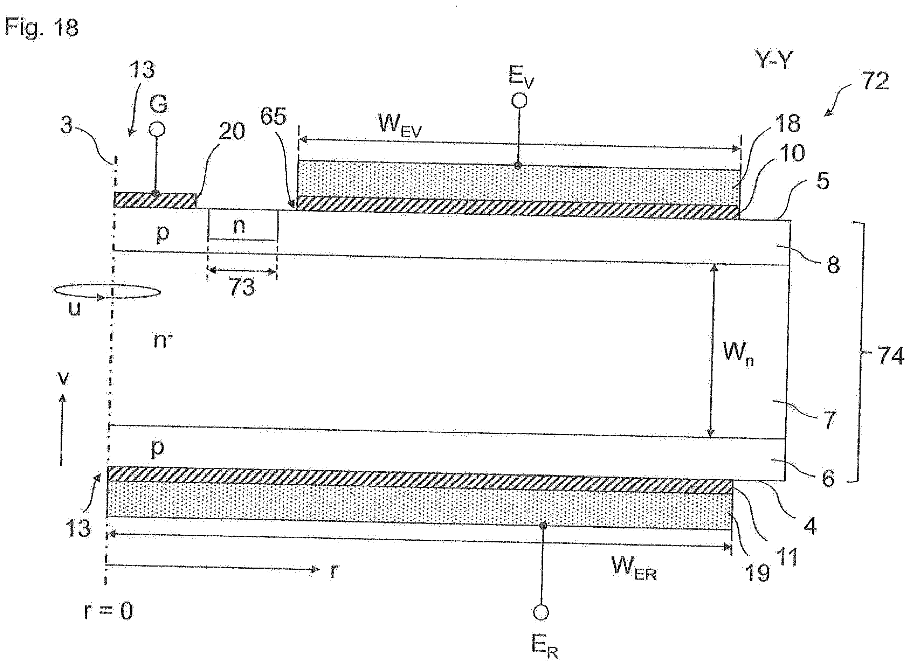

Fig. 18 zeigt einen Vertikalschnitt durch das in Fig. 17 dargestellte Kurzschluss-Halbleiterbauelement 72 entlang der in Fig. 17 dargestellten Schnittlinie Y-Y. In dieser Ansicht ist zu erkennen, dass der Widerstandsabschnitt 73 durch einen Pinch-Widerstand gebildet ist, der als in einem Halbleiterkörper 74 und speziell in der vorderseitigen Basiszone 8 von der Vorderseite 5 und an diese angrenzend eingebrachtes n-Gebiet den wirksamen Leitungsquerschnitt der vorderseitigen Basiszone 8 zwischen der Zündstruktur 20 und der vorderseitigen Elektrode 10 deutlich verringert, wodurch der Pinch-Widerstand 73 eine Erhöhung des flächenspezifischen Widerstands in diesem Bereich der Basiszone 8 bewirkt. Die Auswirkungen dieser Widerstandserhöhung sind bereits vorstehend zu den Fig. 14 bis 16 beschrieben worden.

Es ist zu verstehen, dass die im Zusammenhang mit den Fig. 13 bis 18 beschrienen Ausgestaltungen der Einschaltstruktur 63 mit einzelnen Einschaltstruktursegmenten 64 in Kombination mit der lokalen Widerstandserhöhung in der Basiszone 8 zwischen der Zündstruktur 20 und dem Einschaltstruktursegment 64 mit allen anderen hierin beschriebenen Einschaltstrukturen und/oder Zündstrukturen beliebig kombinierbar sind und damit weitere, in den Figuren nicht dargestellte vorteilhafte Ausgestaltungen der Erfindung beinhalten. So können beispielsweise auch zwei radial zueinander beabstandete, elektrisch voneinander isolierte Einschaltstrukturen vorgesehen sein, zum Beispiel wenigstens ein wie in den Fig. 13 bis 18 gezeigtes Einschaltstruktursegment 63, das von einer radial weiter außen angeordneten, ring- und/oder polygonförmig geschlossenen, verfingerten Einschaltstruktur, beispielsweise ähnlich der in Fig. 3 gezeigten, umgeben ist. Hierdurch lässt sich in vorteilhafter Weise der nach dem Einschalten des Kurzschluss-Halbleiterbauelements entstehende durchlegierte Bereich innerhalb des von der vorder- und/oder rückseitigen Elektrode überdeckten Bereichs des Halbleiterkörpers in radialer Richtung mit den hierin bereits beschriebenen Vorteilen aufweiten.

Das vorstehend beschriebene erfindungsgemäße Kurzschluss-Halbleiterbauelement ist nicht auf die hierin offenbarten Ausführungsformen beschränkt, sondern umfasst auch gleich wirkende weitere Ausführungsformen, die sich aus technisch sinnvollen weiteren Kombinationen der hierin beschriebenen Merkmale des Kurzschluss-Halbleiterbauelements ergeben. Insbesondere ist auch eine zur in den Ausführungsbeispielen gezeigten pnp-Struktur des Halbleiterkörpers inverse npn-Schichtenfolge denkbar. In diesem Fall besteht die schwach n-dotierte Halbleiterinnenzone aus einer schwach p-dotierten Innenzone und die vorder- und rückseitigen Basiszonen jeweils aus einer n-dotierten Schicht usw. Die Leitungstypen der hierin beschriebenen Einschaltstrukturen wären in einem solchen Fall ebenfalls entsprechend zu invertieren.

In bevorzugter Ausführung wird das erfindungsgemäße Kurzschluss-Halbleiterbauelement als Berührschutz bzw. Personenschutz sowie zum Anlagenschutz verwendet.

### Bezugszeichenliste:

- 1: Thyristor nach Stand der Technik
- 2: Halbleiterkörper
- 3: Mittelachse
- 4: Rückseite
- 5: Vorderseite
- 6: Rückseitige Basiszone
- 7: Innenzone
- 8: Vorderseitige Basiszone
- 9: Vorderseitiger Emitter
- 10: Vorderseitige Elektrode
- 11: Rückseitige Elektrode
- 12: Kurzschluss
- 13: Vorder- und rückseitiges Zentrum
- 14: Gate-Elektrode
- 15: Kurzschluss-Halbleiterbauelement
- 16: Halbleiterkörper
- 17: Vorderseitige Einschaltstruktur / Emitterstruktur
- 18: Vorderseitige Kontaktscheibe
- 19: Rückseitige Kontaktscheibe
- 20: Zündstruktur, Gate-Elektrode
- 21: Durchlegierung
- 22: Kurzschluss-Halbleiterbauelement
- 23: Verringerte Einschaltstruktur / Emitterstruktur
- 24: Vorderseitige Elektrode
- 25: Halbleiterkörper
- 26: Zündstruktur, Gate-Elektrode
- 27: Zündstrukturfinger / Gate-Finger
- 28: Einschaltstrukturfinger von 23
- 29: Kurzschluss-Halbleiterbauelement
- 30: Vorderseitige Einschaltstruktur / Emitterstruktur
- 31: Rückseitige Einschaltstruktur / Durchbruchstruktur
- 32: Halbleiterkörper
- 33: Kritischer Krümmungsradius
- 34: Kurzschluss-Halbleiterbauelement
- 35: Vorderseitige Einschaltstruktur / Emitterstruktur
- 36: Rückseitige Einschaltstruktur / Emitterstruktur
- 37: Vorderseitige Zündstruktur / Gate-Elektrode
- 38: Rückseitige Zündstruktur / Gate-Elektrode
- 39: Halbleiterkörper
- 40 41 42 43 44 45: Kurzschluss-Halbleiterbauelement
- 46: Rückseitige Einschaltstruktur / Emitterstruktur
- 47: Rückseitige Zündstruktur / Durchbruchstruktur
- 48: Halbleiterkörper
- 49 50 51 52: Kurzschluss-Halbleiterbauelement
- 53: Vorderseitige Einschaltstruktur / Emitterstruktur
- 54: Vorderseitige Zündstruktur / Durchbruchstruktur
- 55: Halbleiterkörper
- 56: Kurzschluss-Halbleiterbauelement
- 57: Rückseitige Einschaltstruktur / Durchbruchstruktur
- 58: Halbleiterkörper
- 59: Kurzschluss-Halbleiterbauelement
- 60: Vorderseitige Zündstruktur / Durchbruchstruktur
- 61: Halbleiterkörper
- 62: Kurzschluss-Halbleiterbauelement
- 63: Vorderseitige Einschaltstruktur / Emitterstruktur
- 64: Einschaltstruktursegment / Emitterstruktursegment
- 65: Radialer Innenrand
- 66: Kurzschluss-Halbleiterbauelement
- 67: Widerstandsabschnitt
- 68: Durchlasskanal
- 69: Halbleiterkörper
- 70: Kurzschluss-Halbleiterbauelement
- 71: Shunt-Widerstand
- 72: Kurzschluss-Halbleiterbauelement
- 73: Widerstandsabschnitt / Pinch-Widerstand
- 74: Halbleiterkörper
- 75: Vorzerstörung zwischen erstem und zweitem Halbleiterübergang
- 76: Kurzschluss-Halbleiterbauelement
- 77: Halbleiterkörper
- 78: Isolatorschicht
- 79: Elektrischer Schalter
- 80: Parasitärer Widerstand bzw. Induktivität im Gate-Kreis
- A: Anodenanschluss
- AI: Aluminium
- C: Kondensator
- Dₐ: Außendurchmesser einer BOD-Struktur
- Dₐ∗: Außendurchmesser einer BOD-Struktur
- D_{I}: Innendurchmesser einer BOD-Struktur
- Dᵢ∗: Innendurchmesser einer BOD-Struktur
- Eᵥ: Vorderseitiger Elektrodenanschluss
- E_{R}: Rückseitiger Elektrodenanschluss
- G: Gate-Anschluss
- G_{V}: Vorderseitiger Gate-Anschluss
- G_{R}: Rückseitiger Gate-Anschluss
- K: Kathodenanschluss
- L_{SF}: Radiale Fingerlänge der Einschaltstruktur
- N: Dotierstoffkonzentration
- Na: Konzentrationsverlaufslinie (a)
- Nb: Konzentrationsverlaufslinie (b)
- Nc: Konzentrationsverlaufslinie (c)
- r: Radiale/laterale Richtung
- R: Begrenzungswiderstand
- u: Umfangsrichtung
- v: Vertikale Richtung
- x: Eindringtiefe
- W_{E1}: Laterale Elektrodenweite nach Stand der Technik
- W_{ER}: Laterale rückseitige Elektrodenweite
- W_{EV}: Laterale vorderseitige Elektrodenweite
- Wₙ: Dicke der Innenzone
- Wₙ₁: Dicke der Innenzone nach Stand der Technik
- W_{S1}: Laterale Emitterweite nach Stand der Technik
- W_{SR}: Laterale rückseitige Einschaltstrukturweite
- Wsv: Laterale vorderseitige Einschaltstrukturweite
- Wuv: Umfängliche vorderseitige Einschaltstrukturweite
- X-X: Schnittlinie Vertikalschnitt
- Y-Y: Schnittlinie Vertikalschnitt

## Patentansprüche

1. Kurzschluss-Halbleiterbauelement aufweisend einen Halbleiterkörper (16, 25, 32, 39, 48, 55, 58, 61, 69, 74, 77), in dem in einer vertikalen Richtung (v) ausgehend von einer Rückseite (4) mit einem durch ihren geometrischen Schwerpunkt festgelegten rückseitigen Zentrum (13) hin zu einer der Rückseite (4) gegenüberliegenden Vorderseite (5) mit einem durch ihren geometrischen Schwerpunkt festgelegten vorderseitigen Zentrum (13) eine rückseitige Basiszone (6) von einem ersten Leitungstyp (p), eine Innenzone (7) von einem zum ersten Leitungstyp (p) komplementären zweiten Leitungstyp (n) und eine vorderseitige Basiszone (8) vom ersten Leitungstyp (p) aufeinanderfolgend angeordnet sind, wobei die rückseitige Basiszone (6) mit einer auf der Rückseite (4) aufgebrachten rückseitigen Elektrode (11) mit einer durch ihre laterale Erstreckung gegebenen lateralen rückseitigen Elektrodenweite (W_{ER}) elektrisch leitend verbunden ist und die vorderseitige Basiszone (8) mit einer auf der Vorderseite (5) aufgebrachten vorderseitigen Elektrode (10) mit einer durch ihre laterale Erstreckung gegebenen lateralen vorderseitigen Elektrodenweite (W_{EV}) elektrisch leitend verbunden ist, wobei in die vorderseitige Basiszone (8) wenigstens eine vorderseitige Einschaltstruktur (17, 23, 30, 35, 53, 63) eingebettet und von der vorderseitigen Elektrode (10) wenigstens teilweise überdeckt ist und/oder in die rückseitige Basiszone (6) wenigstens eine rückseitige Einschaltstruktur (31, 36, 46, 57) eingebettet und von der rückseitigen Elektrode (11) wenigstens teilweise überdeckt ist, wobei die jeweilige Einschaltstruktur (17, 23, 30, 31, 35, 36, 46, 53, 63) eine mit der auf diese jeweils einbettenden Basiszone (6, 8) aufgebrachten Elektrode (10, 11) elektrisch leitend kontaktierte Emitterstruktur (17, 23, 30, 35, 36, 46, 53, 63) vom zweiten Leitungstyp (n) ist, die mittels wenigstens einer auf diese elektrisch über den Halbleiterkörper (16, 25, 32, 39, 48, 55, 58, 61, 69, 74, 77) einwirkenden Zündstruktur (20, 26, 37, 38, 47, 54, 60) einschaltbar ist, die wiederum mittels eines ihr zugeführten elektrischen Einschaltsignals aktivierbar ist,
**dadurch gekennzeichnet, dass**
die Zündstruktur (20, 26, 37, 38, 47, 54, 60) derart ausgebildet und angeordnet ist, dass sie in ihrem aktivierten Zustand durch die Injektion eines elektrischen Stromstoßes mit einem vorbestimmten Energieeintrag in den Halbleiterkörper (16, 25, 32, 39, 48, 55, 58, 61, 69, 74, 77) zwischen die Zündstruktur (20, 26, 37, 38, 47, 54, 60) und die vorderseitige und/oder rückseitige Einschaltstruktur (17, 23, 30, 35, 36, 46, 53, 63) eine Vorzerstörung herbeiführt, wobei der elektrische Stromstoß einen zwischen der jeweiligen Einschaltstruktur (17, 23, 30, 35, 36, 46, 53, 63) und diese einbettenden Basiszone (6, 8) gebildeten ersten Halbleiterübergang und/oder einen zwischen dieser Basiszone (6, 8) und der Innenzone (7) gebildeten zweiten Halbleiterübergang irreversibel zerstört, und wobei der Halbleiterkörper (16, 25, 32, 39, 48, 55, 58, 61, 69, 74, 77) im Anschluss an die Vorzerstörung durch einen über die vorderseitige Elektrode (10) und die rückseitige Elektrode (11) fließenden Strom derart zerstört wird, dass sich eine Durchlegierung (21) zwischen der vorderseitigen Elektrode (10) und der rückseitigen Elektrode (20) bildet.

2. Kurzschluss-Halbleiterbauelement nach Anspruch 1,
wobei der Energieeintrag in einem Bereich zwischen 1 Ws bis 3 Ws vorbestimmt ist.

3. Kurzschluss-Halbleiterbauelement nach Anspruch 1 oder 2,
wobei der Halbleiterkörper (16, 25, 32, 39, 48, 55, 58, 61, 69, 74, 77) in einem zwischen der Zündstruktur (20, 26, 37, 38, 47, 54, 60) und der vorderseitigen und/oder rückseitigen Einschaltstruktur (17, 23, 30, 35, 36, 46, 53, 63) liegenden Bereich, in den der Stromstoß injiziert wird, in radialer Richtung (r) einen Widerstand kleiner als 10 Ω aufweist.

4. Kurzschluss-Halbleiterbauelement nach einem der vorhergehenden Ansprüche,
wobei die vorderseitige Einschaltstruktur (17, 23, 30, 35, 53, 63) eine durch ihre laterale Erstreckung gegebene laterale vorderseitige Einschaltstrukturweite (W_{SV}) aufweist und die rückseitige Einschaltstruktur (31, 36, 46, 57) eine durch ihre laterale Erstreckung gegebene laterale rückseitige Einschaltstrukturweite (W_{SR}) aufweist, wobei das Verhältnis der lateralen Einschaltstrukturweite (W_{SV}, W_{SR}) zur entsprechenden lateralen Elektrodenweite (W_{EV}, W_{ER}) der jeweiligen, die entsprechende Einschaltstruktur kontaktierende Elektrode (10, 11) kleiner als 1 ist, bevorzugt kleiner als 4/5, bevorzugter kleiner als 3/4, noch bevorzugter kleiner als 2/3 und weiterhin bevorzugter kleiner als 1/2.

5. Kurzschluss-Halbleiterbauelement nach einem der vorhergehenden Ansprüche,
wobei die Einschaltstruktur (31, 46, 53, 57) vollständig von der vorderseitigen Elektrode (10) und der rückseitigen Elektrode (11) überdeckt ist.

6. Kurzschluss-Halbleiterbauelement nach einem der vorhergehenden Ansprüche,
wobei die Einschaltstruktur (31, 46, 53, 57) an ihrer sie in radialer Richtung (r) außen begrenzenden Außenseite von der sie kontaktierenden Elektrode (10, 11) um wenigstens 5 mm in radialer Richtung (r) überdeckt ist.

7. Kurzschluss-Halbleiterbauelement nach einem der vorhergehenden Ansprüche,
wobei die vorderseitige Elektrode (10) und die rückseitige Elektrode (11) das vorderseitige beziehungsweise rückseitige Zentrum (13) des Halbleiterkörpers (16, 25, 32, 39, 48, 55, 58, 61, 69, 74) überdecken und die Einschaltstruktur (17, 23, 30, 31, 35, 36, 46, 53, 57, 63) in dem entsprechenden Zentrum (13) angeordnet ist.

8. Kurzschluss-Halbleiterbauelement nach einem der vorhergehenden Ansprüche,
wobei eine elektrisch isolierende Isolatorschicht (78) zwischen der Einschaltstruktur (17, 23, 30, 31, 35, 36, 46, 53, 57, 63) und der diese elektrisch leitend kontaktierenden Elektrode (10, 11) angeordnet ist, wobei sich die Isolatorschicht (78) in radialer Richtung (r) über diese Einschaltstruktur (17, 23, 30, 31, 35, 36, 46, 53, 57, 63) erstreckt und in Umfangsrichtung (u) entlang einem in radialer Richtung (r) innen liegenden Innenrand dieser Elektrode (10, 11) erstreckt.

9. Kurzschluss-Halbleiterbauelement nach dem vorhergehenden Anspruch,
wobei die Isolatorschicht (78) eine Dicke von wenigstens 10 nm bis höchstens 100 nm aufweist, bevorzugter von wenigstens 50 nm bis höchstens 100 nm.

10. Kurzschluss-Halbleiterbauelement nach einem der beiden vorhergehenden Ansprüche,
wobei die Isolatorschicht (78) ein Siliziumoxidschicht ist.

11. Kurzschluss-Halbleiterbauelement nach einem der drei vorhergehenden Ansprüche,
wobei die Isolatorschicht (78) in radialer Richtung (r) zueinander beabstandete Öffnungen aufweist, die eine direkte elektrisch leitende Verbindung zwischen der Elektrode (10, 11) und der an dieser anliegenden Basiszone (6, 8) herstellen.

12. Kurzschluss-Halbleiterbauelement nach einem der vorhergehenden Ansprüche,
wobei die Zündstruktur eine Gate-Elektrode (20, 26, 37, 38) ist und das Einschaltsignal der von der Zündstruktur (20, 26, 37, 38) in den Halbleiterkörper (16, 25, 32, 39, 48, 55, 58, 61, 69, 74, 77) injizierte Stromstoß ist.

13. Kurzschluss-Halbleiterbauelement nach dem vorhergehenden Anspruch,
wobei ein Kondensator (C) mit einer dem vorbestimmten Energieeintrag entsprechend vorbestimmten Kapazität vorgesehen ist, der das Einschaltsignal in einem aufgeladenen Zustand bereitstellt, wobei der Kondensator (C) mittels eines elektronischen Schalters (79) elektrisch zwischen die Gate-Elektrode (20, 26, 37, 38) und die vorderseitige Elektrode (10) und/oder die rückseitige Elektrode (11) schaltbar ist.

14. Kurzschluss-Halbleiterbauelement nach einem der beiden vorhergehenden Ansprüche,
wobei die Gate-Elektrode (20, 26, 37, 38) auf ihrer in vertikaler Richtung (v) außen liegenden metallischen Kontaktseite mit einer Silberschicht beschichtet ist.

15. Kurzschluss-Halbleiterbauelement nach einem der vorhergehenden Ansprüche,
wobei die Zündstruktur eine Durchbruchstruktur (47, 54, 60) ist und das Einschaltsignal die zwischen der vorderseitigen Elektrode (10) und der rückseitigen Elektrode (11) anliegende elektrische Spannung ist.

16. Kurzschluss-Halbleiterbauelement nach einem der vorhergehenden Ansprüche,
wobei die Einschaltstruktur (17, 23, 30, 35, 36, 46, 53, 63) in radialer Richtung (r) von der Zündstruktur (20, 26, 37, 38, 60) beabstandet ist und wenigstens ein Einschaltstruktursegment (64) mit einer in einer Umfangsrichtung (u) des Halbleiterkörpers (16, 25, 32, 39, 48, 55, 58, 61, 69, 74) verlaufenden Einschaltstrukturweite (W_{UV}) aufweist, die überall kleiner ist als eine durch das Einschaltstruktursegment (64) in Umfangsrichtung (u) um das Zentrum (13) verlaufende geschlossene Umfangslänge.

17. Kurzschluss-Halbleiterbauelement nach dem vorhergehenden Anspruch,
wobei in Umfangsrichtung (u) des Halbleiterkörpers (16, 25, 32, 39, 48, 55, 58, 61, 69, 74) wenigstens zwei voneinander getrennte Einschaltstruktursegmente (64) vorgesehen sind.

18. Kurzschluss-Halbleiterbauelement nach einem der beiden vorhergehenden Ansprüche,
wobei der elektrische Widerstand in der die Einschaltstruktur (17, 23, 30, 35, 36, 46, 53, 63) enthaltenden Basiszone (6, 8) wenigstens in einem Abschnitt (67, 73) des radialen Zwischenraums zwischen der Einschaltstruktur (17, 23, 30, 35, 36, 46, 53, 63) und der Zündstruktur (20, 26, 37, 38, 60) mit Ausnahme wenigstens eines das wenigstens eine der Einschaltstruktursegmente (64) mit der Zündstruktur (20, 26, 37, 38, 60) elektrisch koppelnden Durchgangskanals (67) erhöht ist.

19. Kurzschluss-Halbleiterbauelement nach einem der vorhergehenden Ansprüche,
wobei ein Bereich der die Einschaltstruktur (17, 23, 30, 35, 36, 46, 53, 63) einbettenden Basiszone (6, 8) zwischen der Zündstruktur (20, 26, 37, 38, 47, 54, 60) und der jeweiligen Einschaltstruktur (17, 23, 30, 35, 36, 46, 53, 63) derart ausgebildet ist, dass die Einschaltstruktur (17, 23, 30, 35, 36, 46, 53, 63) mittels der Zündstruktur (20, 26, 37, 38, 47, 54, 60) mit einem Übersteuerungsfaktor von höchstens 10, bevorzugt höchstens 5, noch bevorzugter höchstens 3, einschaltbar ist, wobei ein das Einschalten der Einschaltstruktur (17, 23, 30, 35, 36, 46, 53, 63) bewirkender Mindesteinschaltstrom wenigstens 1 A, bevorzugt wenigstens 2 A und noch bevorzugter zwischen wenigstens 5 A und höchstens 10 A beträgt.

20. Kurzschluss-Halbleiterbauelement nach einem der vorhergehenden Ansprüche,
wobei eine Dicke (Wₙ) der Innenzone (7) in vertikaler Richtung (v) größer als 400 µm, bevorzugter größer als 600 µm, noch bevorzugter größer als 800 µm und weiter bevorzugt größer als 1000 µm ist.

21. Kurzschluss-Halbleiterbauelement nach einem der vorhergehenden Ansprüche,
wobei eine Dicke der vorderseitigen Basiszone (8) und/oder der rückseitigen Basiszone (6) in vertikaler Richtung (v) wenigstens 50 µm beträgt.

22. Kurzschluss-Halbleiterbauelement nach einem der vorhergehenden Ansprüche,
wobei die vorderseitige Elektrode (10) und die rückseitige Elektrode (11) jeweils mittels einer metallischen Kontaktscheibe (18, 19) elektrisch leitend druckkontaktiert sind.

23. Kurzschluss-Halbleiterbauelement nach dem vorhergehenden Anspruch,
wobei die laterale Weite der jeweiligen Kontaktscheibe (18, 19) der lateralen Elektrodenweite (W_{EV}, W_{ER}) der entsprechenden druckkontaktieren Elektrode (10, 11) entspricht.

24. Verfahren zum Betreiben eines Kurzschluss-Halbleiterbauelements (15, 22, 29, 34, 45, 52, 56, 59, 62, 66, 70, 72), das einen Halbleiterkörper (16, 25, 32, 39, 48, 55, 58, 61, 69, 74) aufweist, in dem in einer vertikalen Richtung (v) ausgehend von einer Rückseite (4) mit einem durch ihren geometrischen Schwerpunkt festgelegten rückseitigen Zentrum (13) hin zu einer der Rückseite (4) gegenüberliegenden Vorderseite (5) mit einem durch ihren geometrischen Schwerpunkt festgelegten vorderseitigen Zentrum (13) eine rückseitige Basiszone (6) von einem ersten Leitungstyp (p), eine Innenzone (7) von einem zum ersten Leitungstyp (p) komplementären zweiten Leitungstyp (n) und eine vorderseitige Basiszone (8) vom ersten Leitungstyp (p) aufeinanderfolgend angeordnet sind, wobei die rückseitige Basiszone (6) mit einer auf der Rückseite (4) aufgebrachten rückseitigen Elektrode (11) mit einer durch ihre laterale Erstreckung gegebenen lateralen rückseitigen Elektrodenweite (W_{ER}) elektrisch leitend verbunden ist und die vorderseitige Basiszone (8) mit einer auf der Vorderseite (5) aufgebrachten vorderseitigen Elektrode (10) mit einer durch ihre laterale Erstreckung gegebenen lateralen vorderseitigen Elektrodenweite (W_{EV}) elektrisch leitend verbunden ist, wobei in die vorderseitige Basiszone (8) wenigstens eine vorderseitige Einschaltstruktur (17, 23, 30, 35, 53, 63) eingebettet und von der vorderseitigen Elektrode (10) wenigstens teilweise überdeckt ist und/oder in die rückseitige Basiszone (6) wenigstens eine rückseitige Einschaltstruktur (31, 36, 46, 57) eingebettet und von der rückseitigen Elektrode (11) wenigstens teilweise überdeckt ist, wobei die jeweilige Einschaltstruktur (17, 23, 30, 35, 36, 46, 53, 63) eine mit der auf diese jeweils einbettenden Basiszone (6, 8) aufgebrachten Elektrode (10, 11) elektrisch leitend kontaktierte Emitterstruktur (17, 23, 30, 35, 36, 46, 53, 63) vom zweiten Leitungstyp (n) ist, die mittels wenigstens einer auf diese elektrisch über den Halbleiterkörper (16, 25, 32, 39, 48, 55, 58, 61, 69, 74) einwirkenden Zündstruktur (20, 26, 37, 38, 47, 54, 60) einschaltbar ist, die wiederum mittels eines ihr zugeführten elektrischen Einschaltsignals aktivierbar ist,
**dadurch gekennzeichnet, dass**
durch Aktivieren der Zündstruktur (20, 26, 37, 38, 47, 54, 60) mittels des Einschaltsignals eine Vorzerstörung herbeigeführt wird, indem ein elektrischer Stromstoß mit einem vordefinierten Energieeintrag in den Halbleiterkörper (16, 25, 32, 39, 48, 55, 58, 61, 69, 74) zwischen die Zündstruktur (20, 26, 37, 38, 47, 54, 60) und die vorderseitige und/oder rückseitige Einschaltstruktur (17, 23, 30, 35, 36, 46, 53, 63) derart injiziert wird, dass durch den elektrischen Stromstoß ein zwischen der jeweiligen Einschaltstruktur (17, 23, 30, 35, 36, 46, 53, 63) und diese einbettenden Basiszone (6, 8) gebildeter erster Halbleiterübergang und/oder ein zwischen dieser Basiszone (6, 8) und der Innenzone (7) gebildeter zweiter Halbleiterübergang irreversibel zerstört werden, wobei der Halbleiterkörper (16, 25, 32, 39, 48, 55, 58, 61, 69, 74, 77) im Anschluss an die Vorzerstörung durch einen über die vorderseitige Elektrode (10) und die rückseitige Elektrode (11) fließenden Strom derart zerstört wird, dass sich eine Durchlegierung (21) zwischen der vorderseitigen Elektrode (10) und der rückseitigen Elektrode (20) bildet.

## Claims

1. Short-circuit semiconductor component comprising a semiconductor body (16, 25, 32, 39, 48, 55, 58, 61, 69, 74, 77), in which a rear-side base zone (6) of a first conduction type (p), an inner zone (7) of a second conduction type (n) complementary to the first conduction type (p), and a front-side base zone (8) of the first conduction type (p) are arranged successively in a vertical direction (v) proceeding from a rear side (4) with a rear-side centre (13) defined by its geometric centroid towards a front side (5), situated opposite the rear side (4), with a front-side centre (13) defined by its geometric centroid, wherein the rear-side base zone (6) is electrically conductively connected to a rear-side electrode (11), applied on the rear side (4), with a lateral rear-side electrode width (W_{ER}) given by its lateral extent, and the front-side base zone (8) is electrically conductively connected to a front-side electrode (10), applied on the front side (5), with a lateral front-side electrode width (W_{EV}) given by its lateral extent, wherein at least one front-side switch-on structure (17, 23, 30, 35, 53, 63) is embedded into the front-side base zone (8) and is at least partly covered by the front-side electrode (10), and/or at least one rear-side switch-on structure (31, 36, 46, 57) is embedded into the rear-side base zone (6) and is at least partly covered by the rear-side electrode (11), wherein the respective switch-on structure (17, 23, 30, 31, 35, 36, 46, 53, 63) is an emitter structure (17, 23, 30, 35, 36, 46, 53, 63) of the second conduction type (n), which is electrically conductively contacted with the electrode (10, 11) applied on the base zone (6, 8) respectively embedding said structure and which is able to be switched on by means of at least one triggering structure (20, 26, 37, 38, 47, 54, 60) which acts on it electrically via the semiconductor body (16, 25, 32, 39, 48, 55, 58, 61, 69, 74, 77) and which is activatable in turn by means of an electrical switch-on signal fed to it,
**characterized in that**
the triggering structure (20, 26, 37, 38, 47, 54, 60) is configured and arranged in such a way that it causes a predestruction in its activated state by the injection of an electric current surge with a predetermined energy input into the semiconductor body (16, 25, 32, 39, 48, 55, 58, 61, 69, 74, 77) between the triggering structure (20, 26, 37, 38, 47, 54, 60) and the front-side and/or rear-side switch-on structure (17, 23, 30, 35, 36, 46, 53, 63), wherein the electric current surge irreversibly destroys a first semiconductor junction formed between the respective switch-on structure (17, 23, 30, 35, 36, 46, 53, 63) and the base zone (6, 8) embedding the latter and/or a second semiconductor junction formed between said base zone (6, 8) and the inner zone (7), and wherein after the predestruction the semiconductor body (16, 25, 32, 39, 48, 55, 58, 61, 69, 74, 77) is destroyed by a current flowing via the front-side electrode (10) and the rear-side electrode (11) in such a way that a fused junction (21) forms between the front-side electrode (10) and the rear-side electrode (20).

2. Short-circuit semiconductor component according to Claim 1, wherein the energy input is predetermined in a range of between 1 Ws and 3 Ws.

3. Short-circuit semiconductor component according to Claim 1 or 2, wherein the semiconductor body (16, 25, 32, 39, 48, 55, 58, 61, 69, 74, 77), in a region into which the current surge is injected, which region is situated between the triggering structure (20, 26, 37, 38, 47, 54, 60) and the front-side and/or rear-side switch-on structure (17, 23, 30, 35, 36, 46, 53, 63), has a resistance of less than 10 Q in a radial direction (r).

4. Short-circuit semiconductor component according to any of the preceding claims, wherein the front-side switch-on structure (17, 23, 30, 35, 53, 63) has a lateral front-side switch-on structure width (W_{SV}) given by its lateral extent, and the rear-side switch-on structure (31, 36, 46, 57) has a lateral rear-side switch-on structure width (W_{SR}) given by its lateral extent, wherein the ratio of the lateral switch-on structure width (W_{SV}, W_{SR}) to the corresponding lateral electrode width (W_{EV}, W_{ER}) of the respective electrode (10, 11) contacting the corresponding switch-on structure is less than 1, preferably less than 4/5, more preferably less than 3/4, even more preferably less than 2/3, and furthermore more preferably less than 1/2.

5. Short-circuit semiconductor component according to any of the preceding claims, wherein the switch-on structure (31, 46, 53, 57) is completely covered by the front-side electrode (10) and the rear-side electrode (11).

6. Short-circuit semiconductor component according to any of the preceding claims, wherein the switch-on structure (31, 46, 53, 57) at its outer side delimiting it at the outside in the radial direction (r), is covered by at least 5 mm in the radial direction (r) by the electrode (10, 11) contacting it.

7. Short-circuit semiconductor component according to any of the preceding claims, wherein the front-side electrode (10) and rear-side electrode (11) cover the front-side and respectively the rear-side centre (13) of the semiconductor body (16, 25, 32, 39, 48, 55, 58, 61, 69, 74), and the switch-on structure (17, 23, 30, 31, 35, 36, 46, 53, 57, 63) is arranged in the corresponding centre (13).

8. Short-circuit semiconductor component according to any of the preceding claims, wherein an electrically insulating insulator layer (78) is arranged between the switch-on structure (17, 23, 30, 31, 35, 36, 46, 53, 57, 63) and the electrode (10, 11) electrically conductively contacting it, wherein the insulator layer (78) extends in the radial direction (r) over said switch-on structure (17, 23, 30, 31, 35, 36, 46, 53, 57, 63) and extends in a circumferential direction (u) along an inner edge of said electrode (10, 11) situated on the inside in the radial direction (r).

9. Short-circuit semiconductor component according to the preceding claim, wherein the insulator layer (78) has a thickness of at least 10 nm to at most 100 nm, more preferably of at least 50 nm to at most 100 nm.

10. Short-circuit semiconductor component according to either of the two preceding claims, wherein the insulator layer (78) is a silicon oxide layer.

11. Short-circuit semiconductor component according to any of the three preceding claims, wherein the insulator layer (78) has openings which are spaced apart from one another in the radial direction (r) and which establish a directly electrically conductive connection between the electrode (10, 11) and the base zone (6, 8) adjacent thereto.

12. Short-circuit semiconductor component according to any of the preceding claims, wherein the triggering structure is a gate electrode (20, 26, 37, 38), and the switch-on signal is the current surge injected into the semiconductor body (16, 25, 32, 39, 48, 55, 58, 61, 69, 74, 77) by the triggering structure (20, 26, 37, 38).

13. Short-circuit semiconductor component according to the preceding claim, wherein a capacitor (C) having a capacitance predetermined according to the predetermined energy input is provided, which provides the switch-on signal in a charged state, wherein the capacitor (C) is electrically connectable between the gate electrode (20, 26, 37, 38) and the front-side electrode (10) and/or the rear-side electrode (11) by means of an electronic switch (79).

14. Short-circuit semiconductor component according to either of the two preceding claims, wherein the gate electrode (20, 26, 37, 38) is coated with a silver layer on its metallic contact side situated on the outside in a vertical direction (v).

15. Short-circuit semiconductor component according to any of the preceding claims, wherein the triggering structure is a breakdown structure (47, 54, 60), and the switch-on signal is the electrical voltage present between the front-side electrode (10) and the rear-side electrode (11).

16. Short-circuit semiconductor component according to any of the preceding claims, wherein the switch-on structure (17, 23, 30, 35, 36, 46, 53, 63) is spaced apart from the triggering structure (20, 26, 37, 38, 60) in the radial direction (r) and has at least one switch-on structure segment (64) with a switch-on structure width (W_{UV}) extending in a circumferential direction (u) of the semiconductor body (16, 25, 32, 39, 48, 55, 58, 61, 69, 74), said switch-on structure width being smaller at all points than a closed circumferential length extending through the switch-on structure segment (64) in the circumferential direction (u) around the centre (13).

17. Short-circuit semiconductor component according to the preceding claim, wherein at least two switch-on structure segments (64) that are separated from one another are provided in the circumferential direction (u) of the semiconductor body (16, 25, 32, 39, 48, 55, 58, 61, 69, 74).

18. Short-circuit semiconductor component according to either of the two preceding claims, wherein the electrical resistance in the base zone (6, 8) containing the switch-on structure (17, 23, 30, 35, 36, 46, 53, 63) is increased at least in a portion (67, 73) of the radial interspace between the switch-on structure (17, 23, 30, 35, 36, 46, 53, 63) and the triggering structure (20, 26, 37, 38, 60) with the exception of at least one passage channel (67) electrically coupling the at least one of the switch-on structure segments (64) to the triggering structure (20, 26, 37, 38, 60).

19. Short-circuit semiconductor component according to any of the preceding claims, wherein a region of the base zone (6, 8) embedding the switch-on structure (17, 23, 30, 35, 36, 46, 53, 63) between the triggering structure (20, 26, 37, 38, 47, 54, 60) and the respective switch-on structure (17, 23, 30, 35, 36, 46, 53, 63) is configured in such a way that the switch-on structure (17, 23, 30, 35, 36, 46, 53, 63) is able to be switched on, by means of the triggering structure (20, 26, 37, 38, 47, 54, 60), with an overdrive factor of at most 10, preferably at most 5, even more preferably at most 3, wherein a minimum switch-on current causing the switch-on structure (17, 23, 30, 35, 36, 46, 53, 63) to be switched on is at least 1 A, preferably at least 2 A, and even more preferably between at least 5 A and at most 10 A.

20. Short-circuit semiconductor component according to any of the preceding claims, wherein a thickness (Wₙ) of the inner zone (7) in the vertical direction (v) is greater than 400 µm, more preferably greater than 600 µm, even more preferably greater than 800 µm, and further preferably greater than 1000 µm.

21. Short-circuit semiconductor component according to any of the preceding claims, wherein a thickness of the front-side base zone (8) and/or of the rear-side base zone (6) in the vertical direction (v) is at least 50 µm.

22. Short-circuit semiconductor component according to any of the preceding claims, wherein the front-side electrode (10) and the rear-side electrode (11) are each electrically conductively pressure-contacted by means of a metallic contact plate (18, 19).

23. Short-circuit semiconductor component according to the preceding claim, wherein the lateral width of the respective contact plate (18, 19) corresponds to the lateral electrode width (W_{EV}, W_{ER}) of the corresponding pressure-contacted electrode (10, 11) .

24. Method for operating a short-circuit semiconductor component (15, 22, 29, 34, 45, 52, 56, 59, 62, 66, 70, 72) comprising a semiconductor body (16, 25, 32, 39, 48, 55, 58, 61, 69, 74), in which a rear-side base zone (6) of a first conduction type (p), an inner zone (7) of a second conduction type (n) complementary to the first conduction type (p), and a front-side base zone (8) of the first conduction type (p) are arranged successively in a vertical direction (v) proceeding from a rear side (4) with a rear-side centre (13) defined by its geometric centroid towards a front side (5), situated opposite the rear side (4), with a front-side centre (13) defined by its geometric centroid, wherein the rear-side base zone (6) is electrically conductively connected to a rear-side electrode (11), applied on the rear side (4), with a lateral rear-side electrode width (W_{ER}) given by its lateral extent, and the front-side base zone (8) is electrically conductively connected to a front-side electrode (10), applied on the front side (5), with a lateral front-side electrode width (W_{EV}) given by its lateral extent, wherein at least one front-side switch-on structure (17, 23, 30, 35, 53, 63) is embedded into the front-side base zone (8) and is at least partly covered by the front-side electrode (10), and/or at least one rear-side switch-on structure (31, 36, 46, 57) is embedded into the rear-side base zone (6) and is at least partly covered by the rear-side electrode (11), wherein the respective switch-on structure (17, 23, 30, 35, 36, 46, 53, 63) is an emitter structure (17, 23, 30, 35, 36, 46, 53, 63) of the second conduction type (n), which is electrically conductively contacted with the electrode (10, 11) applied on the base zone (6, 8) respectively embedding said structure and which is able to be switched on by means of at least one triggering structure (20, 26, 37, 38, 47, 54, 60) which acts on it electrically via the semiconductor body (16, 25, 32, 39, 48, 55, 58, 61, 69, 74) and which is activatable in turn by means of an electrical switch-on signal fed to it,
**characterized in that**
by activating the triggering structure (20, 26, 37, 38, 47, 54, 60) by means of the switch-on signal, a predestruction is caused by the injection of an electric current surge with a predetermined energy input into the semiconductor body (16, 25, 32, 39, 48, 55, 58, 61, 69, 74) between the triggering structure (20, 26, 37, 38, 47, 54, 60) and the front-side and/or rear-side switch-on structure (17, 23, 30, 35, 36, 46, 53, 63) in such a way that the electric current surge irreversibly destroys a first semiconductor junction formed between the respective switch-on structure (17, 23, 30, 35, 36, 46, 53, 63) and the base zone (6, 8) embedding the latter and/or a second semiconductor junction formed between said base zone (6, 8) and the inner zone (7), wherein after the predestruction the semiconductor body (16, 25, 32, 39, 48, 55, 58, 61, 69, 74, 77) is destroyed by a current flowing via the front-side electrode (10) and the rear-side electrode (11) in such a way that a fused junction (21) forms between the front-side electrode (10) and the rear-side electrode (20) .

## Revendications

1. Composant à semiconducteur à court circuit comportant un corps (16, 25, 32, 39, 48, 55, 58, 61, 69, 74, 77) à semiconducteur, dans lequel, dans une direction (v) verticale en allant d'une face (4) arrière, ayant un centre (13) du côté arrière, fixé par son centre de gravité géométrique, à une face (5) avant opposée à la face (4) arrière, ayant un centre (13) du côté avant, fixé par son centre de gravité géométrique, sont disposées successivement une zone (6) de base du côté arrière d'un premier type (p) de conduction, une zone (7) intérieure d'une deuxième type (n) de conduction, complémentaire du premier type (p) de conduction, et une zone (8) de base du côté avant du premier type (p) de conduction, dans lequel la zone (6) de base du côté arrière est reliée, d'une manière conductrice de l'électricité, à une électrode (11) du côté arrière, qui est déposée sur la face (4) arrière et qui a une largeur (W_{ER}) latérale d'électrode du côté arrière donnée par son étendue latérale et la zone (8) de base du côté avant est reliée, d'une manière conductrice de l'électricité, à une électrode (10) du côté avant, qui est déposée sur la face (5) avant et qui a une largeur (W_{EV}) latérale du côté avant donnée par son étendue latérale, dans lequel, dans la zone (8) de base du côté avant au moins une structure (17, 23, 30, 35, 53, 63) de déblocage du côté avant est enterrée et est recouverte au moins en partie de l'électrode (10) du côté avant et/ou dans la zone (6) de base du côté arrière au moins une structure (31, 36, 46, 57) de mise en conduction du côté arrière est enterrée et est recouverte au moins en partie de l'électrode (11) du côté arrière, dans lequel la structure (17, 23, 30, 31, 35, 36, 46, 53, 63) respective de mise en conduction est une structure (17, 23, 30, 35, 36, 46, 53, 63) d'émetteur du deuxième type (n) de conduction mise en contact, d'une manière conductrice de l'électricité, avec l'électrode (10, 11), déposée sur cette zone (6, 8) de base respective enterrée, et pouvant être mise en conduction au moyen d'au moins une structure (20, 26, 37, 38, 47, 54, 60) d'amorçage, qui agit électriquement, par l'intermédiaire du corps (16, 25, 32, 39, 48, 55, 58, 61, 69, 74, 77) à semiconducteur et qui peut être activée, à son tour, au moyen d'un signal électrique de mise en conduction, qui lui est envoyé,
**caractérisé en ce que**
la structure (20, 26, 37, 38, 47, 54, 60) d'amorçage est constituée et est disposée de manière à ce que, dans son état activé par l'injection d'une pointe de courant électrique ayant un apport d'énergie défini à l'avance dans le corps (16, 25, 32, 39, 48, 55, 58, 61, 69, 74, 77) à semiconducteur entre la structure (20, 26, 37, 38, 47, 54, 60) d'amorçage et la structure (17, 23, 30, 35, 36, 46, 53, 63) de mise en conduction du côté avant et/ou du côté arrière, elle provoque une prédestruction, dans lequel la pointe de courant électrique détruit, de manière irréversible, une première jonction de semiconducteur formée entre la structure (17, 23, 30, 35, 36, 46, 53, 63) respective de mise en conduction et cette zone (6, 8) de base enterrée et/ou une deuxième jonction de semiconducteur formée entre cette zone (6, 8) de base et la zone (7) intérieure, et dans lequel le corps (16, 25, 32, 39, 48, 55, 58, 61, 69, 74, 77) à semiconducteur, à la suite de la prédestruction, est détruit par un courant passant par l'intermédiaire de l'électrode (10) du côté avant et de l'électrode (11) du côté arrière, de manière à ce qu'il se forme un alliage (21) de part en part entre l'électrode (10) du côté avant et l'électrode (20) du côté arrière.

2. Composant à semiconducteur à court circuit suivant la revendication 1,
dans lequel l'apport d'énergie est défini à l'avance dans une plage comprise entre 1 Ws à 3 Ws.

3. Composant à semiconducteur à court circuit suivant la revendication 1 ou 2,
dans lequel le corps (16, 25, 32, 39, 48, 55, 58, 61, 69, 74, 77) à semiconducteur a, dans une direction (r) radiale, une résistance plus petite que 10 **Ω**, dans une partie, dans laquelle on injecte le pic de courant, se trouvant entre la structure (20, 26, 37, 38, 47, 54, 60) d'amorçage et la structure (17, 23, 30, 35, 36, 46, 53, 63) de mise en conduction du côté avant et/ou du côté arrière.

4. Composant à semiconducteur à court circuit suivant l'une des revendications précédentes,
dans lequel la structure (17, 23, 30, 35, 53, 63) de mise en conduction du côté avant a une largeur (W_{SV}) latérale de structure de mise en conduction du côté avant donnée par son étendue latérale, et la structure (31, 36, 46, 57) de mise en conduction du côté arrière a une largeur (W_{SR}) latérale de structure de mise en conduction du côté arrière donnée par son étendue latérale, dans lequel le rapport des largeurs (W_{SV}, W_{SR}) latérales de structure de mise en conduction aux largeurs (W_{EV}, W_{ER}) latérales d'électrode correspondantes des électrodes (10, 11) respectives venant en contact avec la structure correspondante de mise en conduction est plus petit que 1, de préférence plus petit que 4/5, de préférence plus petit que 3/4, d'une manière encore plus préférée plus petit que 2,13 et encore davantage plus préférée plus petit que 1/2.

5. Composant à semiconducteur à court circuit suivant l'une des revendications précédentes,
dans lequel la structure (31, 46, 53, 57) de mise en conduction est recouverte complètement de l'électrode (10) du côté avant et de l'électrode (11) du côté arrière.

6. Composant à semiconducteur à court circuit suivant l'une des revendications précédentes,
dans lequel la structure (31, 46, 53, 57) de mise en conduction est, du côté extérieur la délimitant à l'extérieur dans la direction (r) radiale, recouverte d'au moins 5 mm dans la direction (r) radiale, de l'électrode (10, 11) la contactant.

7. Composant à semiconducteur à court circuit suivant l'une des revendications précédentes,
dans lequel l'électrode (10) du côté avant et l'électrode (11) du côté arrière recouvrent le centre (13) du côté avant et respectivement du côté arrière du corps (16, 25, 32, 39, 48, 55, 58, 61, 69, 74) à semiconducteur, et la structure (17, 23, 30, 31, 35, 36, 46, 53, 57, 63) de mise en conduction est disposée au centre (13) correspondant.

8. Composant à semiconducteur à court circuit suivant l'une des revendications précédentes,
dans lequel une couche (78) d'isolateur isolante électriquement est disposée entre la structure (17, 23, 30, 31, 35, 36, 46, 53, 57, 63) de mise en conduction et l'électrode (10, 11) contactant celle-ci d'une manière conductrice de l'électricité, dans lequel la couche (78) d'isolateur s'étend dans la direction (r) radiale sur cette structure (17, 23, 30, 31, 35, 36, 46, 53, 57, 63) de mise en conduction et s'étend dans la direction (u) du pourtour, le long d'un bord intérieur, se trouvant à l'intérieur dans la direction (r) de cette électrode (10, 11).

9. Composant à semiconducteur à court circuit suivant la revendication précédente,
dans lequel la couche (78) d'isolateur a une épaisseur d'au moins 10 nm à au plus 100 nm, de préférence d'au moins 50 nm à au plus 100 nm.

10. Composant à semiconducteur à court circuit suivant l'une des deux revendications précédentes,
dans lequel la couche (78) d'isolateur est une couche d'oxyde de silicium.

11. Composant à semiconducteur à court circuit suivant l'une des trois revendications précédentes,
dans lequel la couche (78) d'isolateur a des ouvertures, à distance les unes des autres dans la direction (r) radiale, qui ménagent une liaison conductrice de l'électricité directe entre l'électrode (10, 11) et la zone (6, 8) de base s'appliquant à celle-ci.

12. Composant à semiconducteur à court circuit suivant l'une des revendications précédentes,
dans lequel la structure d'amorçage est une électrode (20, 26, 37, 38) de grille et le signal de mise en conduction est le pic de courant injecté par la structure (20, 26, 37, 38) d'amorçage dans le corps (16, 25, 32, 39, 48, 55, 58, 61, 69, 74, 77) à semiconducteur.

13. Composant à semiconducteur à court circuit suivant la revendication précédente,
dans lequel il est prévu un condensateur (C) ayant une capacité définie à l'avance correspondant à l'apport d'énergie définie à l'avance, qui donne le signal de mise en conduction dans un état chargé, dans lequel le condensateur (C) peut, au moyen d'un interrupteur (79) électrique, être mis en circuit électriquement entre l'électrode (20, 26, 37, 38) de grille et l'électrode (10) du côté avant et/ou l'électrode (11) du côté arrière.

14. Composant à semiconducteur à court circuit suivant l'une des deux revendications précédentes,
dans lequel l'électrode (20, 26, 37, 38) de grille est revêtue d'une couche d'argent sur son côté de contact métallique se trouvant à l'extérieur dans la direction (v) verticale.

15. Composant à semiconducteur à court circuit suivant l'une des revendications précédentes,
dans lequel la structure d'amorçage est une structure (47, 54, 60) de claquage et le signal de mise en conduction est la tension électrique s'appliquant entre l'électrode (10) du côté avant et l'électrode (11) du côté arrière.

16. Composant à semiconducteur à court circuit suivant l'une des revendications précédentes,
dans lequel la structure (17, 23, 30, 35, 36, 46, 53, 63) de mise en conduction est, dans la direction (r) radiale, à distance de la structure (20, 26, 37, 38, 60) d'amorçage et au moins un segment (64) de la structure de mise en conduction a une largeur (W_{UV}) de structure de mise en conduction s'étendant dans une direction (u) de pourtour du corps (16, 25, 32, 39, 48, 55, 58, 61, 69, 74) à semiconducteur, qui partout est plus petite qu'une longueur de pourtour fermée s'étendant autour du centre (13) dans la direction (u) du pourtour dans le segment (64) de la structure de mise en conduction.

17. Composant à semiconducteur à court circuit suivant la revendication précédente,
dans lequel il est prévu, dans la direction (u) du pourtour du corps (16, 25, 32, 39, 48, 55, 58, 61, 69, 74) à semiconducteur, au moins deux segments (64) de structure de mise en conduction séparés l'un de l'autre.

18. Composant à semiconducteur à court circuit suivant l'une des deux revendications précédentes,
dans lequel la résistance électrique dans la zone (6, 8) de base contenant la structure (17, 23, 30, 35, 36, 46, 53, 63) de mise en conduction est augmentée au moins dans une partie (67, 73) de l'espace intermédiaire radial entre la structure (17, 23, 30, 35, 36, 46, 53, 63) de mise en conduction et la structure (20, 26, 37, 38, 60) d'amorçage, à l'exception d'au moins un canal (67) de passage connectant électriquement le au moins un des segments (64) de la structure de mise en conduction à la structure (20, 26, 37, 38, 60) d'amorçage.

19. Composant à semiconducteur à court circuit suivant l'une des revendications précédentes,
dans lequel une partie de la zone (6, 8) de base enterrant la structure (17, 23, 30, 35, 36, 46, 53, 63) de mise en conduction entre la structure (20, 26, 37, 38, 47, 54, 60) d'amorçage et la structure (17, 23, 30, 35, 36, 46, 53, 63) respective de mise en conduction est constituée de manière à ce que la structure (17, 23, 30, 35, 36, 46, 53, 63) de mise en conduction puisse, au moyen de la structure (20, 26, 37, 38, 47, 54, 60) d'amorçage, être mise en conduction avec un facteur de surcharge de 10 au plus, de préférence de 5 au plus, d'une manière encore plus préférée de 3 au plus, dans lequel un courant de mise en conduction minimum provoquant la mise en conduction de la structure (17, 23, 30, 35, 36, 46, 53, 63) de mise en conduction est d'au moins 1 A, de préférence d'au moins 2 A, et d'une manière encore plus préférée compris entre au moins 5 A et au plus 10 A.

20. Composant à semiconducteur à court circuit suivant l'une des revendications précédentes,
dans lequel une épaisseur (Wₙ) de la zone (7) intérieure dans la direction (v) verticale est plus grande que 400 µm, de préférence plus grande que 600 µm, d'une manière encore plus préférée plus grande que 800 µm et d'une manière encore davantage plus préférée plus grande que 1000 µm.

21. Composant à semiconducteur à court circuit suivant l'une des revendications précédentes,
dans lequel une épaisseur de la zone (8) de base du côté avant et/ou de la zone (6) de base du côté dans la direction (v) verticale est d'au moins 50 µm.

22. Composant à semiconducteur à court circuit suivant l'une des revendications précédentes,
dans lequel l'électrode (10) du côté avant et l'électrode (11) du côté arrière sont mises en contact par pression, d'une manière conductrice de l'électricité, respectivement au moyen d'un disque (18, 19) métallique de contact.

23. Composant à semiconducteur à court circuit suivant la revendication précédente,
dans lequel la largeur latérale du disque (18, 19) respectif de contact correspond à la largeur (W_{EV}, W_{ER}) de l'électrode (10, 11) correspondante mise en contact par pression.

24. Procédé pour faire fonctionner un composant (15, 22, 29, 34, 45, 52, 56, 59, 62, 66, 70, 72) à semiconducteur à court circuit, qui a un corps (16, 25, 32, 39, 48, 55, 58, 61, 69, 74) à semiconducteur, dans lequel, dans une direction (v) verticale en allant d'une face (4) arrière ayant un centre (13) du côté arrière fixé par son centre de gravité géométrique à une face (5) avant opposée à la face (4) arrière, ayant un centre (13) du côté avant, fixé par son centre de gravité géométrique, sont disposées successivement une zone (6) de base du côté arrière d'un premier type (p) de conduction, une zone (7) intérieure d'une deuxième type (n) de conduction, complémentaire du premier type (p) de conduction, et une zone (8) de base du côté avant du premier type (p) de conduction, dans lequel la zone (6) de base du côté arrière est reliée, d'une manière conductrice de l'électricité, à une électrode (11) du côté arrière, qui est déposée sur la face (4) arrière et qui a une largeur (W_{ER}) latérale d'électrode du côté arrière donnée par son étendue latérale et la zone (8) de base du côté avant est reliée, d'une manière conductrice de l'électricité, à une électrode (10) du côté avant, qui est déposée sur la face (5) avant et qui a une largeur (W_{EV}) latérale du côté avant donnée par son étendue latérale, dans lequel, dans la zone (8) de base du côté avant au moins une structure (17, 23, 30, 35, 53, 63) de déblocage du côté avant est enterrée et est recouverte au moins en partie de l'électrode (10) du côté avant et/ou dans la zone (6) de base du côté arrière au moins une structure (31, 36, 46, 57) de mise en conduction du côté arrière est enterrée et est recouverte au moins en partie de l'électrode (11) du côté arrière, dans lequel la structure (17, 23, 30, 31, 35, 36, 46, 53, 63) respective de mise en conduction est une structure (17, 23, 30, 35, 36, 46, 53, 63) d'émetteur du deuxième type (n) de conduction mise en contact, d'une manière conductrice de l'électricité, avec l'électrode (10, 11), déposée sur cette zone (6, 8) de base respective enterrée, et pouvant être mise en conduction au moyen d'au moins une structure (20, 26, 37, 38, 47, 54, 60) d'amorçage, qui agit électriquement, par l'intermédiaire du corps (16, 25, 32, 39, 48, 55, 58, 61, 69, 74) à semiconducteur et qui peut être activée, à son tour, au moyen d'un signal électrique de mise en conduction, qui lui est envoyé,
**caractérisé en ce que**
en activant la structure (20, 26, 37, 38, 47, 54, 60) d'amorçage au moyen d'un signal de mise en conduction, on provoque une prédestruction en injectant un pic de courant électrique ayant un apport d'énergie défini à l'avance dans le corps (16, 25, 32, 39, 48, 55, 58, 61, 69, 74) à semiconducteur entre la structure (20, 26, 37, 38, 47, 54, 60) d'amorçage et la structure (17, 23, 30, 35, 36, 46, 53, 63) de mise en conduction du côté avant et/ou du côté arrière, de manière à ce que, par le pic du courant électrique, une première jonction à semiconducteur formée entre la structure (17, 23, 30, 35, 36, 46, 53, 63) respective de mise en conduction et la zone (6, 8) de base enterrant celle-ci et/ou une deuxième jonction à semiconducteur formée entre cette zone (6, 8) de base et la zone (7) intérieure soient détruites irréversiblement, dans lequel ensuite on détruit le corps (16, 25, 32, 39, 48, 55, 58, 61, 69, 74, 77) à semiconducteur, à la suite de la prédestruction, par un courant passant par l'intermédiaire de l'électrode (10) du côté avant et de l'électrode (11) du côté arrière, de manière à ce qu'il se forme un alliage (21) de part en part entre l'électrode (10) du côté avant et l'électrode (20) du côté arrière.
